(19) Europäisches Patentamt
European Patent Office
Office européen des brevets

(11) EP 4 453 128 B1

(12) EUROPEAN PATENT SPECIFICATION

(45) Date of publication and mention of the grant of the patent:
**29.07.2026 Bulletin 2026/31**

(21) Application number: **22839786.5**

(22) Date of filing: **19.12.2022**

(51) International Patent Classification (IPC):
***C09K 11/02*** *(2006.01)* ***C09K 11/56*** *(2006.01)*
***C09K 11/70*** *(2006.01)* ***H10K 50/115*** *(2023.01)*

(52) Cooperative Patent Classification (CPC):
**C09K 11/02; C09K 11/565; C09K 11/70; H10K 50/115; H10K 85/60;** Y02E 10/549

(86) International application number:
**PCT/EP2022/086543**

(87) International publication number:
**WO 2023/117835 (29.06.2023 Gazette 2023/26)**

# (54) ELECTRONIC DEVICES

ELEKTRONISCHE VORRICHTUNGEN

DISPOSITIFS ÉLECTRONIQUES

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **21.12.2021 EP 21216507**

(43) Date of publication of application:
**30.10.2024 Bulletin 2024/44**

(73) Proprietor: **Samsung Electronics Co., Ltd**
**Suwon-si, Gyeonggi-do 16677 (KR)**

(72) Inventors:
- **ENGEL, Miriam**
**64293 DARMSTADT (DE)**
- **MEYER, Sebastian**
**64293 DARMSTADT (DE)**
- **HAMBURGER, Manuel**
**64293 DARMSTADT (DE)**
- **MAY, Falk**
**64293 DARMSTADT (DE)**
- **BOEHM, Edgar**
**64293 DARMSTADT (DE)**

(74) Representative: **Appleyard Lees IP LLP**
**G Mill**
**Dean Clough Industrial Park**
**Halifax HX3 5AH (GB)**

(56) References cited:
**US-A1- 2013 226 268** **US-A1- 2017 324 057**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

The present disclosure relates to electronic devices, in particular electroluminescent devices (EL devices), compositions and formulations comprising at least one semiconducting light emitting nanoparticle such as a quantum dot and at least one wide-energy gap material.

Electronic devices in the context of this application are understood to mean so-called electroluminescent devices such as light emitting diodes (LEDs), which employ semiconducting light emitting nanoparticles such as quantum dots (QD) as light emitting materials. As used herein, electroluminescent devices should be understood to also include organic electroluminescent devices, such as an organic light emitting diode (OLED), which comprises one or more layers including organic compounds as functional materials. Accordingly, the term organic electroluminescent devices in the context of the present application is understood to also include such hybrid systems of organic electroluminescent devices, such as OLEDs, which employ inorganic semiconducting nanoparticles such as quantum dots (QD) as light emitting materials.

Electroluminescent devices such as light emitting diodes based on quantum dots (EL-QD-LED) as the emitters show the potential of narrow full-width FWHM, tunable emission wavelength and high quantum efficiencies (Adv. Mater. 2017, 29, 1607022).

Reported devices are often based on Cd-containing quantum dots in the emissive layer, which are often also deployed as monolayers or bare quantum dot emissive layers, as described in US 2015/022885 A1.

EL-QD-LEDs based on bare quantum dot emissive layers, with the quantum dots moreover being Cd-free, suffer from strong film-inhomogeneity, poor device performance and poor transport characteristics. Typically, these QDs can only be formulated in high concentrated inks to avoid degradation or storage instability.

In view of the disadvantages described above, it has been proposed to embed and homogeneously distribute the quantum dots in an organic matrix and to additionally add a transporting moiety, such as polymers as described in CN 105900529 B, or small molecules having a triphenylamine skeleton as described in JP 2019-33005 A, to the emissive layer.

US 2013/226268 discloses nanocrystals in devices.

US 2017/324057 discloses an electroluminescent device.

However, there is still a need for electric devices based on semiconducting light emitting nanoparticles such as quantum dots, which are in particular Cd-free and exhibit improved device performance, improved stability as well as improved transport characteristics.

It is therefore an object of the present invention to provide an electric device, in particular an organic electroluminescent device, based on semiconducting light emitting nanoparticles such as quantum dots, in particular Cd-free quantum dots, which exhibits improved device performance, in particular reduced voltage, high efficiencies and longer lifetime,and improved transport characteristics.

Surprisingly, it has been found that an improvement of layer film homogeneity and morphology, improved device performance, in particular reduced voltage, high efficiency and long-term stability, and improved transport characteristics as well as improved ink and film stability can be achieved by using a wide-energy gap material, in particular a compound represented by the formula (1) as described herein, in combination with semiconducting light emitting nanoparticles such as quantum dots, preferably Cd-free quantum dots, in an electronic device, in particular in the light-emitting layer of the electronic device, or in a formulation together with at least a first solvent, to thereby solve one or more of the objects mentioned above.

The invention is set out in the appended claims.

The present invention provides for an electronic device comprising anode, cathode and at least one layer which comprises the following compounds:

a) at least one semiconducting light emitting nanoparticle having a core-shell structure wherein, in the core-shell structure, an inorganic core is surrounded by one or more inorganic shell layers, optionally wherein the shell layers are over coated with one or more surface modifying ligands; and
b) at least one compound having a band gap of 2.5 eV or more, preferably of 3.0 eV or more, more preferably of 3.5 eV or more, and very preferably of 4.0 eV or more;

wherein the core of the semiconducting light emitting nanoparticle is a material selected from CdS, CdSe, CdTe, ZnS, ZnSe, ZnSeS, ZnTe, ZnO, GaAs, GaP, GaSb, HgS, HgSe, HgSe, HgTe, InAs, InP, InPS, InPZnS, InPZn, InPGa, InSb, AlAs, AlP, AlSb, $Cu_2S$, $Cu_2Se$, $CuInS_2$, $CuInSe_2$, $Cu_2(ZnSn)S_4$, $Cu_2(InGa)S_4$, $TiO_2$ alloys, and a combination of any of these;
wherein the electronic device is selected from organic light-emitting transistors (OLETs), organic field-quench devices (OFQDs), organic laser diodes (O-lasers) and organic light emitting diodes (OLEDs); and
wherein the at least one compound having a band gap of 2.5 eV or more is represented by the formula (1) below.

In the context of the present invention, the term "band gap" means the energy gap between the highest occupied molecular orbital (HOMO) and the lowest unoccupied molecular orbital (LUMO).

Accordingly, one way of calculating the band gap is via the energy levels of the highest occupied molecular orbital (HOMO) and the lowest unoccupied molecular orbital (LUMO).

The HOMO and LUMO energies and the triplet level and the singlet levels of the materials are determined via quantum-chemical calculations. For this purpose, in the present case, the "Gaussian09, Revision D.01" software package (Gaussian Inc.) is used. For calculation of organic substances without metals (referred to as the "org." method), a geometry optimization is first conducted by the semi-empirical method AM1 (Gaussian input line "# AM1 opt") with charge 0 and multiplicity 1. Subsequently, on the basis of the optimized geometry, a single-point energy calculation is effected for the electronic ground state and the triplet level. This is done using the TDDFT (time dependent density functional theory) method B3PW91 with the 6-31G(d) basis set (Gaussian input line "# B3PW91/6-31 G(d) td=(50-50,nstates=4)") (charge 0, multiplicity 1). For organometallic compounds (referred to as the "M-org." method), the geometry is optimized by the Hartree-Fock method and the LanL2MB basis set (Gaussian input line "# HF/LanL2MB opt") (charge 0, multiplicity 1). The energy calculation is effected, as described above, analogously to that for the organic substances, except that the "LanL2DZ" basis set is used for the metal atom and the "6-31G(d)" basis set for the ligands (Gaussian input line "#B3PW91/gen pseudo=lanl2 td=(50-50,nstates=4)"). From the energy calculation, the HOMO is obtained as the last orbital occupied by two electrons (alpha occ. eigenvalues) and LUMO as the first unoccupied orbital (alpha virt. eigenvalues) in Hartree units, where HEh and LEh represent the HOMO energy in Hartree units and the LUMO energy in Hartree units respectively. This is used to determine the HOMO and LUMO value in electron volts, calibrated by cyclic voltammetry measurements, as follows:

$$HOMO(eV) = (HEh*27.212)*0.8308-1.118$$

$$LUMO(eV) = (LEh*27.212)*1.0658-0.5049$$

These values are to be regarded as HOMO and as LUMO of the materials in the context of this application. The magnitude of the difference between the two values is regarded as the band gap in the context of this application.

The triplet level T1 of a material is defined as the relative excitation energy (in eV) of the triplet state having the lowest energy which is found by the quantum-chemical energy calculation.

The singlet level S1 of a material is defined as the relative excitation energy (in eV) of the singlet state having the second-lowest energy which is found by the quantum-chemical energy calculation.

The energetically lowest singlet state is referred to as S0.

The method described herein is independent of the software package used. Examples of frequently utilized programs for this purpose are "Gaussian09" (Gaussian Inc.) and Q-Chem 4.1 (Q-Chem, Inc.). In the present case, the energies are calculated using the software package "Gaussian09, Revision D.01" with the pre-programmed set of parameters.

It is preferred according to the present invention that the at least one compound having a band gap of 2.5 eV or more, is a purely organic compound. A purely organic compound is an compound without any metal atom(s) or ion(s), i.e., which neither forms a coordination bond nor a covalent bond to a metal atom or ion. Particularly preferably, the at least one compound having a band gap of 2.5 eV or more is a purely organic compound comprising only aromatic ring systems as defined herein.

Further preferably, the at least one compound having a band gap of 2.5 eV or more is a wide band gap material. A "wide band gap" material in the context of the present invention refers to a material having a band gap of 3.0 eV or more. Such systems are well known in the art, for example from US 7,294,849.

The at least one compound having a band gap of 2.5 eV or more, preferably of 3.0 eV or more, more preferably of 3.5 eV or more, and very preferably of 4.0 eV or more, is a compound represented by the following formula (1):

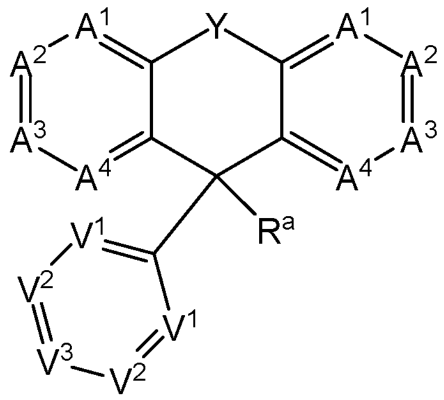

formula (1)

where the symbols used are as follows:

$A^1$, $A^2$, $A^3$, $A^4$ is, identically or different at each occurrence, N or $CR^1$, preferably $CR^1$, with the proviso that not more than two of the groups $A^1$, $A^2$, $A^3$, $A^4$ in one cycle are N; or two directly adjacent groups $A^1$, $A^2$, $A^3$, $A^4$ (i.e., $A^1$/$A^2$, $A^2$/$A^3$, or $A^3$/$A^4$) stand for a unit of the following formula (7)

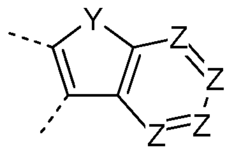

formula (7)

where the dashed bonds indicate the link of the unit to the adjacent C or N atoms;

Y is on each occurrence, identically or differently, a single bond or a group selected from $BR^1$, $C(R^1)_2$, C(=O), $C(=NR^1)$, $C(=C(R^1)_2)$, $Si(R^1)_2$, $NR^1$, $PR^1$, $P(=O)R^1$, O, S, S(=O), $S(=O)_2$, $C(R^1)_2$-$C(R^1)_2$, $C(R^1)_2$-$NR^1$ or $CR^1$=$CR^1$;

Z is on each occurrence, identically or differently, $CR^1$ or N, where a maximum of two groups Z in each cycle stand for N;

$V^1$, $V^2$, $V^3$ is, identically or different at each occurrence, N or $CR^2$, preferably $CR^2$, with the proviso that not more than three of the groups $V^1$, $V^2$, $V^3$ in one cycle are N;

$R^a$ is on each occurrence, identically or differently, H, D, F, Cl, Br, I, CHO, $N(R^3)_2$, $N(Ar)_2$, C(=O)Ar, $P(=O)(Ar)_2$, S(=O)Ar, $S(=O)_2Ar$, $CR^3$=$CR^3Ar$, CN, $NO_2$, $Si(R^3)_3$, $B(OR^3)_2$, $B(R^3)_2$, $B(N(R^3)_2)_2$, $OSO_2R^3$, a straight-chain alkyl, alkenyl, alkynyl, alkoxy or thioalkoxy group having 1 to 40 C atoms or a branched or cyclic alkyl, alkenyl, alkynyl, alkoxy or thioalkoxy group having 3 to 40 C atoms, each of which may be substituted by one or more radicals $R^3$, where one or more non-adjacent $CH_2$ groups may be replaced by $R^3C$=$CR^3$, C≡C, $Si(R^3)_2$, $Ge(R^3)_2$, $Sn(R^3)_2$, C=O, C=S, C=Se, $C$=$NR^3$, $P(=O)(R^3)$, SO, $SO_2$, $NR^3$, O, S or $CONR^3$ and where one or more H atoms may be replaced by F, Cl, Br, I, CN or $NO_2$, or an aromatic or heteroaromatic ring system having 5 to 60 aromatic ring atoms, which may in each case be substituted by one or more radicals $R^3$, or an aryloxy or heteroaryloxy group having 5 to 60 aromatic ring atoms, which may be substituted by one or more radicals $R^3$, or a combination of these systems; at the same time, one substituent $R^a$ and one adjacent group $V^1$, $V^2$, or $V^3$, preferably $V^1$, here may also be linked to one another by a single bond or a bridge selected from $B(R^3)$, $C(R^3)_2$, $Si(R^3)_2$, C=O, $C$=$NR^3$, $C$=$C(R^3)_2$, O, S, S=O, $SO_2$, $N(R^3)$, $P(R^3)$ and $P(=O)R^3$, preferably a single bond;

Ar is on each occurrence, identically or differently, an aromatic or heteroaromatic ring system having 5 to 30 aromatic ring atoms, which may be substituted by one or more non-aromatic radicals $R^5$; two radicals Ar here which are bonded to the same nitrogen or phosphorus atom may also be linked to one another by a single bond or a bridge selected from $B(R^6)$, $C(R^6)_2$, $Si(R^6)_2$, C=O, $C=NR^6$, $C=C(R^6)_2$, O, S, S=O, $SO_2$, $N(R^6)$, $P(R^6)$ and $P(=O)R^6$;

$R^1$ is, identically or different at each occurrence, H, D, F, Cl, Br, I, $B(OR^5)_2$, CHO, $C(=O)R^5$, $CR^5=C(R^5)_2$, CN, $C(=O)OR^5$, $C(=O)N(R^5)_2$, $Si(R^5)_3$, $N(R^5)_2$, $NO_2$, $P(=O)(R^5)_2$, $OSO_2R^5$, $OR^5$, $S(=O)R^5$, $S(=O)_2R^5$, a straight-chain alkyl, alkoxy or thioalkoxy group having 1 to 40 carbon atoms or a branched or cyclic alkyl, alkoxy or thioalkoxy group having 3 to 40 carbon atoms, each of which may be substituted by one or more $R^5$ radicals, where one or more nonadjacent $CH_2$ groups may be replaced by $-R^5C=CR^5-$, - C≡C-, $Si(R^5)_2$, $Ge(R^5)_2$, $Sn(R^5)_2$, C=O, C=S, C=Se, $C=NR^5$, - C(=O)O-, $-C(=O)NR^5-$, $NR^5$, $P(=O)(R^5)$, -O-, -S-, SO or $SO_2$ and where one or more hydrogen atoms may be replaced by D, F, Cl, Br, I, CN or $NO_2$, or an aromatic or heteroaromatic ring system which has 5 to 40 aromatic ring atoms and may be substituted in each case by one or more $R^5$ radicals, or an aryloxy or heteroaryloxy group which has 5 to 40 aromatic ring atoms and may be substituted by one or more $R^5$ radicals, or a combination of these systems; at the same time, it is also possible for two or more adjacent $R^1$ substituents together to form a mono- or polycyclic, aliphatic or aromatic ring system;

$R^2$, $R^3$ is, identically or different at each occurrence, H, D, F, Cl, Br, I, $B(OR^4)_2$, CHO, $C(=O)R^4$, $CR^4=C(R^4)_2$, CN, $C(=O)OR^4$, $C(=O)N(R^4)_2$, $Si(R^4)_3$, $N(R^4)_2$, $NO_2$, $P(=O)(R^4)_2$, $OSO_2R^4$, $OR^4$, $S(=O)R^4$, $S(=O)_2R^4$, a straight-chain alkyl, alkoxy or thioalkoxy group having 1 to 40 carbon atoms or a branched or cyclic alkyl, alkoxy or thioalkoxy group having 3 to 40 carbon atoms, each of which may be substituted by one or more $R^4$ radicals, where one or more nonadjacent $CH_2$ groups may be replaced by $-R^4C=CR^4-$, - C≡C-, $Si(R^4)_2$, $Ge(R^4)_2$, $Sn(R^4)_2$, C=O, C=S, C=Se, $C=NR^4$, - C(=O)O-, $-C(=O)NR^4-$, $NR^4$, $P(=O)(R^4)$, -O-, -S-, SO or $SO_2$ and where one or more hydrogen atoms may be replaced by D, F, Cl, Br, I, CN or $NO_2$, or an aromatic or heteroaromatic ring system which has 5 to 40 aromatic ring atoms and may be substituted in each case by one or more $R^4$ radicals, or an aryloxy or heteroaryloxy group which has 5 to 40 aromatic ring atoms and may be substituted by one or more $R^4$ radicals, or a combination of these systems; at the same time, it is also possible for two or more adjacent $R^2$ substituents together to form a mono- or polycyclic, aliphatic or aromatic ring system; at the same time, it is also possible for two or more adjacent $R^3$ substituents together to form a mono- or polycyclic, aliphatic or aromatic ring system;

$R^4$, $R^5$ is, identically or different at each occurrence, H, D, F, Cl, Br, I, $B(OR^6)_2$, CHO, $C(=O)R^6$, $CR^6=C(R^6)_2$, CN, $C(=O)OR^6$, $C(=O)N(R^6)_2$, $Si(R^6)_3$, $N(R^6)_2$, $NO_2$, $P(=O)(R^6)_2$, $OSO_2R^6$, $OR^6$, $S(=O)R^6$, $S(=O)_2R^6$, a straight-chain alkyl, alkoxy or thioalkoxy group having 1 to 40 carbon atoms or a branched or cyclic alkyl, alkoxy or thioalkoxy group having 3 to 40 carbon atoms, each of which may be substituted by one or more $R^6$ radicals, where one or more nonadjacent $CH_2$ groups may be replaced by $-R^6C=CR^6-$, - C≡C-, $Si(R^6)_2$, $Ge(R^6)_2$, $Sn(R^6)_2$, C=O, C=S, C=Se, $C=NR^6$, - C(=O)O-, $-C(=O)NR^6-$, $NR^6$, $P(=O)(R^6)$, -O-, -S-, SO or $SO_2$ and where one or more hydrogen atoms may be replaced by D, F, Cl, Br, I, CN or $NO_2$, or an aromatic or heteroaromatic ring system which has 5 to 40 aromatic ring atoms and may be substituted in each case by one or more $R^6$ radicals, or an aryloxy or heteroaryloxy group which has 5 to 40 aromatic ring atoms and may be substituted by one or more $R^6$ radicals, or a combination of these systems; at the same time, it is also possible for two or more adjacent $R^4$ substituents together to form a mono- or polycyclic, aliphatic or aromatic ring system; at the same time, it is also possible for two or more adjacent $R^5$ substituents together to form a mono- or polycyclic, aliphatic or aromatic ring system and

$R^6$ is, identically or different at each occurrence, H, D, F or an aliphatic, aromatic and/or heteroaromatic hydrocarbyl radical having 1 to 20 carbon atoms, in which hydrogen atoms may also be replaced by F; at the same time, it is also possible for two or more adjacent $R^6$ substituents together to form a mono- or polycyclic, aliphatic or aromatic ring system

For the sake of clarity, the structure and numbering of 9,9-diphenylfluorene is shown below:

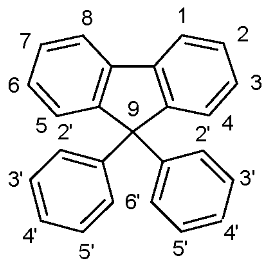

An aryl group in the context of this invention contains 6 to 60 carbon atoms; a heteroaryl group in the context of this invention contains 2 to 60 carbon atoms and at least one heteroatom, with the proviso that the total sum of carbon atoms and heteroatoms is at least 5. The heteroatoms are preferably selected from N, O and/or S. An aryl group or heteroaryl group is understood here to mean either a simple aromatic ring, i.e. benzene, or a simple heteroaromatic ring, for example pyridine, pyrimidine, thiophene, etc., or a condensed (anellated) aryl or heteroaryl group, for example naphthalene, anthracene, pyrene, quinoline, isoquinoline, etc.

An aromatic ring system in the context of this invention contains 6 to 60 carbon atoms in the ring system, where the aromatic ring system is built up from benzene, naphthalene, phenanthrene, fluorene and spirobifluorene or combinations of these groups. A heteroaromatic ring system in the context of this invention contains 2 to 60 carbon atoms and at least one heteroatom in the ring system, with the proviso that the sum total of carbon atoms and heteroatoms is at least 5. The heteroatoms are preferably selected from N, O and/or S. An aromatic or heteroaromatic ring system in the context of this invention is understood to mean a system which does not necessarily contain only aryl or heteroaryl groups, but in which it is also possible for two or more aryl or heteroaryl groups to be interrupted by a short nonaromatic unit (preferably less than 10% of the atoms other than H), for example an $sp^3$-hybridized carbon, nitrogen or oxygen atom. For example, systems such as 9,9'-spirobifluorene, 9,9-diarylfluorene, triarylamine, diaryl ether, stilbene, benzophenone, etc. shall also be regarded as aromatic ring systems in the context of this invention. An aromatic or heteroaromatic ring system is likewise understood to mean systems in which two or more aryl or heteroaryl groups are joined to one another by single bonds, for example biphenyl, terphenyl or bipyridine.

An aromatic or heteroaromatic ring system which has 5-60 aromatic ring atoms and may also be substituted in each case by the R radicals as defined above and which may be joined to the aromatic or heteroaromatic system via any desired positions is especially understood to mean groups derived from benzene, naphthalene, anthracene, phenanthrene, benzanthracene, pyrene, chrysene, perylene, fluoranthene, naphthacene, pentacene, benzopyrene, biphenyl, biphenylene, terphenyl, terphenylene, fluorene, spirobifluorene, dihydrophenanthrene, dihydropyrene, tetrahydropyrene, cis- or trans-indenofluorene, truxene, isotruxene, spirotruxene, spiroisotruxene, furan, benzofuran, isobenzofuran, dibenzofuran, thiophene, benzothiophene, isobenzothiophene, dibenzothiophene, pyrrole, indole, isoindole, carbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthimidazole, phenanthrimidazole, pyridimidazole, pyrazinimidazole, quinoxalinimidazole, oxazole, benzoxazole, naphthoxazole, anthroxazole, phenanthroxazole, isoxazole, 1,2-thiazole, 1,3-thiazole, benzothiazole, pyridazine, benzopyridazine, pyrimidine, benzopyrimidine, quinoxaline, 1,5-diazaanthracene, 2,7-diazapyrene, 2,3-diazapyrene, 1,6-diazapyrene, 1,8-diazapyrene, 4,5-diazapyrene, 4,5,9,10-tetraazaperylene, pyrazine, phenazine, phenoxazine, phenothiazine, fluorubine, naphthyridine, azacarbazole, benzocarboline, phenanthroline, 1,2,3-triazole, 1,2,4-triazole, benzotriazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, purine, pteridine, indolizine and benzothiadiazole.

For the purposes of the present invention, an aliphatic hydrocarbon radical or an alkyl group or an alkenyl or alkynyl group, which may typically contain 1 to 40 or also 1 to 20 C atoms and in which, in addition, individual H atoms or $CH_2$ groups may be substituted by the above-mentioned groups, is preferably taken to mean the radicals methyl, ethyl, n-propyl, i-propyl, n-butyl, i-butyl, s-butyl, t-butyl, 2-methylbutyl, n-pentyl, s-pentyl, neopentyl, cyclopentyl, n-hexyl, neohexyl, cyclohexyl, n-heptyl, cycloheptyl, n-octyl, cyclooctyl, 2-ethylhexyl, trifluoromethyl, pentafluoroethyl, 2,2,2-trifluoroethyl, ethenyl, propenyl, butenyl, pentenyl, cyclopentenyl, hexenyl, cyclohexenyl, heptenyl, cycloheptenyl, octenyl, cyclooctenyl, ethynyl, propynyl, butynyl, pentynyl, hexynyl, heptynyl or octynyl. An alkoxy group having 1 to 40 C atoms is preferably taken to mean methoxy, trifluoromethoxy, ethoxy, n-propoxy, i-propoxy, n-butoxy, i-butoxy, s-butoxy, t-butoxy, n-pentoxy, s-pentoxy, 2-methylbutoxy, n-hexoxy, cyclohexyloxy, n-heptoxy, cycloheptyl-oxy, n-octyloxy, cyclooctyloxy, 2-ethylhexyloxy, pentafluoroethoxy or 2,2,2-trifluoroethoxy. A thioalkyl group having 1 to 40 C atoms is taken to mean, in particular, methylthio, ethylthio, n-propylthio, i-propylthio, n-butylthio, i-butylthio, s-butylthio, t-butylthio, n-pentylthio, s-pentylthio, n-hexylthio, cyclohexylthio, n-heptylthio, cycloheptylthio, n-octylthio, cyclooctylthio, 2-ethylhexylthio, trifluoromethylthio, pentafluoroethylthio, 2,2,2-trifluoroethyl-thio, ethenylthio, propenylthio, butenylthio, pentenylthio, cyclopentenylthio, hexenylthio, cyclohexenylthio, heptenylthio, cycloheptenylthio, octenylthio, cyclooctenylthio, ethynylthio, propynylthio, butynylthio, pentynylthio, hexynylthio, heptynylthio or octynylthio. In general, alkyl, alkoxy or thioalkyl groups in

accordance with the present invention can be straight-chain, branched or cyclic, where one or more non-adjacent $CH_2$ groups may be replaced by the above-mentioned groups; furthermore, one or more H atoms may also be replaced by D, F, Cl, Br, I, CN or $NO_2$, preferably F, Cl or CN, further preferably F or CN, particularly preferably CN.

In a preferred embodiment of the invention, the at least one compound having a band gap of 2.5 eV or more represented by the formula (1) has a molecular weight of not more than 5000 g/mol, preferably not more than 4000 g/mol, particularly preferably not more than 3000 g/mol, especially preferably not more than 2000 g/mol and most preferably not more than 1000 g/mol.

In addition, in a preferred embodiment it is a feature of the at least one compound having a band gap of 2.5 eV or more that it is sublimable. Such compounds generally have a molar mass of less than about 1200 g/mol.

In addition, in a preferred embodiment it is a feature of the at least one compound having a band gap of 2.5 eV or more that it has a high solubility in standard organic solvents, preferably a solubility of ≥ 10 mg/ml in toluene.

In a preferred embodiment of the invention, in the formula (1), groups $A^1$, $A^2$, $A^3$ and $A^4$ stand, identically or differently on each occurrence, for $CR^1$ or N, where not more than one of the groups $A^1$, $A^2$, $A^3$ and $A^4$ per cycle in the fluorene unit stands for N. In a further preferred embodiment of the invention, precisely two adjacent groups $A^1$, $A^2$, $A^3$ and $A^4$ stand for a unit of the above-mentioned formula (7). More preferably, all groups $A^1$, $A^2$, $A^3$ and $A^4$ stand for $CR^1$.

In a further preferred embodiment of the invention, in the compound represented by the formula (1), at least one of the $V^1$, $V^2$, $V^3$ groups comprises an $R^2$ radical which is an aromatic or heteroaromatic ring system having 5 to 40 aromatic ring atoms. Further preferably, the groups $V^1$, $V^2$, $V^3$ comprise a total of not more than two $CR^2$ groups comprising an aromatic or heteroaromatic ring system, which includes possible $R^4$ or $R^6$ substituents, and so a total of not more than two $R^2$ radicals including the $R^4$ or $R^6$ substituents present on these $R^2$ radicals comprise an aromatic or heteroaromatic ring system. In case the groups $V^1$, $V^2$, $V^3$ comprise a total of two $CR^2$ groups comprising an aromatic or heteroaromatic ring system, preferably both groups $V^2$ stand for $CR^2$ comprising an $R^2$ radical which is an aromatic or heteroaromatic ring system having 5 to 40 aromatic ring atoms. In a particularly preferred embodiment, the groups $V^1$, $V^2$, $V^3$ comprise not more than one radical $R^2$ comprising an aromatic or heteroaromatic ring system having 5 to 40 aromatic ring atoms. In this embodiment, preferably the $V^2$ group in the 3'-position stands for $CR^2$ comprising an $R^2$ radical which is an aromatic or heteroaromatic ring system.

More preferably, not more than one of the groups $V^1$, $V^2$ and $V^3$ is N. Even more preferably, all groups $V^1$, $V^2$, $V^3$ stand for $CR^2$.

In a further preferred embodiment, none of the radicals $R^2$ in the groups $V^1$, $V^2$, $V^3$ in the formula (1) and none of the $R^4$, $R^6$ substituents which may be bonded directly or indirectly to a radical $R^2$ comprises a nitrogen atom.

The symbol Z in the unit of the formula (7) preferably stands for $CR^1$.

In a further preferred embodiment of the invention, the at least one compound having a band gap of 2.5 eV or more is represented by the formula (2), (3), (4), (5), (6), (8) or 9)

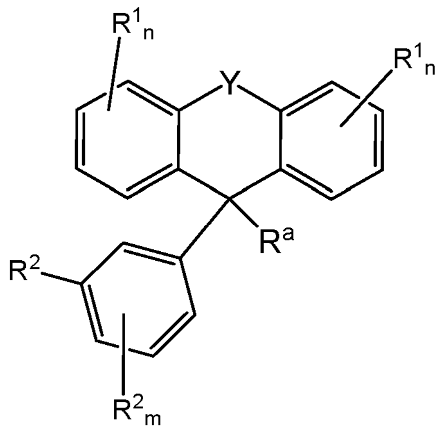

formula (2)

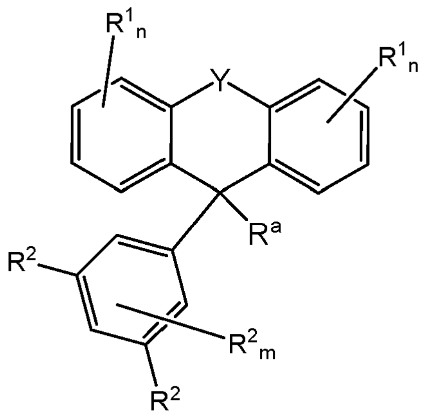

formula (3)

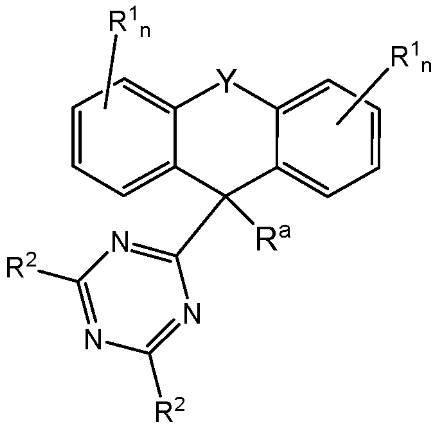

formula (4)

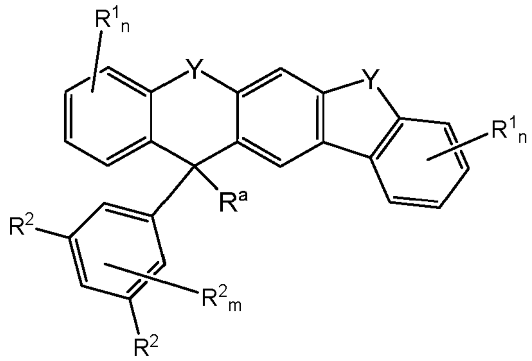

formula (5)

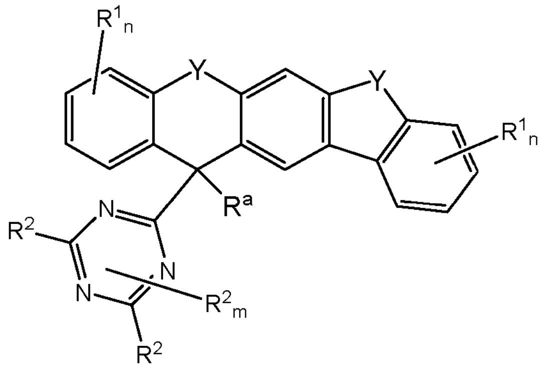

formula (6)

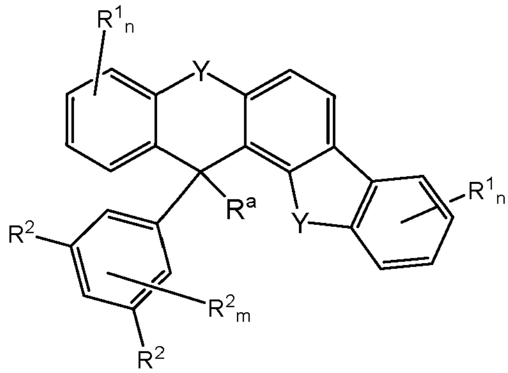

formula (8)

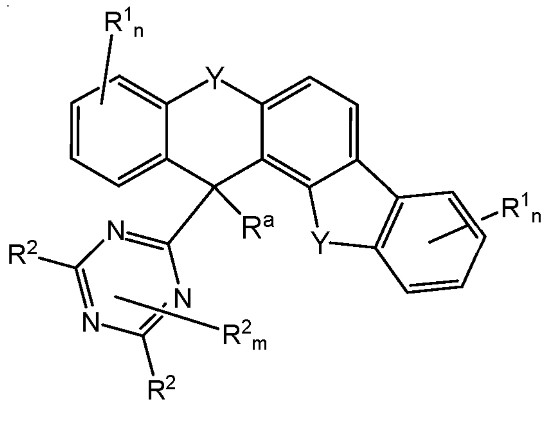

formula (9)

where the symbols used have the meanings indicated above, m is 0 or 1, and each n is independently 0, 1, 2, 3 or 4, preferably 0, 1 or 2.

In a preferred embodiment of the invention, the group Y in the six-membered ring in compounds of the formula (2), (3), (4), (5), (6), (8) or (9) stands for a single bond or a group selected from $C(R^1)_2$, O or $NR^1$, particularly preferably for a single bond, and in the five-membered ring preferably stands for a group selected from $C(R^1)_2$, O or $NR^1$, particularly preferably for $C(R^1)_2$ or N, very particularly preferably for $C(R^1)_2$.

In a more preferred embodiment of the invention, the at least one compound having a band gap of 2.5 eV or more therefore is represented by the formula (2a), (3a), (4a), (5a), (5b), (6a), (6b), (8a), (8b), (9a) or (9b)

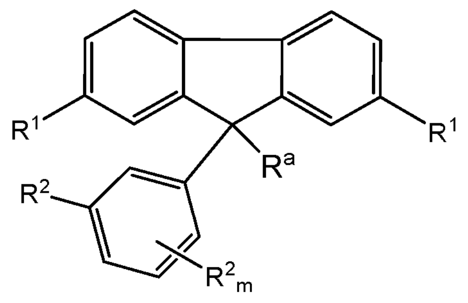

formula (2a)

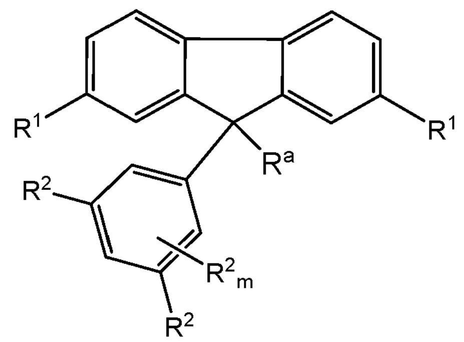

formula (3a)

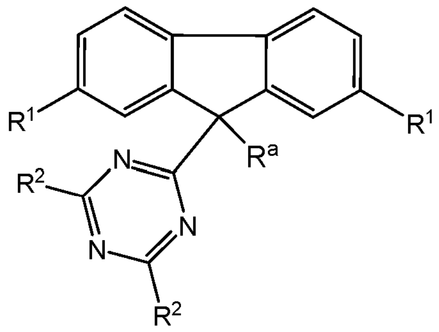

formula (4a)

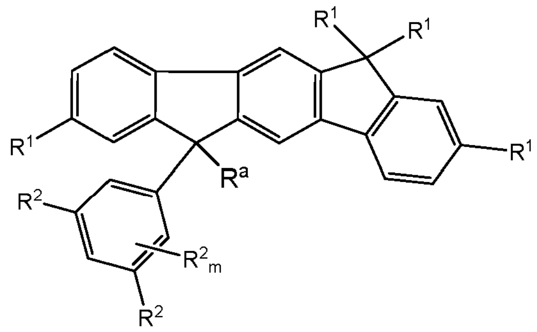

formula (5a)

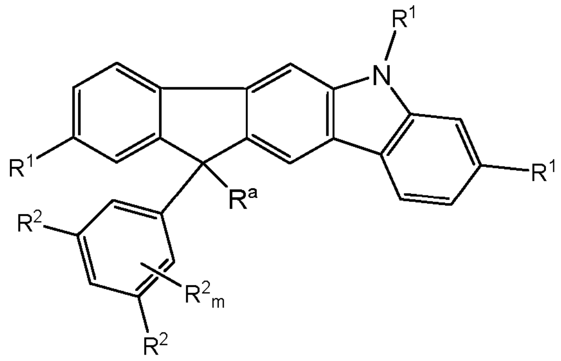

formula (5b)

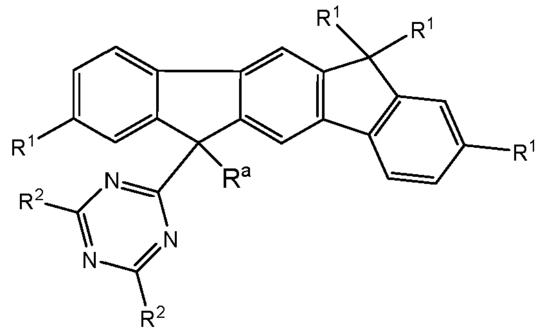

formula (6a)

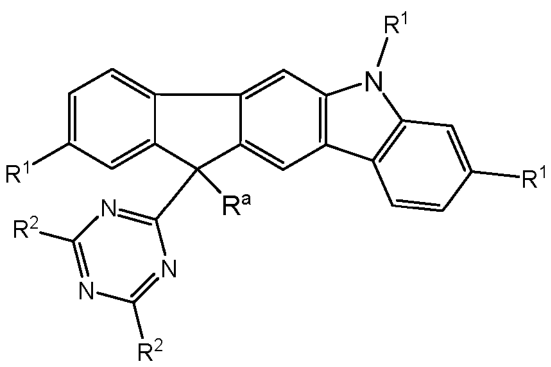

formula (6b)

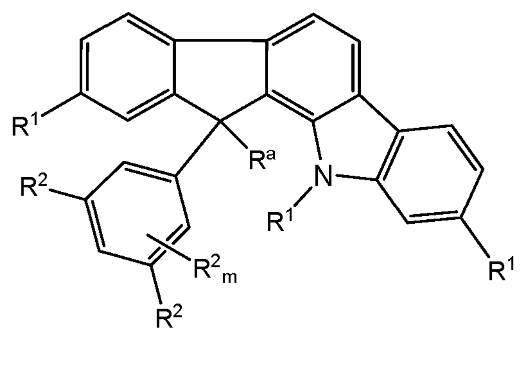

formula (8a)

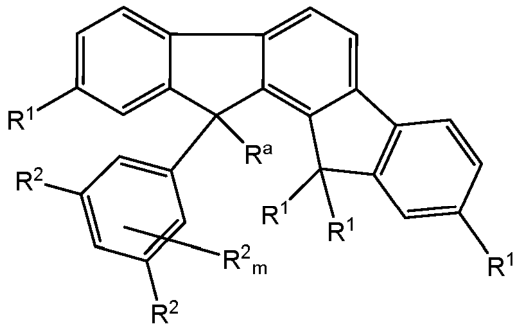

formula (8b)

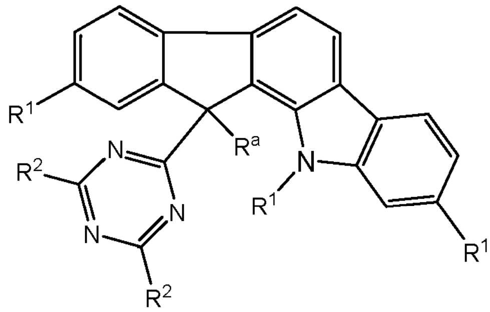

formula (9a)

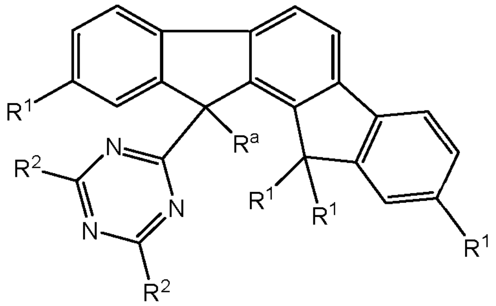

formula (9b)

where the symbols used have the meanings mentioned above and m is 0 or 1.

In a further preferred embodiment, substituent $R^a$ is an aromatic or heteroaromatic ring system having 5 to 60 aromatic ring atoms, preferably an aromatic or heteroaromatic ring system having 5 to 30 aromatic ring atoms, in particular having 6 to 20 aromatic ring atoms, and very particularly preferably is phenyl or triazinyl, which may in each case be substituted by one or more radicals $R^3$. Further preferably, substituent $R^a$ is not linked to one adjacent group $V^1$, $V^2$, or $V^3$. This means that the substituent $R^a$ and a group $V^1$, $V^2$, or $V^3$ are not bonded to one another by a bond, or any $R^3$ or $R^2$ radicals respectively present are not joined to one another, which likewise rules out joining via possible $R^4$ or $R^6$ substituents.

In a still more preferred embodiment of the invention, the at least one compound having a band gap of 2.5 eV or more is a compound represented by the formula (10), (11) or (12)

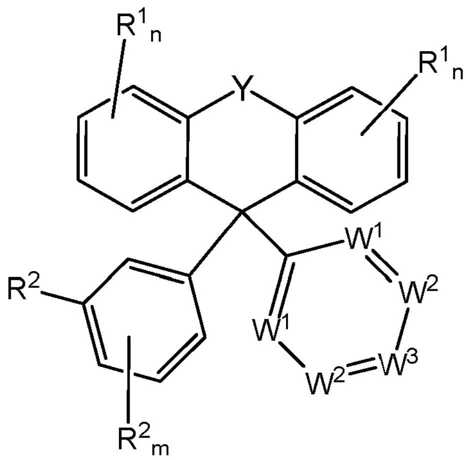

formula (10)

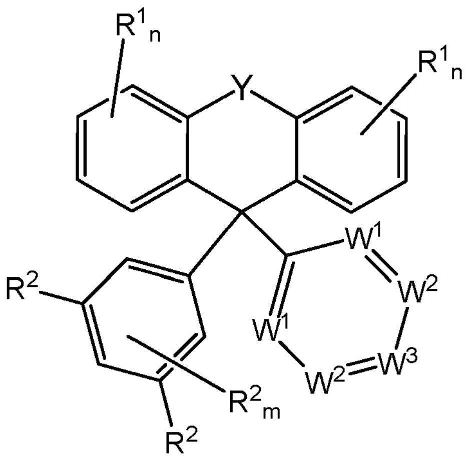

formula (11)

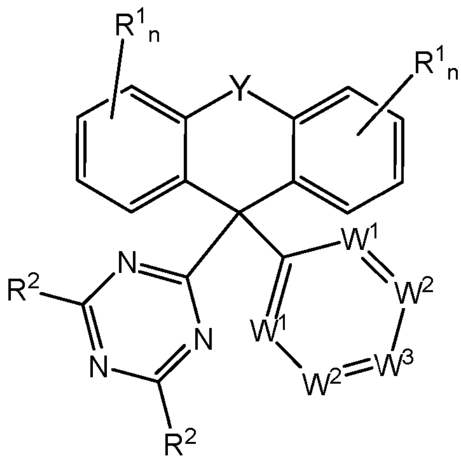

formula (12)

where $W^1$, $W^2$, $W^3$ is, identically or different at each occurrence, N or $CR^3$, preferably $CR^3$, with the proviso that not more than three of the groups $W^1$, $W^2$, $W^3$ in one cycle are N; and

where the symbols used have the meanings mentioned above, m is 0 or 1, and each n is independently 0, 1, 2, 3 or 4, preferably 0, 1 or 2.

In a further preferred embodiment of the invention, in the compound of the structure represented by formula (10), (11) or (12), at least one of the $W^1$, $W^2$, $W^3$ groups comprises an $R^3$ radical which is an aromatic or heteroaromatic ring system having 5 to 40 aromatic ring atoms. Further preferably, the groups $W^1$, $W^2$, $W^3$ comprise a total of not more than two $CR^3$ groups comprising an aromatic or heteroaromatic ring system, which includes possible $R^4$ or $R^6$ substituents, and so a total of not more than two $R^3$ radicals including the $R^4$ or $R^6$ substituents present on these $R^3$ radicals comprise an aromatic or heteroaromatic ring system. In case the groups $W^1$, $W^2$, $W^3$ comprise a total of two $CR^3$ groups comprising an aromatic or heteroaromatic ring system, preferably both groups $W^2$ stand for $CR^3$ comprising an $R^3$ radical which is an aromatic or heteroaromatic ring system having 5 to 40 aromatic ring atoms. In a particularly preferred embodiment, the groups $W^1$, $W^2$, $W^3$ comprise not more than one radical $R^3$ comprising an aromatic or heteroaromatic ring system having 5 to 40 aromatic ring atoms. In this embodiment, preferably the $W^2$ group in the 3'-position stands for $CR^3$ comprising an $R^3$ radical which is an aromatic or heteroaromatic ring system.

More preferably, not more than one of the groups $W^1$, $W^2$ and $W^3$ is N. Even more preferably, all groups $W^1$, $W^2$, $W^3$ stand for $CR^3$.

In a further preferred embodiment, none of the radicals $R^3$ in the groups $W^1$, $W^2$, $W^3$ in the formula (10), (11) or (12) and none of the $R^4$, $R^6$ substituents which may be bonded directly or indirectly to a radical $R^3$ comprises a nitrogen atom.

In a further more preferred embodiment of the invention, the at least one compound having a band gap of 2.5 eV or more is a compound represented by the formula (13), (14), (15), (16), (17), (18), (19), (20), (21), (22), (23) or (24)

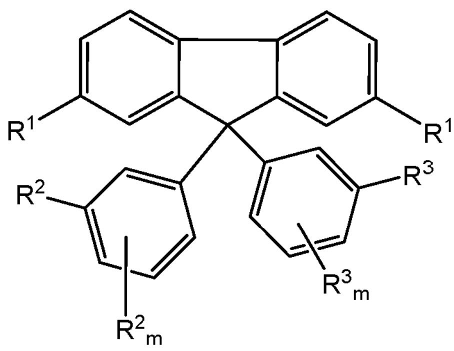

formula (13)

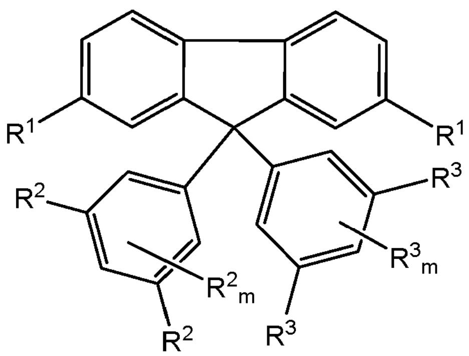

formula (14)

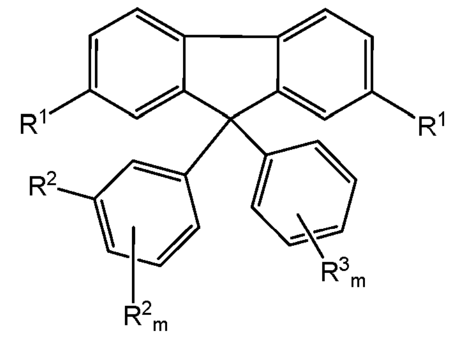

formula (15)

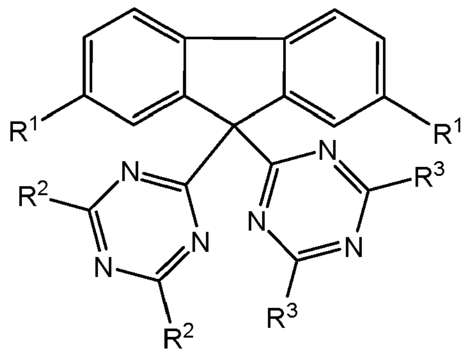

formula (16)

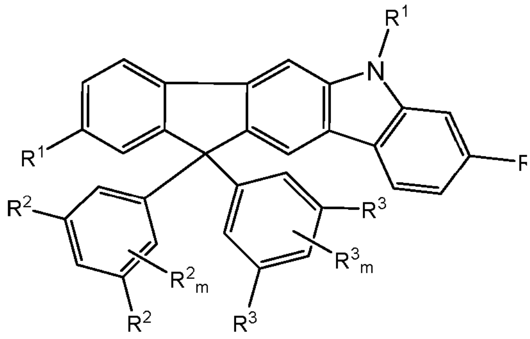

formula (17)

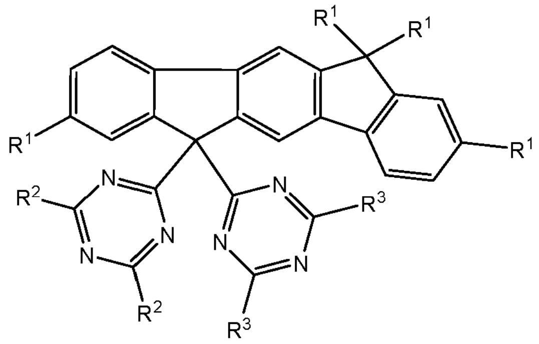

formula (18)

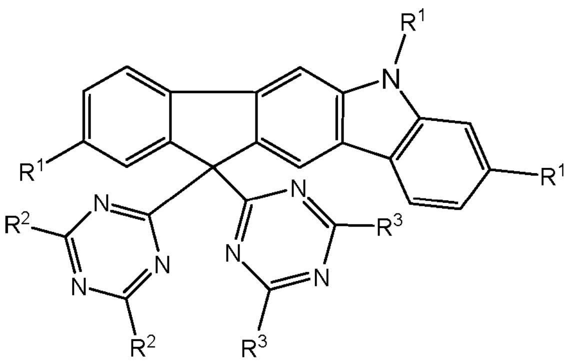

formula (19)

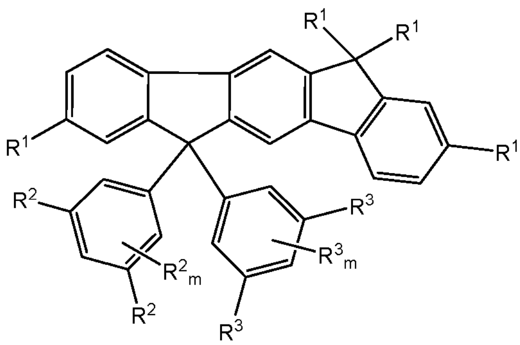

formula (20)

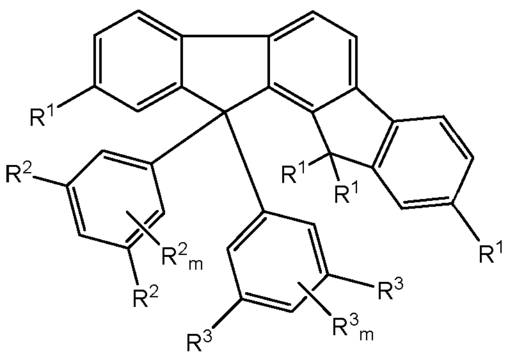

formula (21)

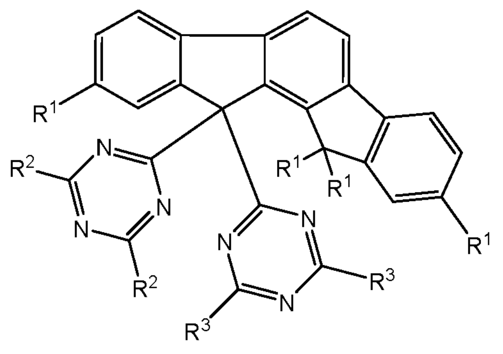

formula (22)

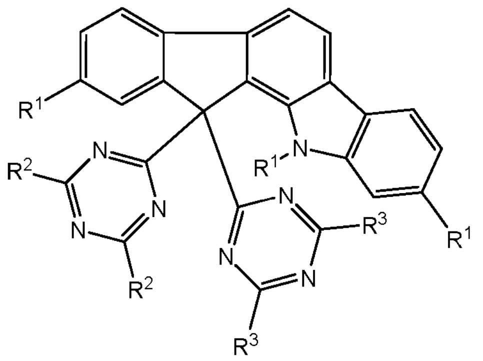

formula (23)

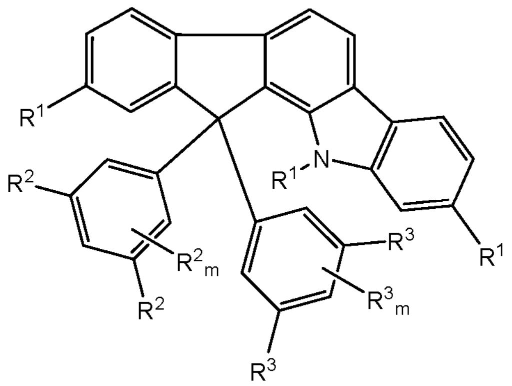

formula (24)

where the symbols used have the meanings mentioned above and each m is independently 0 or 1, where the total sum of the indices m is not more than 1.

In a further preferred embodiment of the invention, the symbols $R^2$, $R^3$ in compounds of the formulae mentioned above, in particular formulae (13), (14), (15), (16), (17), (18), (19), (20), (21), (22), (23) and (24), stand, identically or differently on each occurrence, for $N(Ar)_2$, C(=O)Ar, $P(=O)Ar_2$ or for an aromatic or heteroaromatic ring system having 5 to 30 aromatic ring atoms, which may be substituted by one or more non-aromatic radicals $R^4$. $R^2$, $R^3$ particularly preferably, if bonded to a phenyl group, stand, identically or differently, preferably identically, on each occurrence for an aromatic or heteroaromatic ring system having 5 to 30 aromatic ring atoms, which may be substituted by one or more non-aromatic radicals $R^4$, $N(Ar)_2$ or C(=O)Ar, very particularly preferably for an aromatic or heteroaromatic ring system having 5 to 30 aromatic ring atoms, which may be substituted by one or more non-aromatic radicals $R^4$. $R^2$, $R^3$ particularly preferably, if bonded to a triazine group, stand, identically or differently, preferably identically, on each occurrence for an aromatic or heteroaromatic ring system having 5 to 30 aromatic ring atoms, which may be substituted by one or more non-aromatic radicals $R^4$. Substituents $R^2$, $R^3$ which are furthermore preferred are Cl, Br, I and triflate, in particular Br, since these are valuable intermediates in the synthesis of further compounds according to the invention.

Further preferably, the radicals $R^2$ in structures of the formulae mentioned above, in particular formulae (13), (14), (15), (16), (17), (18), (19), (20), (21), (22), (23) and (24), do not form a condensed ring system with the ring atoms of the phenyl group to which the $R^2$ radicals are bonded. This rules out the formation of a condensed ring system with possible $R^4$, $R^6$ substituents which may be bonded to the $R^2$ radicals. Furthermore preferably, preferably in addition, the radicals $R^3$ in the formulae (13), (14), (15), (16), (17), (18), (19), (20), (21), (22), (23) and (24) do not form a condensed ring system with the ring atoms of the phenyl group to which the $R^3$ radicals are bonded. This also rules out the formation of a condensed ring system with possible $R^4$, $R^6$ substituents which may be bonded to the $R^3$ radicals.

In a further preferred embodiment of the invention, all symbols $R^2$ and $R^3$ in compounds of the above-mentioned formulae are selected identically. This preference can be explained by the easier synthetic accessibility of the compounds.

If the radical $R^2$ or $R^3$ stands for a group $N(Ar)_2$, this group is preferably selected from the groups of the formula (25) or formula (26):

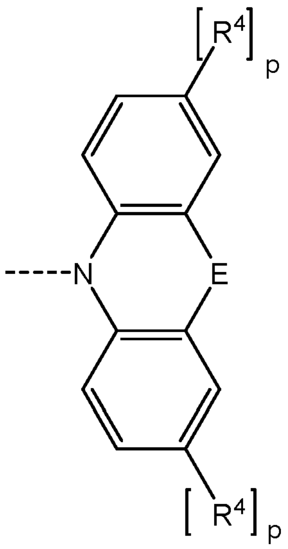

formula (25)

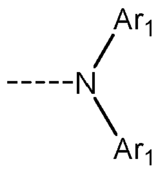

formula (26)

where $R^4$ has the meaning indicated above, and furthermore:

E stands for a single bond, O, S, $N(R^4)$ or $C(R^4)_2$;

$Ar^1$ is, identically or differently on each occurrence, an aromatic or heteroaromatic ring system having 5 to 20 aromatic ring atoms or a triarylamine group having 15 to 30 aromatic ring atoms, each of which may be substituted by one or more radicals $R^4$, preferably an aryl or heteroaryl group having 6 to 14 aromatic ring atoms or a triarylamine group having 18 to 30 aromatic ring atoms, preferably having 18 to 22 aromatic ring atoms, each of which may be substituted by one or more radicals $R^4$;

p is on each occurrence, identically or differently, 0 or 1.

$Ar^1$ particularly preferably stands, identically or differently on each occurrence, for phenyl, biphenyl, 1-naphthyl, 2-naphthyl, 2-, 3- or 4-triphenylamine, 1- or 2-naphthyldiphenylamine, each of which may be bonded via the naphthyl or phenyl group, or 1- or 2-dinaphthylphenylamine, each of which may be bonded via the naphthyl or phenyl group, N-carbazolyl or N-phenyl-2-carbazolyl or N-phenyl-3-carbazolyl. These groups may each be substituted by one or more alkyl groups having 1 to 4 carbon atoms or by fluorine.

If the radical $R^2$ or $R^3$ represents an aromatic or heteroaromatic ring system, this is preferably selected from aromatic or heteroaromatic ring systems having 5 to 30 aromatic ring atoms, in particular having 6 to 20 aromatic ring atoms, very particularly preferably from phenyl, 1-naphthyl, 2-naphthyl, anthracenyl, phenylanthracenyl, 1- or 2-naphthylanthracenyl, binaphthyl, pyrenyl, fluoranthenyl, 2-, 3-, 4-, 5-, 6- or 7-benzanthracenyl, N-benzimidazolyl, phenyl-N-benzimidazolyl, N-phenylbenzimidazolyl and phenyl-N-phenylbenzimidazolyl.

In a more preferred embodiment of the invention, the at least one compound having a band gap of 2.5 eV or more represented by the formula (1) or a preferred embodiment thereof as defined herein has a total of not more than 5 nitrogen atoms, preferably a total of not more than 3 nitrogen atoms, more preferably a total of not more than one nitrogen atom and particularly preferably no nitrogen atom.

It may further be the case that the at least one compound having a band gap of 2.5 eV or more represented by the formula (1) or a preferred embodiment thereof as defined herein has a total of not more than 5 heteroatoms, preferably a total of not more than 3 heteroatoms, more preferably a total of not more than one heteroatom and particularly preferably no heteroatom, apart from fluorine.

Especially preferably, the at least one compound having a band gap of 2.5 eV or more represented by the formula (1) is a hydrocarbon or a fluorinated hydrocarbon, preferably a hydrocarbon.

Particularly preferably, the at least one compound having a band gap of 2.5 eV or more is a compound represented by the formula (27), (28), (29), (30) or (31)

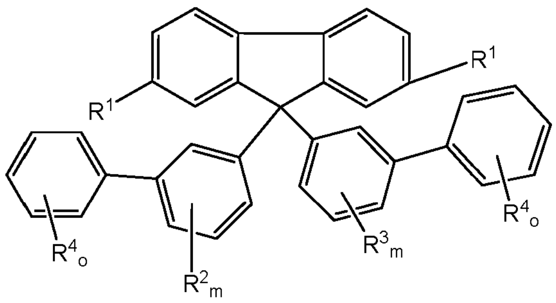

formula (27)

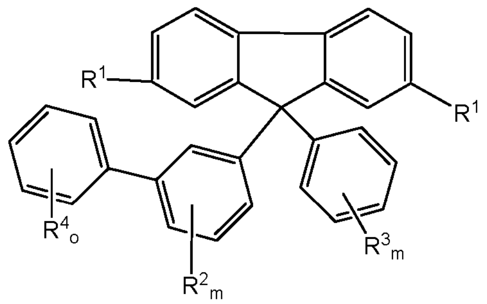

formula (28)

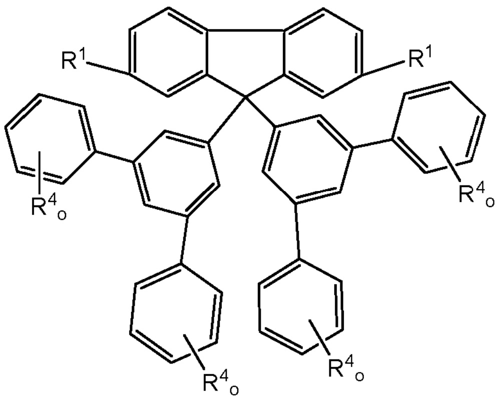

formula (29)

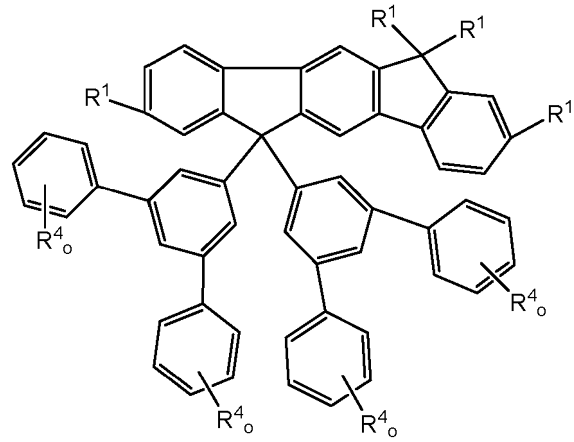

formula (30)

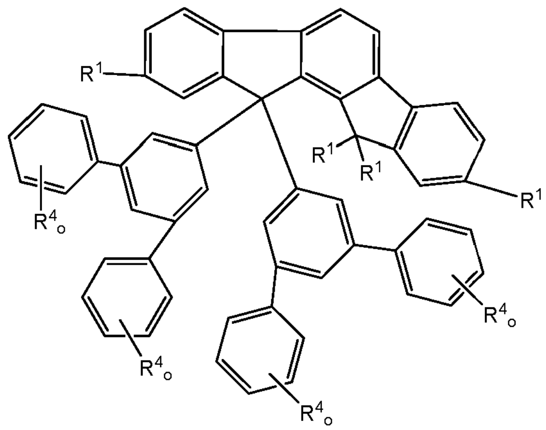

formula (31)

where the symbols used have the meanings mentioned above, and each m is independently 0 or 1, where the total sum of the indices m is not more than 1, and each o is independently 0, 1, 2, 3, 4 or 5, preferably 1, 2 or 3, particularly preferably 1 or 2.

Further preferably, the total sum of the indices o is at least 2, preferably 2, 3 or 4 for formula (27) or (28), preferably 4, 5, 6, 7 or 8 for formula (29), (30) or (31).

In addition, preference is given to a compound represented by the formula (27), (28), (29), (30) or (31), which is characterized in that the radicals $R^4$ in formula (27), (28), (29), (30) or (31) do not form a condensed ring system with the ring atoms of the phenyl group to which the $R^4$ radicals are bonded. This also rules out the formation of a condensed ring system with possible $R^6$ substituents which may be bonded to the $R^4$ radicals. Further preferably, not more than one and still further preferably none of the radicals $R^4$ in the formulae (27), (28), (29), (30) and (31), or one of the $R^6$ substituents

which may be bonded directly or indirectly to an $R^4$ radical, comprises a nitrogen atom. Still further preferably, the radicals $R^4$ do not have any heteroatom. Particularly preferably, the radical $R^4$ is an aromatic ring system, especially an aryl radical, or H.

The total sum of the indices m in compounds of the formulae mentioned above is particularly preferably 0, and so the phenyl radicals bonded to the fluorene group preferably do not comprise any additional substituents.

In a further preferred embodiment of the invention, the symbol $R^1$ in compounds of the above-mentioned formulae stands, identically or differently on each occurrence, for H, F, $N(Ar)_2$, C(=O)Ar, $P(=O)(Ar)_2$, S(=O)Ar, $S(=O)_2Ar$, $CR^2=CR^2Ar$, a straight-chain alkyl group having 1 to 10 C atoms or a branched or cyclic alkyl group having 3 to 10 C atoms, each of which may be substituted by one or more radicals $R^5$, where one or more non-adjacent $CH_2$ groups may be replaced by $R^5C=CR^5$ or O and where one or more H atoms may be replaced by F, or an aromatic or heteroaromatic ring system having 5 to 20 aromatic ring atoms, which may in each case be substituted by one or more radicals $R^5$, or a combination of these systems; two or more adjacent substituents $R^1$ here may also form a mono- or polycyclic, aliphatic or aromatic ring system with one another. In a particularly preferred embodiment of the invention, the symbol $R^1$ in compounds of the above-mentioned formulae stands, identically or differently on each occurrence, for H, F, $N(Ar)_2$, a straight-chain alkyl group having 1 to 6 C atoms or a branched or cyclic alkyl group having 3 to 6 C atoms, each of which may be substituted by one or more radicals $R^5$, where one or more H atoms may be replaced by F, or an aromatic or heteroaromatic ring system having 5 to 14 aromatic ring atoms, which may in each case be substituted by one or more radicals $R^5$; two or more adjacent substituents $R^1$ here may also form a mono- or polycyclic, aliphatic or aromatic ring system with one another. In particular, $R^1$ stands, identically or differently on each occurrence, for H, F, methyl, ethyl, isopropyl or tert-butyl, in particular for H. In the case of compounds which are processed from solution, linear or branched alkyl chains having up to 10 C atoms are also preferred.

Preferred radicals $R^1$ which are present in the bridge Y on corresponding choice of Y are identical or different on each occurrence and are preferably selected from H, straight-chain alkyl groups having 1 to 6 C atoms or branched alkyl groups having 3 to 6 C atoms, where one or more non-adjacent $CH_2$ groups may be replaced by $-R^5C=CR^5-$, -C≡C- or -O- and where one or more H atoms may be replaced by F, or aryl groups having 6 to 20 C atoms or heteroaryl groups having 2 to 20 C atoms, each of which may be substituted by one or more radicals $R^5$, or a combination of two or three of these systems; two of the radicals $R^1$ here which are both bonded to Y may also form a ring system with one another and thus form a spiro system. Particularly preferred radicals $R^1$ which are bonded to the bridges Y are identical or different on each occurrence and are selected from methyl, ethyl, isopropyl, tert-butyl, where in each case one or more H atoms may be replaced by F, or aryl groups having 6 to 14 C atoms, which may be substituted by one or more radicals $R^5$; two radicals $R^1$ here may also form a ring system with one another. In the case of compounds which are processed from solution, linear or branched alkyl chains having up to 10 C atoms are also preferred. If the bridge Y is a group $NR^1$, the group $R^1$ is also particularly preferably selected from an aromatic or heteroaromatic ring system having 5 to 20 aromatic ring atoms.

Further preferably, in the compound represented by the formula (1) or the preferred embodiments thereof as defined above, the radicals $R^1$ do not form a condensed ring system with the ring atoms of the fluorene structure. This also rules out the formation of a condensed ring system with possible $R^5$, $R^6$ substituents which may be bonded to the $R^1$ radicals.

Further preferably, in the structures of the formulae mentioned above, in particular formulae (27), (28), (29), (30) and (31), not more than one and still further preferably none of the radicals $R^4$, or one of the $R^6$ substituents which may be bonded directly or indirectly to an $R^4$ radical, comprises a nitrogen atom.

It may especially be the case that in the structures of the formulae mentioned above, in particular formulae (27) and (28), at least one radical $R^1$, $R^2$, $R^3$ and/or $R^4$ is a group selected from the formulae (R-1) to (R- 45)

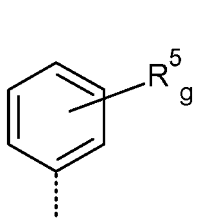

Formula (R-1)

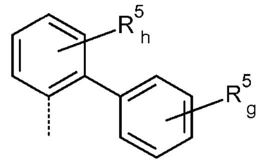

Formula (R-2)

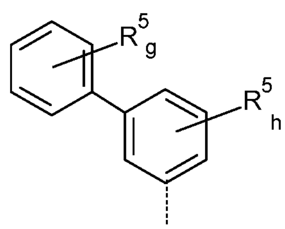

Formula (R-3)

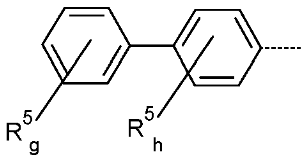

Formula (R-4)

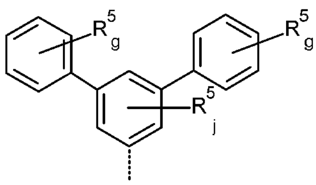

Formula (R-5)

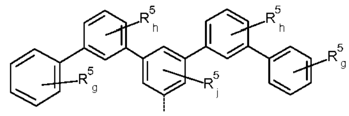

Formula (R-6)

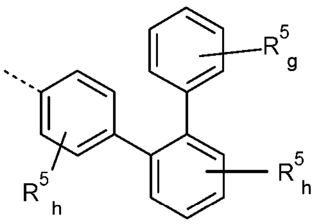

Formula (R-7)

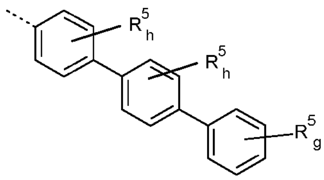

Formula (R-8)

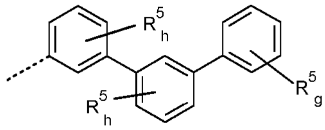

Formula (R-9)

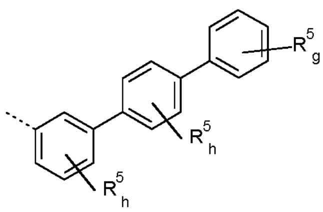

Formula (R-10)

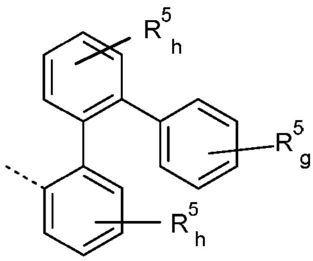

Formula (R-11)

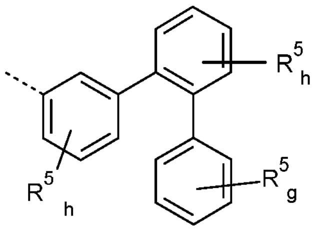

Formula (R-12)

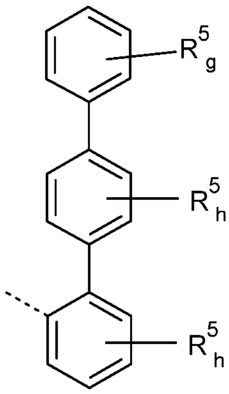

Formula (R-13)

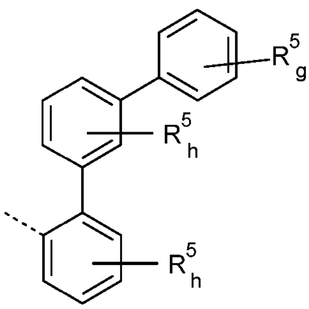

Formula (R-14)

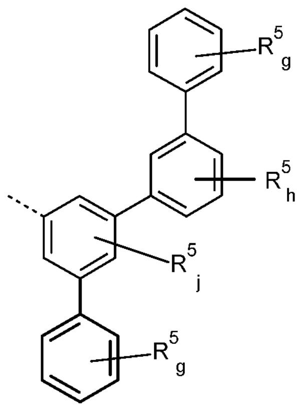

Formula (R-15)

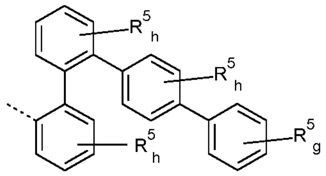

Formula (R-16)

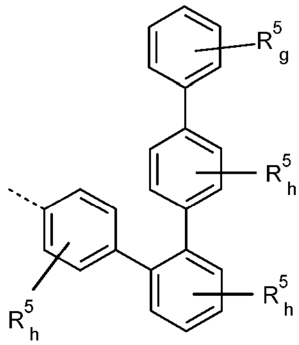

Formula (R-17)

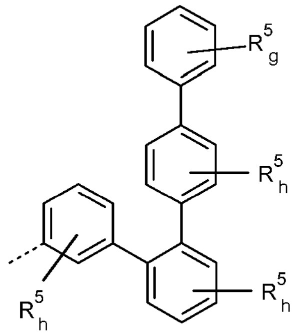

Formula (R-18)

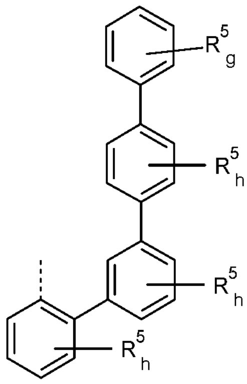

Formula (R-19)

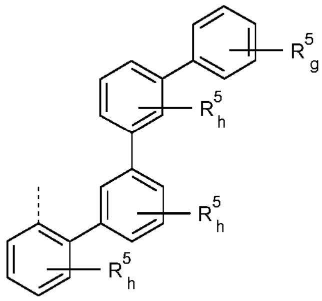

Formula (R-20)

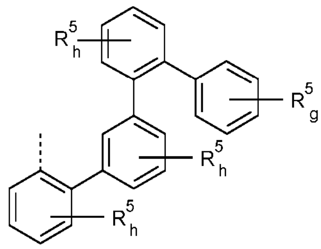

Formula (R-21)

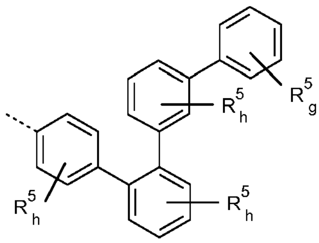

Formula (R-22)

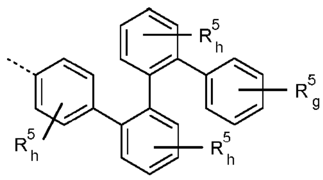

Formula (R-23)

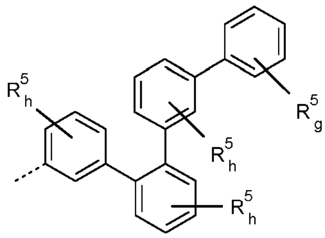

Formula (R-24)

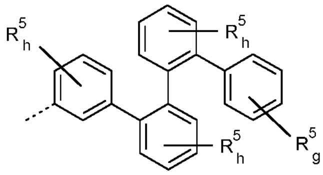

Formula (R-25)

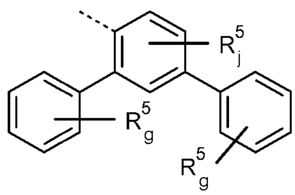

Formula (R-26)

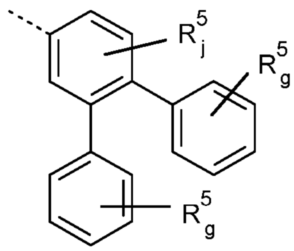

Formula (R-27)

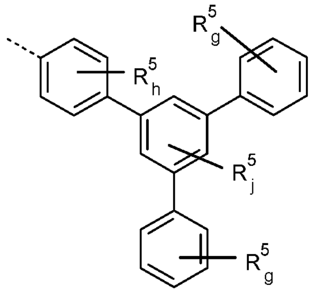

Formula (R-28)

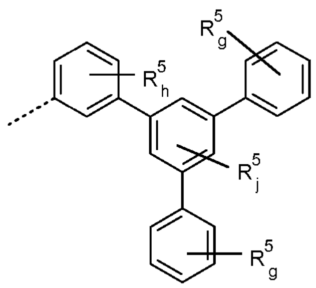

Formula (R-29)

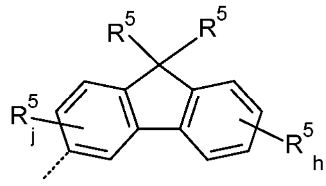

Formula (R-30)

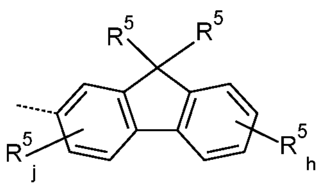

Formula (R-31)

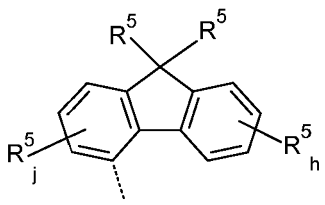

Formula (R-32)

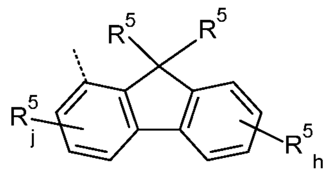

Formula (R-33)

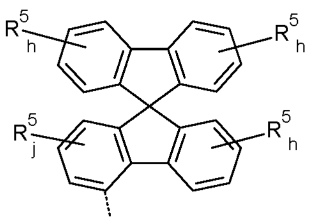

Formula (R-34)

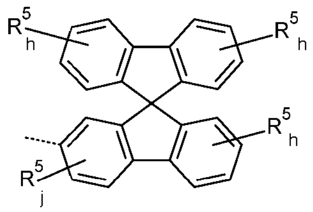

Formula (R-35)

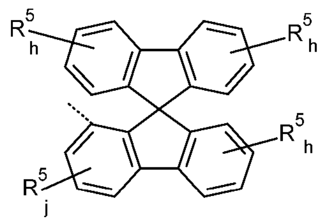

Formula (R-36)

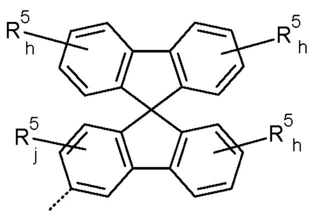

Formula (R-37)

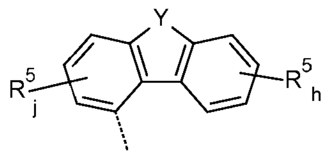

Formula (R-38)

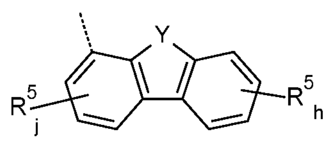

Formula (R-39)

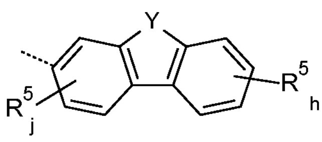

Formula (R-40)

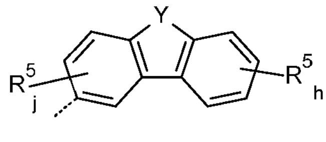

Formula (R-41)

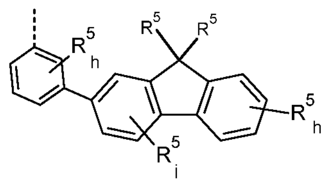

Formula (R-42)

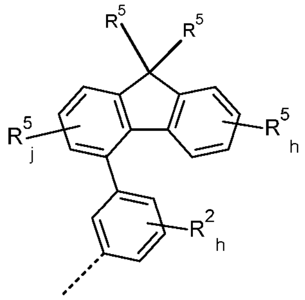

Formula (R-43)

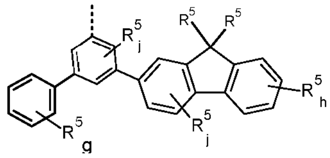

Formula (R-44)

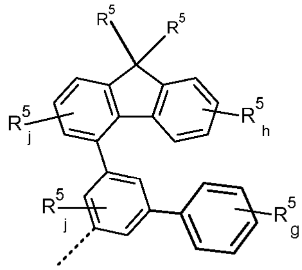

Formula (R-45)

where the symbols used are defined as follows:

Y is O, S or $NR^5$;
j independently at each occurrence instance is 0, 1, 2 or 3;
h independently at each occurrence is 0, 1, 2, 3 or 4;
g independently at each occurrence is 0, 1, 2, 3, 4 or 5: the dotted bond marks the attachment position; and
$R^5$ is as defined above, especially for formula (1).

More preferably, at least two of, and especially preferably all of, the radicals $R^1$, $R^2$, $R^3$ and/or $R^4$ in the structures of the formulae mentioned above, in particular formulae (27) and (28), are H, D, F, an aliphatic hydrocarbon radical which has 1 to 20 carbon atoms and in which hydrogen atoms may also be replaced by F, or a group selected from the formulae (R-1) to (R-45).

Among the groups of the formulae (R-1) to (R-45) mentioned above, preference is given to groups of the formulae (R-1) to (R-37) and (R-42) to (R-45). Among the groups of the formulae (R-1) to (R-45) mentioned above, particular preference is further given to the groups of the formulae (R-1) to (R-33) and (R-42) to (R-45). Very particular preference is given to the groups of the formulae (R-1), (R-3), (R-5), (R-6), (R-15), (R-29), (R-31), (R-32), (R-42), (R-43), (R-44) and/or (R-45).

Preferably, the total sum of the indices g, h and j in the structures of the formula (R-1) to (R-45) is not more than 3 in each case, more preferably not more than 2 and particularly preferably not more than 1. Most preferably, the total sum of the indices g, h and j in each of the structures of the formula (R-1) to (R-45) is 0.

Further preferably, in the structures of the formula ($R^1$-1) to ($R^1$-45), the radical $R^5$ is H, F or a group selected from aliphatic hydrocarbyl radicals having 1 to 20 carbon atoms and in which hydrogen atoms may also be replaced by F. In this context, the $R^5$ radicals preferably do not comprise any $R^6$ substituents.

It may further be the case that a compound represented by the formula (1) or a preferred embodiment thereof as define above is symmetric in relation to the mirror plane defined by the fluorene group. The mirror plane defined by the fluorene group encompasses all the carbon atoms of the fluorene group, and so the groups bonded to the carbon atom in the 9 position of the fluorene group have identical substitution.

In another preferred embodiment, a compound of formula (1) or a preferred embodiment thereof as define above, is unsymmetric in relation to the mirror plane defined by the fluorene group. Accordingly, the groups bonded in the 9 position of the fluorene group preferably do not have identical substitution.

In a particular embodiment, the at least one compound having a band gap of 2.5 eV or more represented by structures of formula (1), or a preferred embodiment thereof as defined above, has a glass transition temperature of at least 70°C, more preferably of at least 110°C, even more preferably of at least 125°C and especially preferably of at least 150°C, determined in accordance with DIN EN ISO 11357-1 and DIN EN ISO 11357-2.

Examples of preferred compounds of the formula (1), which may preferably be used as the at least one compound having a band gap of 2.5 eV or more in the electronic device of the invention, are the structures (1) to (323) depicted below.

| | |
|---|---|
| 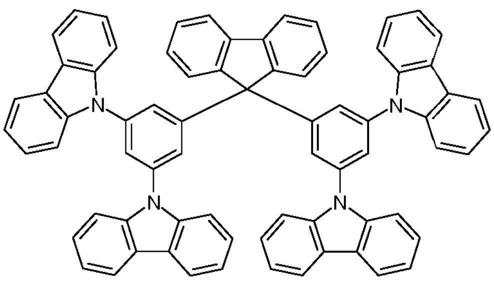 | 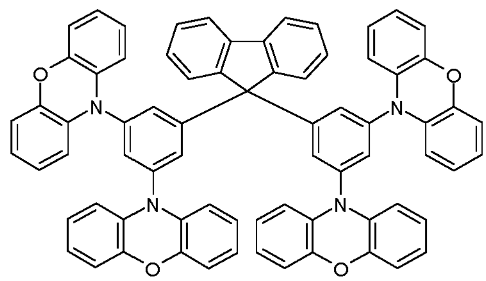 |
| (1) | (2) |
| 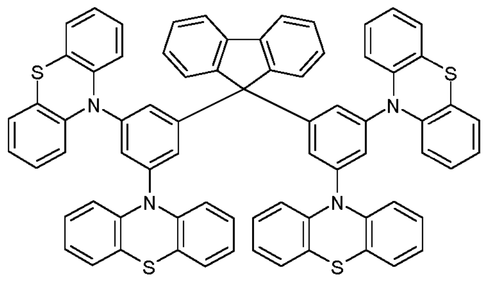 | 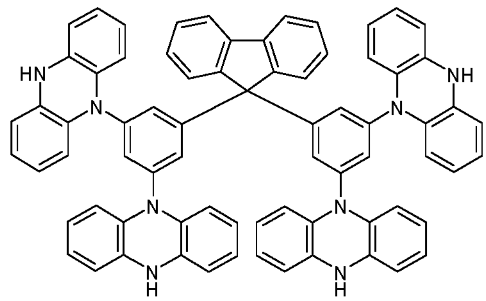 |
| (3) | (4) |
| 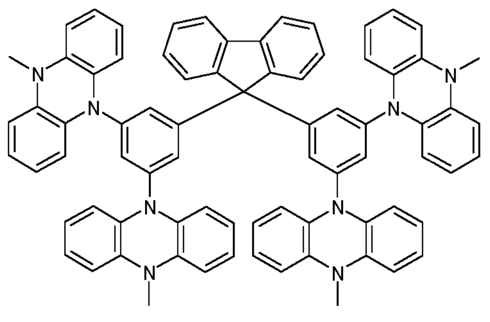 | 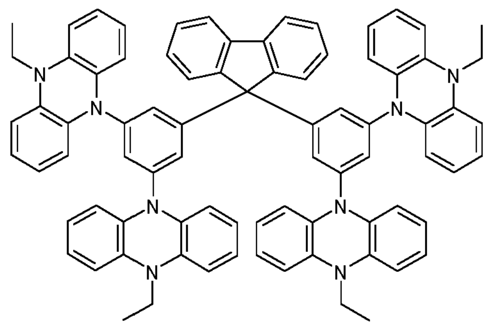 |
| (5) | (6) |
| 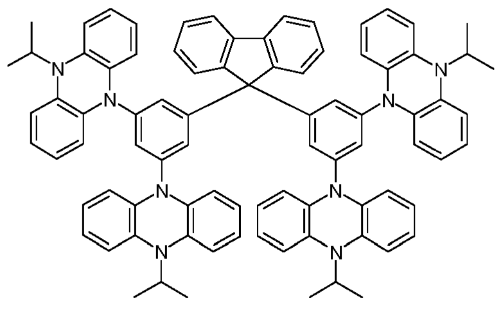 | 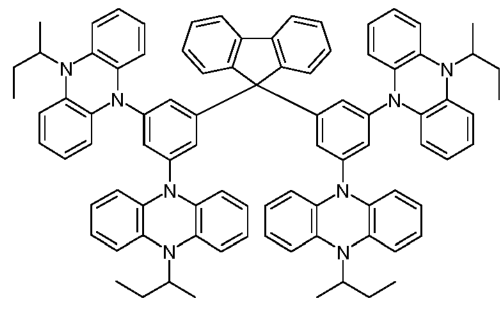 |
| (7) | (8) |
| 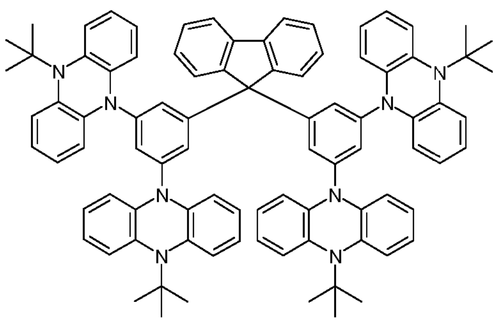 | 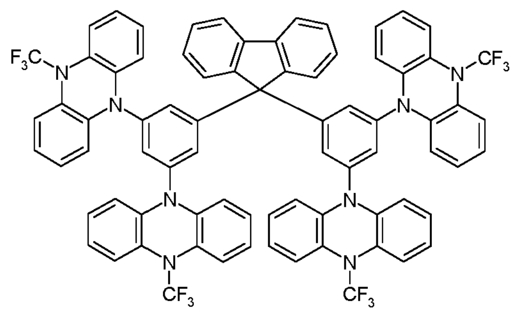 |

(continued)

| (9) | (10) |
|---|---|
| 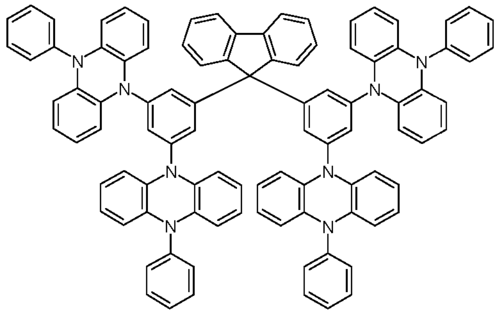 | 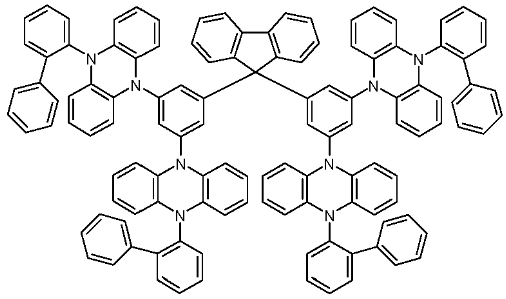 |
| (11) | (12) |
| 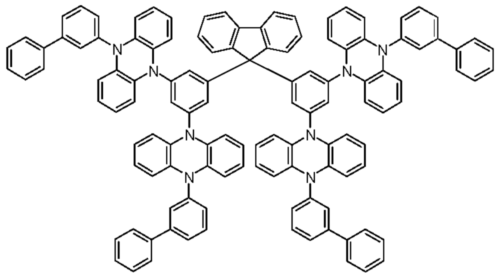 | 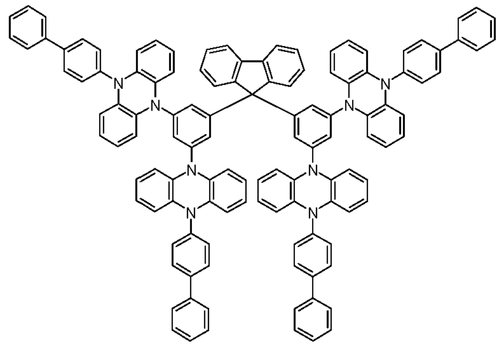 |
| (13) | (14) |
| 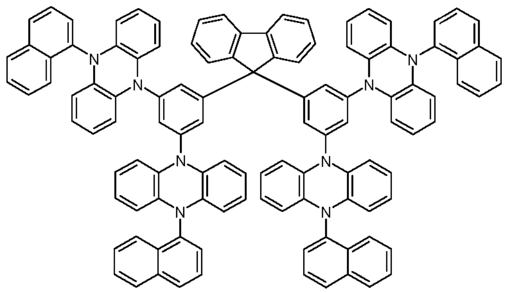 | 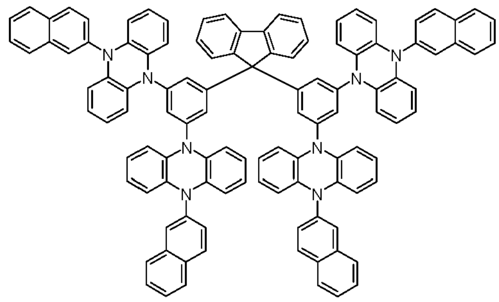 |
| (15) | (16) |
| 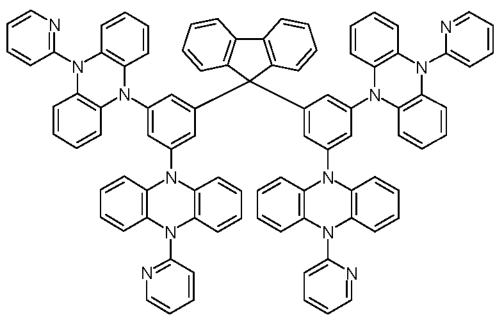 | 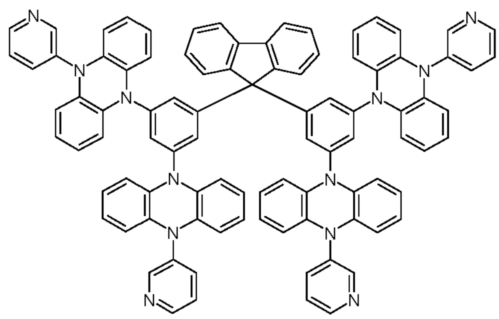 |
| (17) | (18) |

(continued)

| | |
|---|---|
| 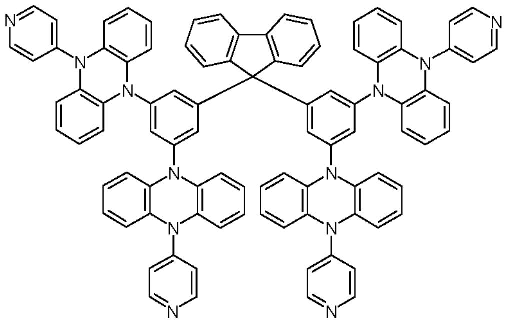 | 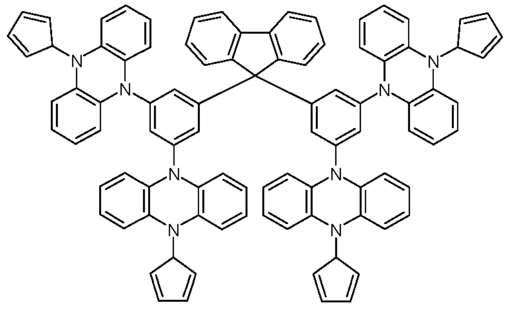 |
| (19) | (20) |
| 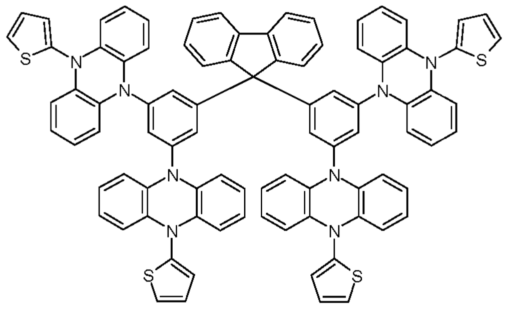 | 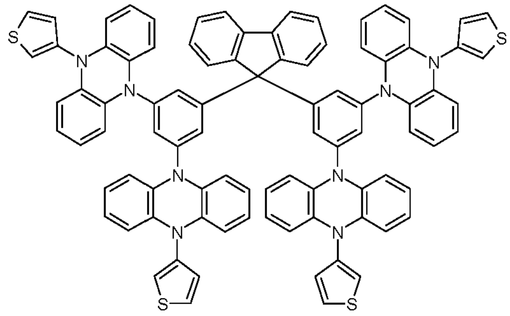 |
| (21) | (22) |
| 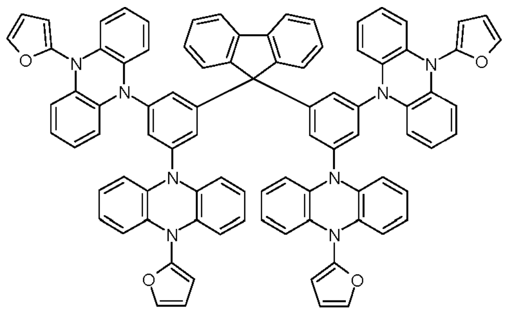 | 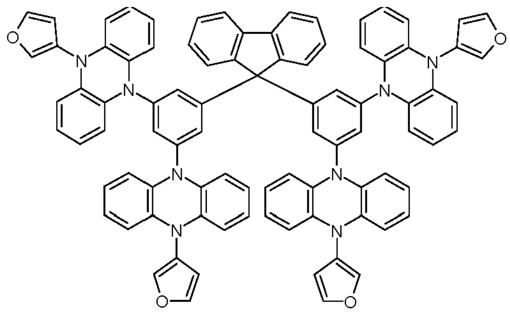 |
| (23) | (24) |
| 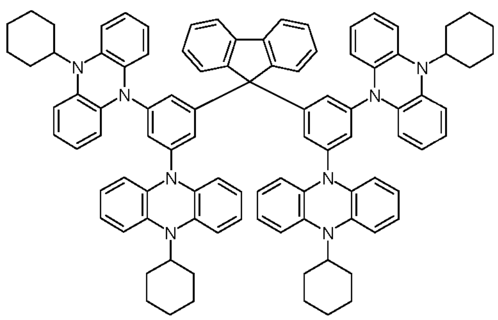 | 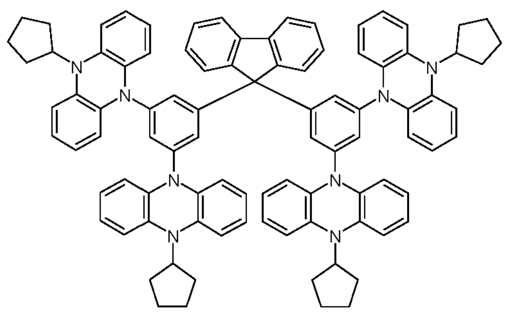 |
| (25) | (26) |

(continued)

| | |
|---|---|
| 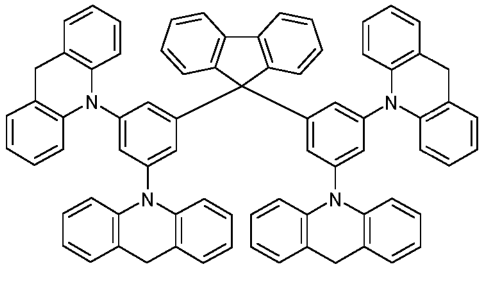 | 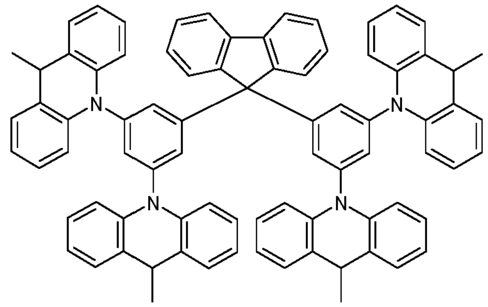 |
| (27) | (28) |
| 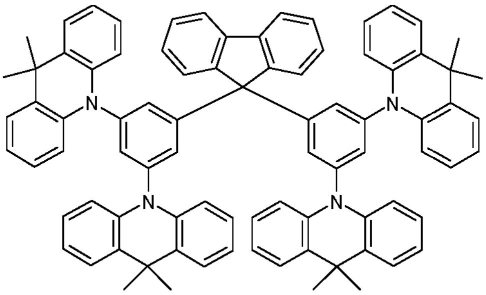 | 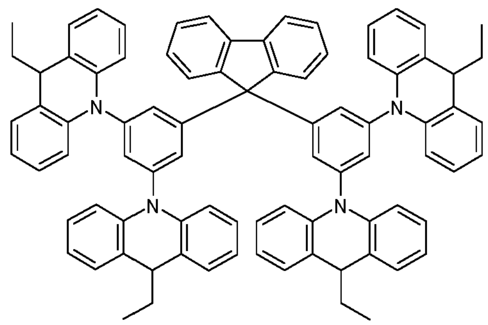 |
| (29) | (30) |
| 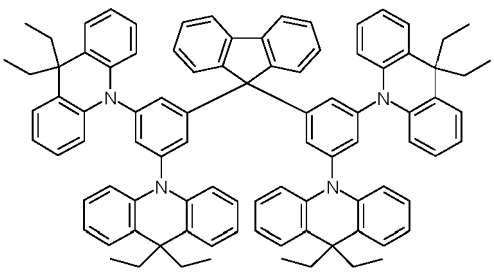 | 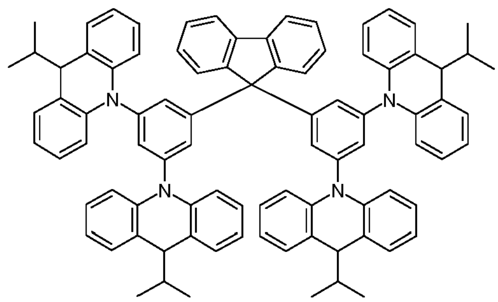 |
| (31) | (32) |
| 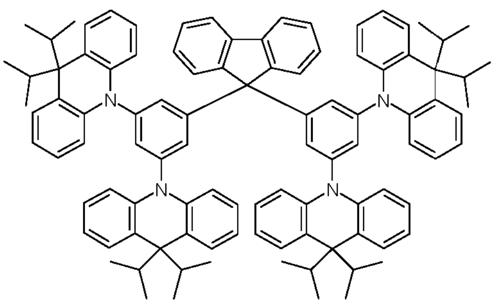 | 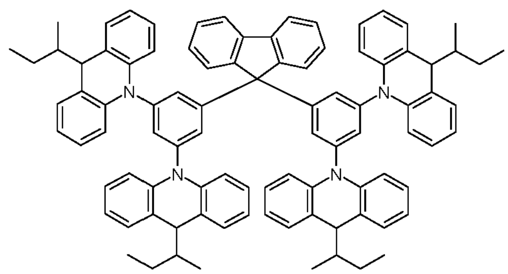 |
| (33) | (34) |

(continued)

| | |
|---|---|
| 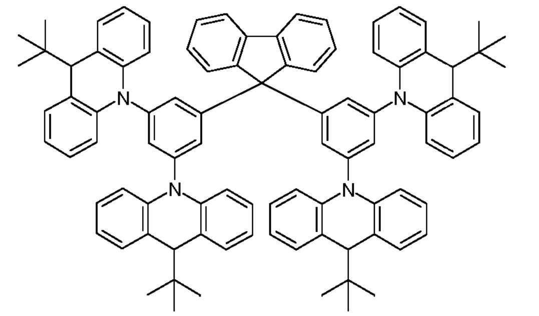 | 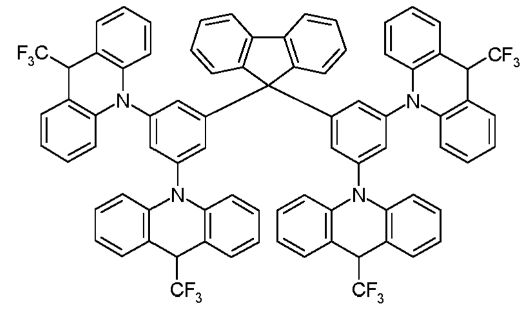 |
| (35) | (36) |
| 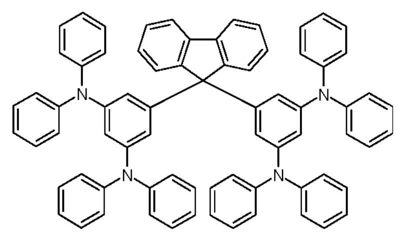 | 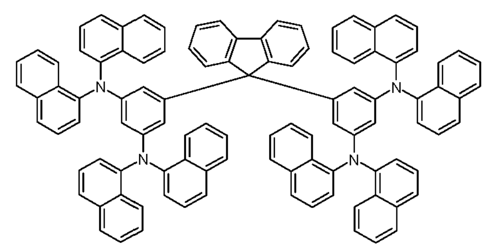 |
| (37) | (38) |
| 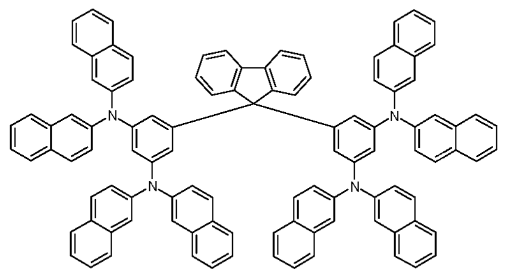 | 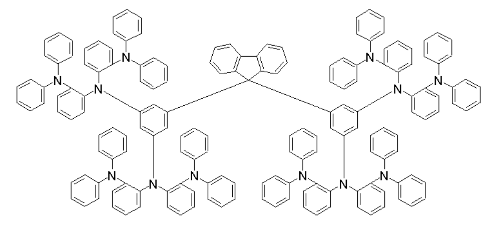 |
| (39) | (40) |
| 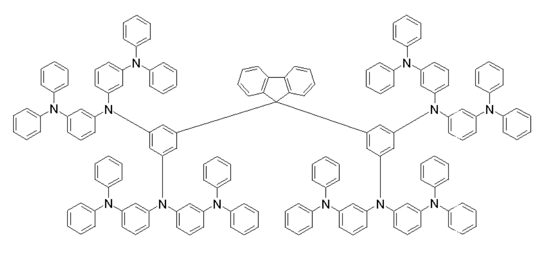 | 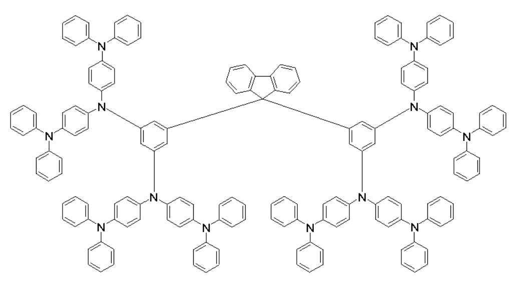 |
| (41) | (42) |
| 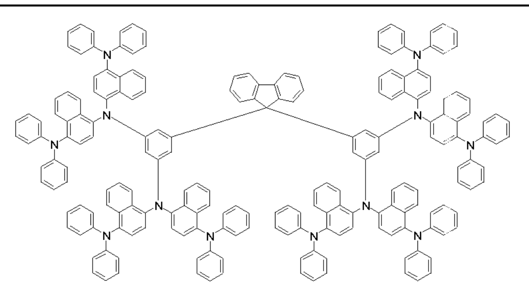 | 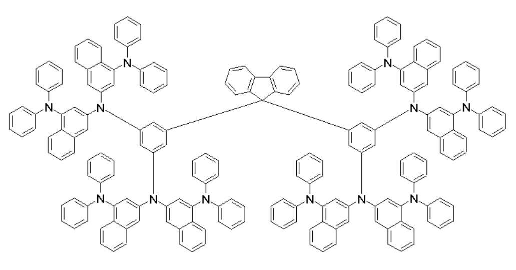 |
| (43) | (44) |

(continued)

| | |
|---|---|
| 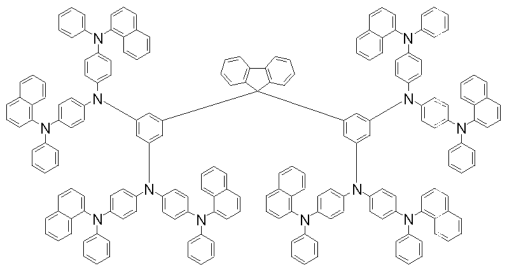 | 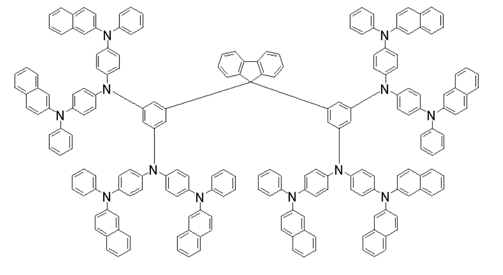 |
| (45) | (46) |
| 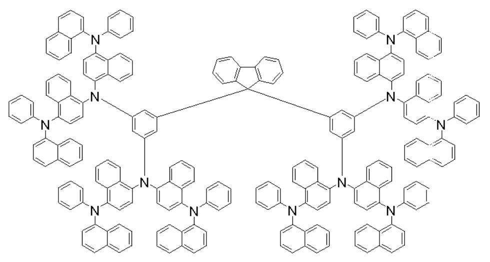 | 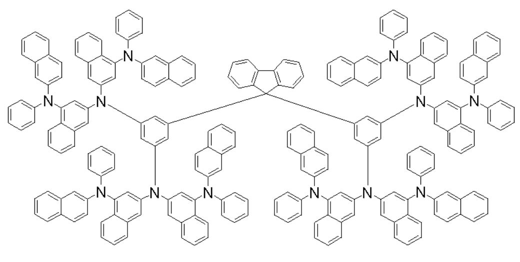 |
| (47) | (48) |
| 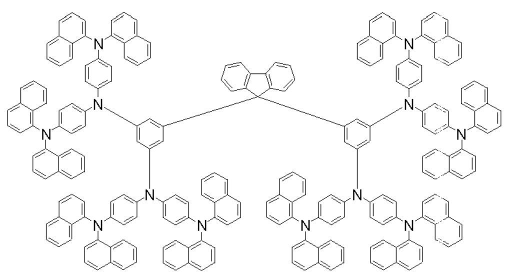 | 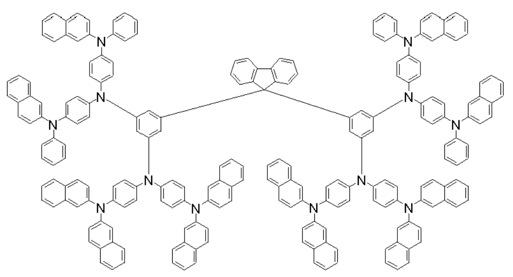 |
| (49) | (50) |
| 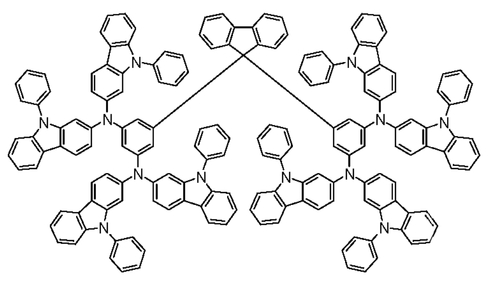 | 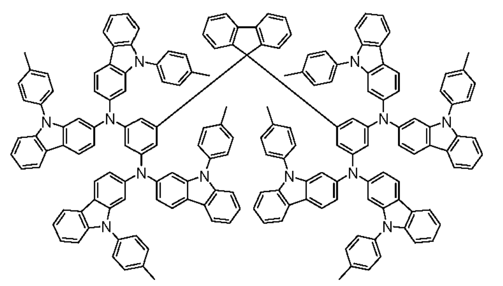 |
| (51) | (52) |
| 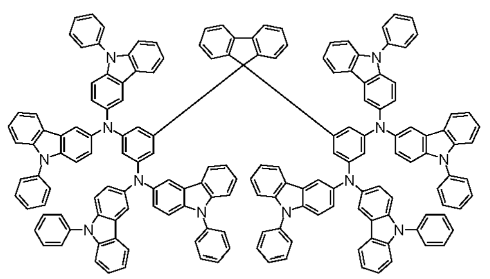 | 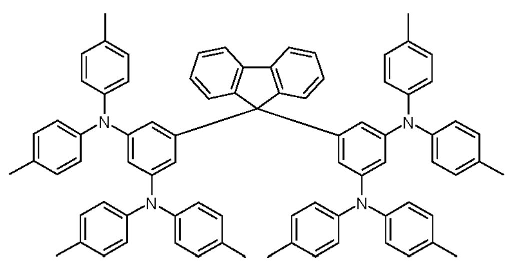 |
| (53) | (54) |

(continued)

| | |
|---|---|
| 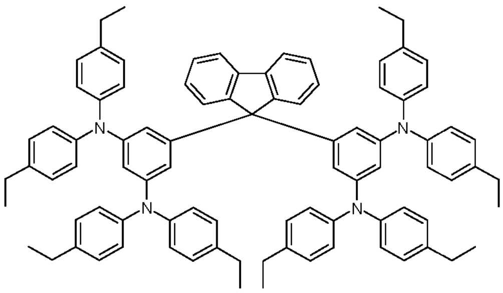 | 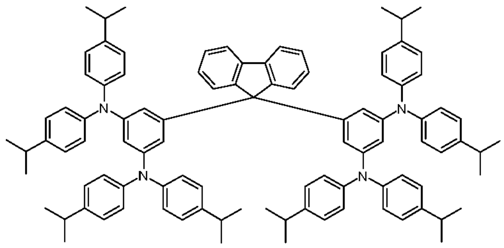 |
| (55) | (56) |
| 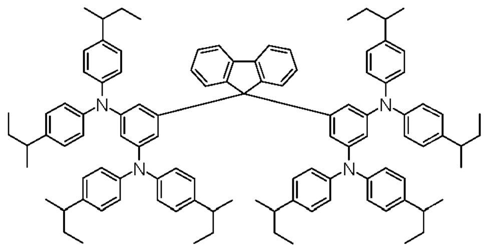 | 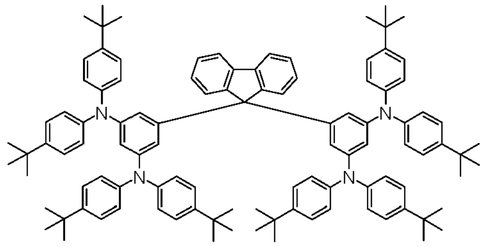 |
| (57) | (58) |
| 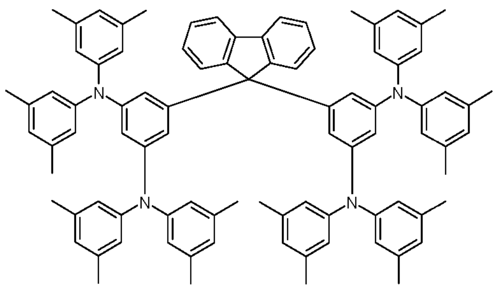 | 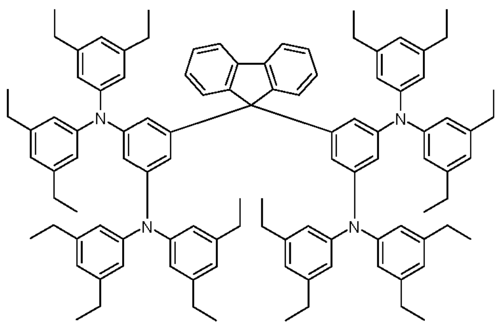 |
| (59) | (60) |
| 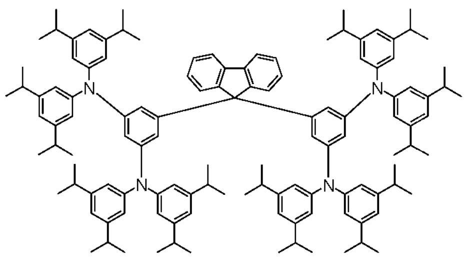 | 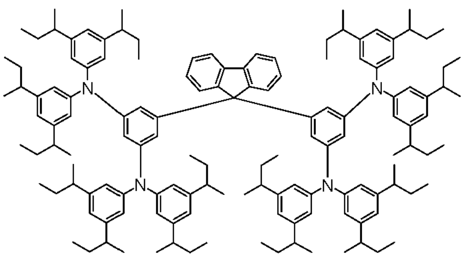 |
| (61) | (62) |
| 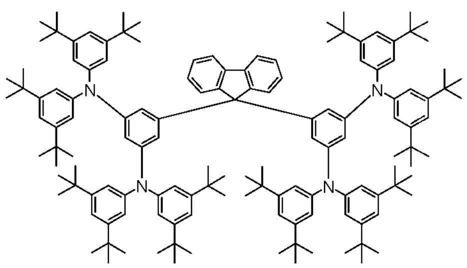 | 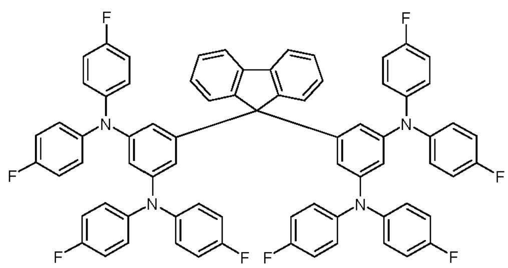 |
| (63) | (64) |

(continued)

| | |
|---|---|
| 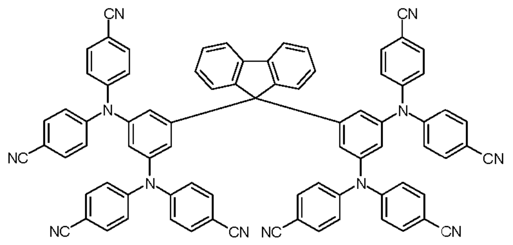 | 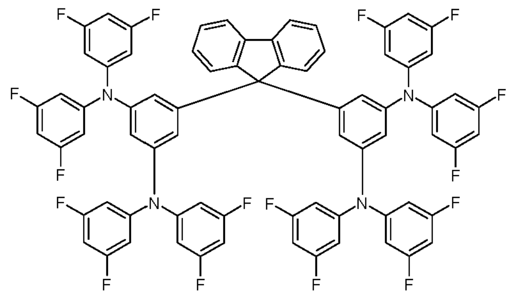 |
| (65) | (66) |
| 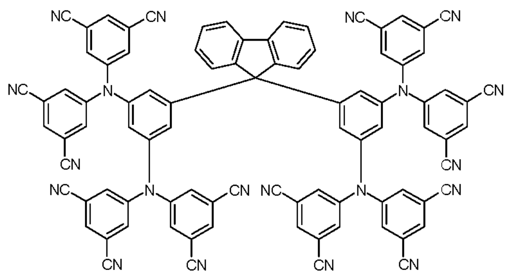 | 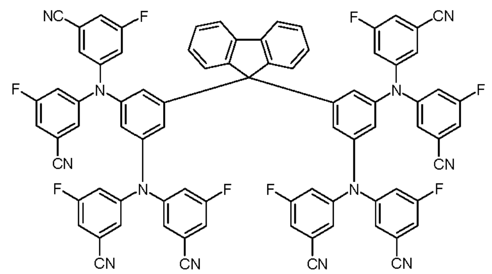 |
| (67) | (68) |
| 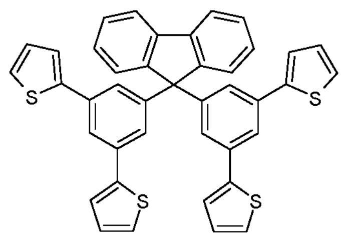 | 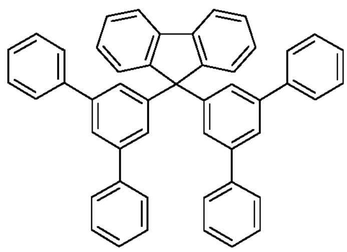 |
| (69) | (70) |
| 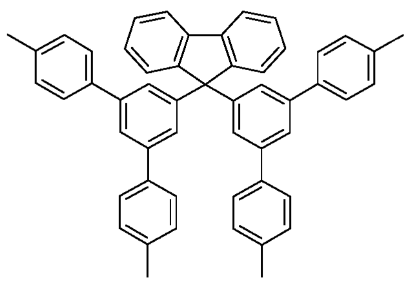 | 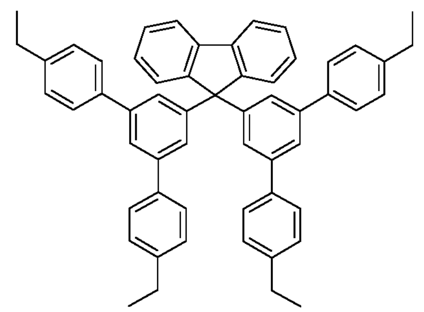 |
| (71) | (72) |
| 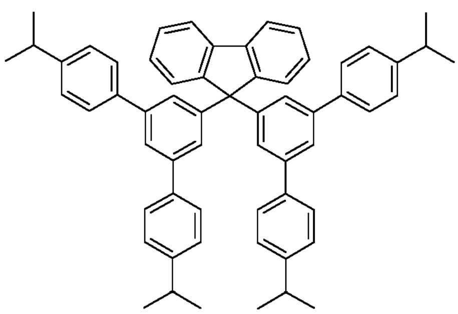 | 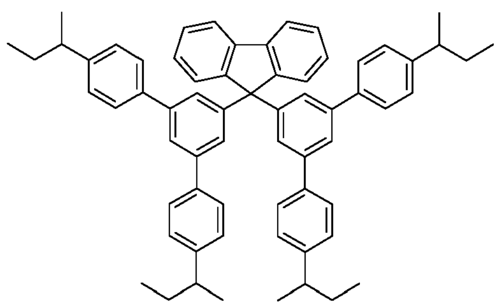 |
| (73) | (74) |

(continued)

| | |
|---|---|
| 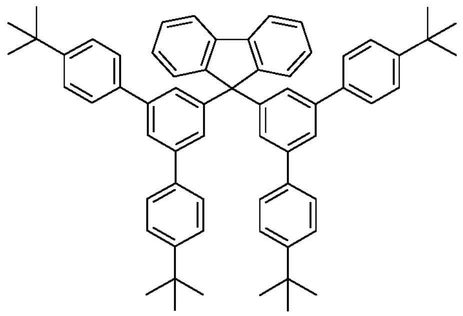 | 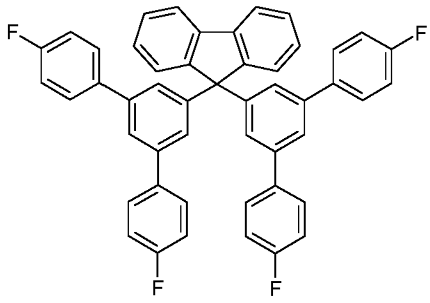 |
| (75) | (76) |
| 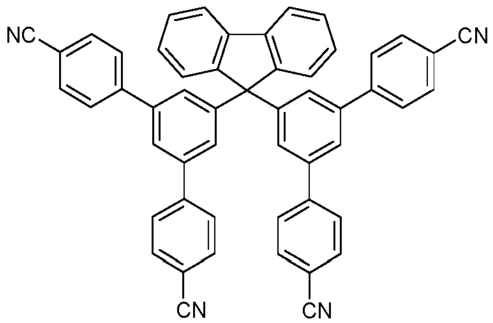 | 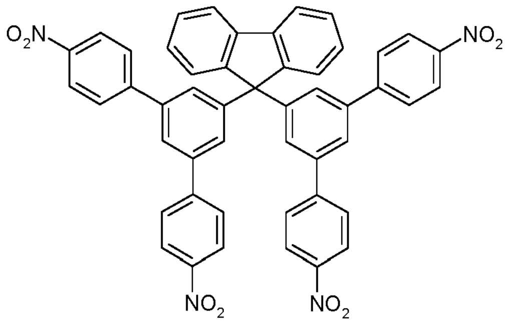 |
| (77) | (78) |
| 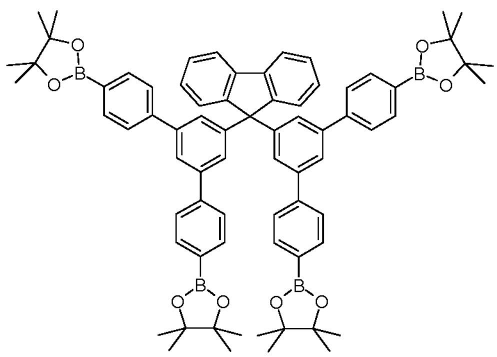 | 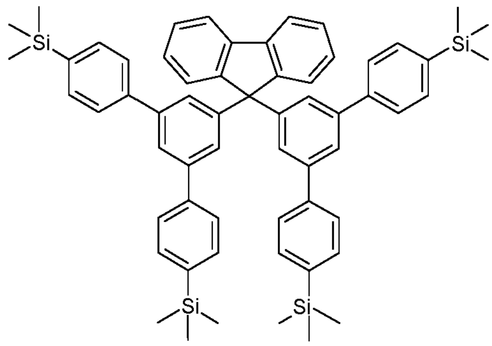 |
| (79) | (80) |
| 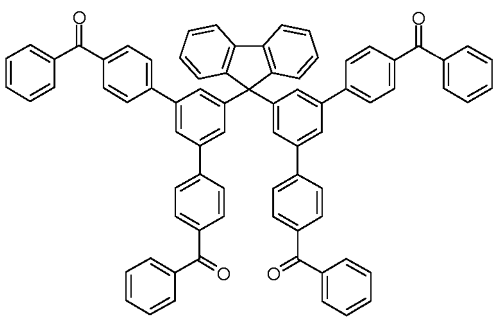 | 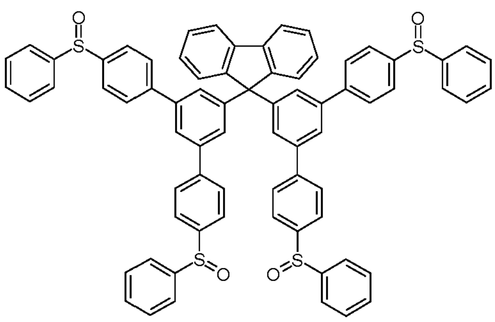 |
| (81) | (82) |

(continued)

| | |
|---|---|
| 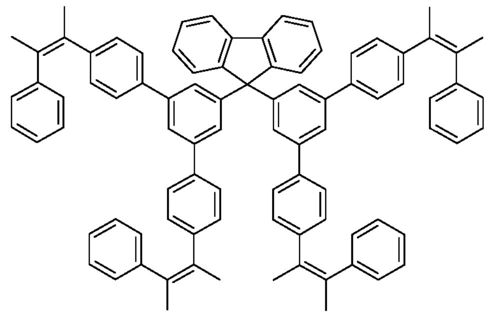 | 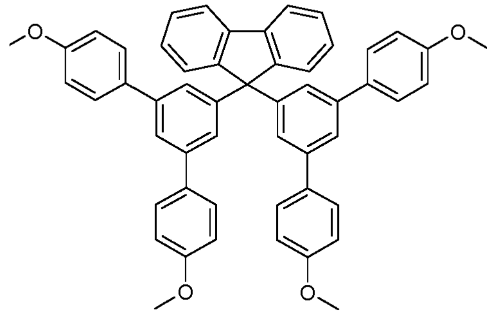 |
| (83) | (84) |
| 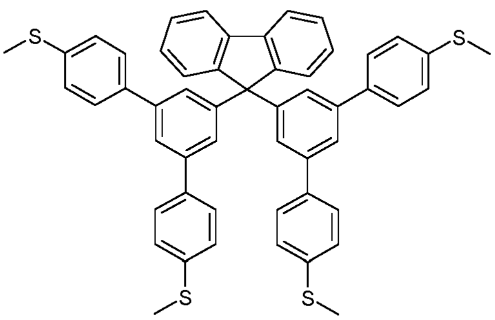 | 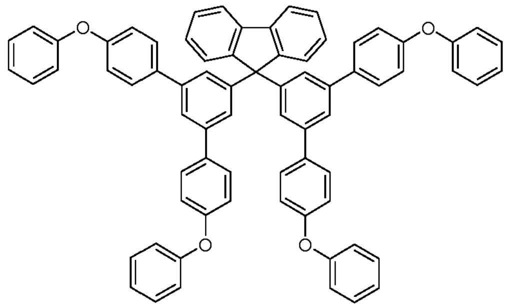 |
| (85) | (86) |
| 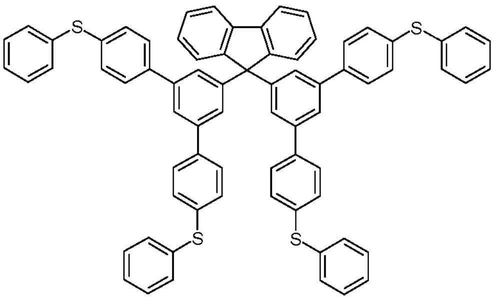 | 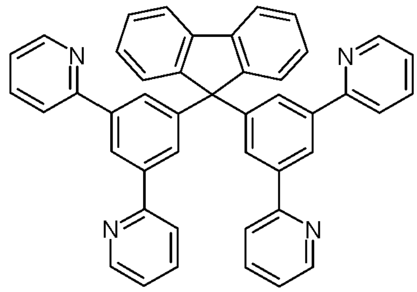 |
| (87) | (88) |
| 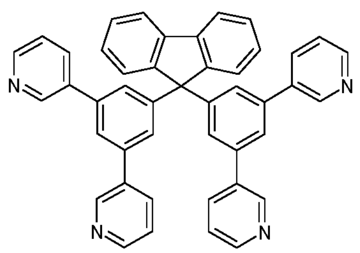 | 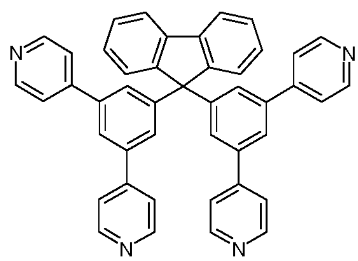 |
| (89) | (90) |
| 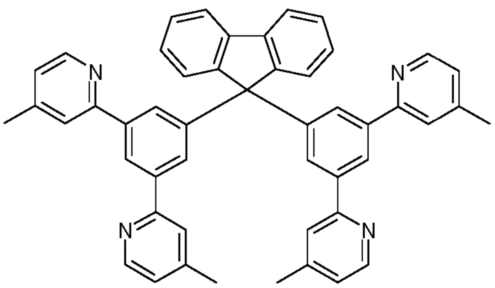 | 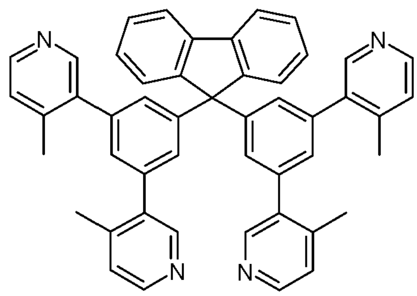 |

(continued)

| (91) | (92) |
|---|---|
| 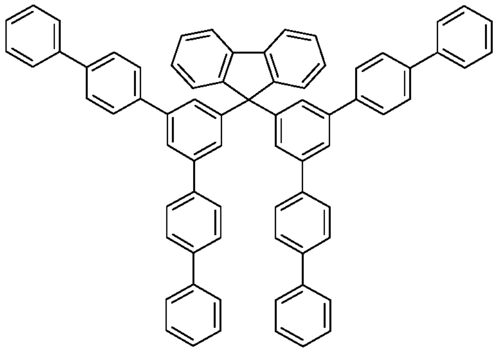 | 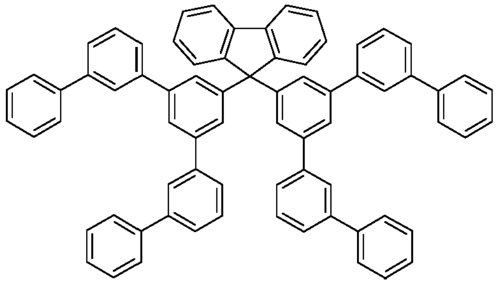 |
| (93) | (94) |
| 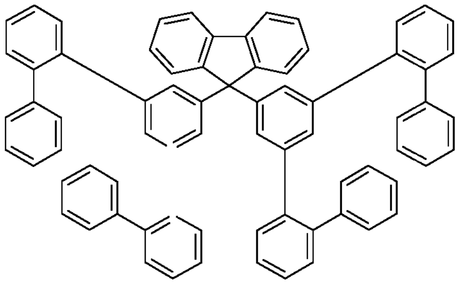 | 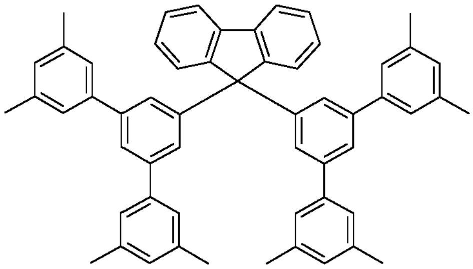 |
| (95) | (96) |
| 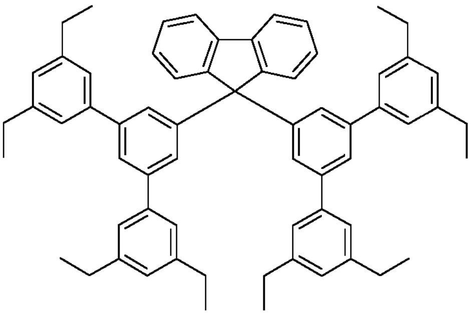 | 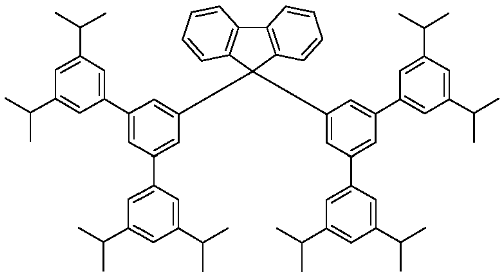 |
| (97) | (98) |
| 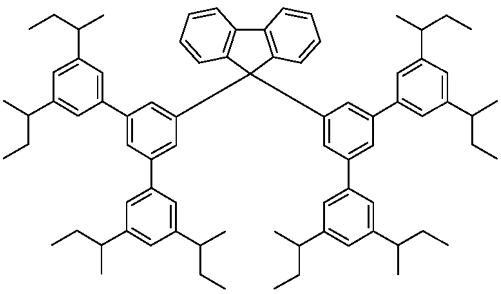 | 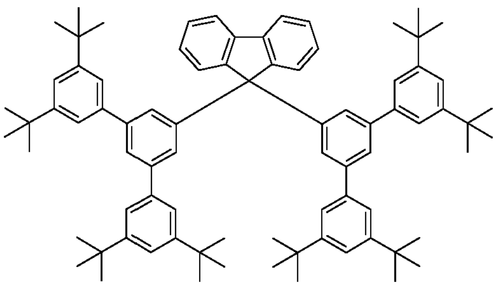 |
| (99) | (100) |

(continued)

| | |
|---|---|
| 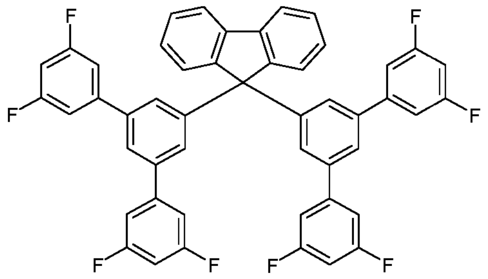 | 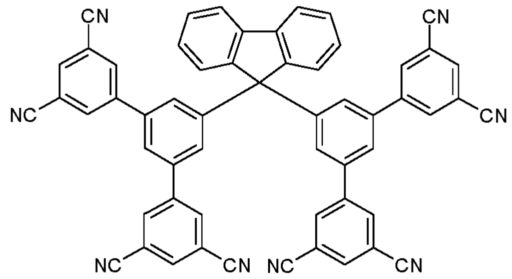 |
| (101) | (102) |
| 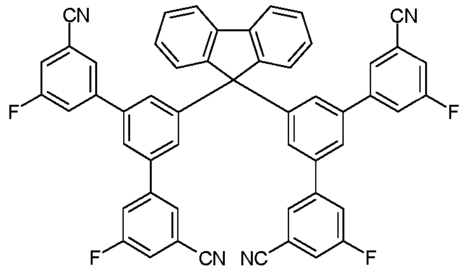 | 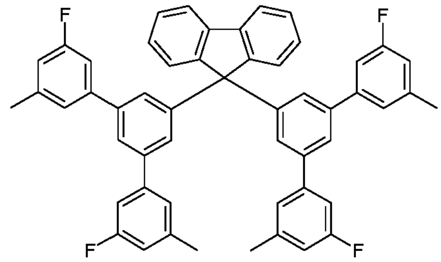 |
| (103) | (104) |
| 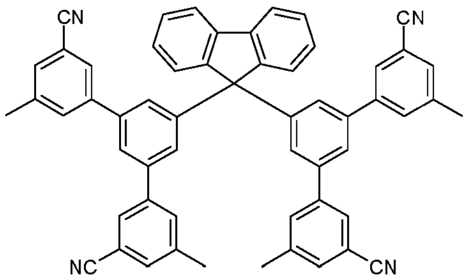 | 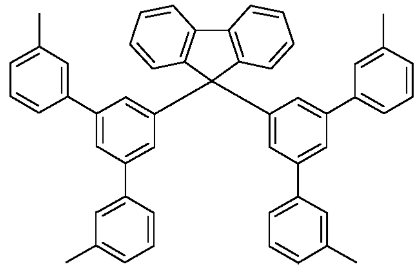 |
| (105) | (106) |
| 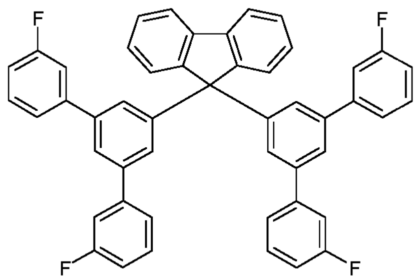 | 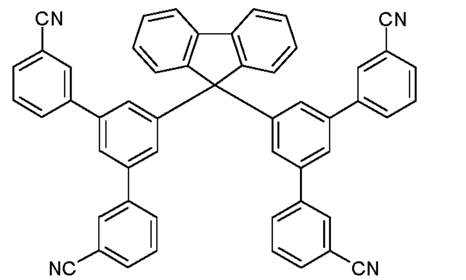 |
| (107) | (108) |
| 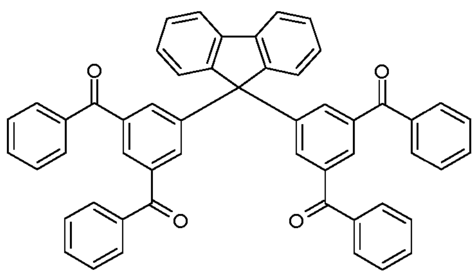 | 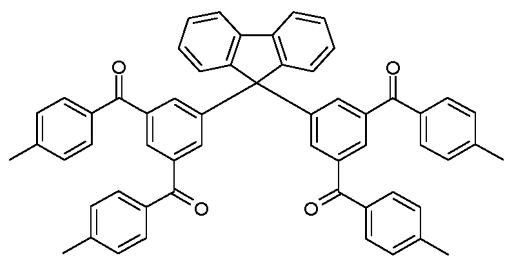 |
| (109) | (110) |

(continued)

| | |
|---|---|
| 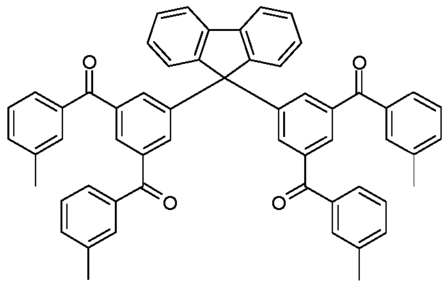 | 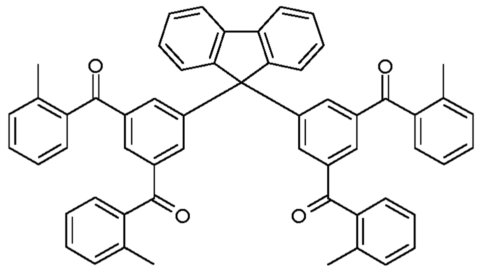 |
| (111) | (112) |
| 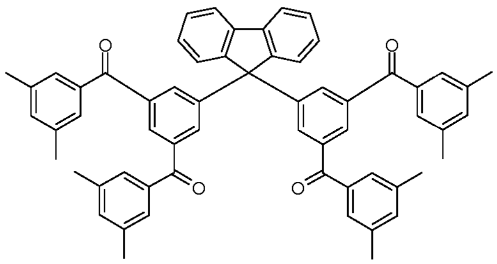 | 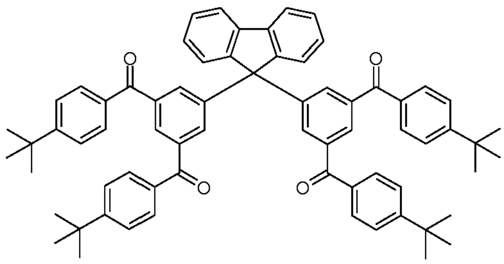 |
| (113) | (114) |
| 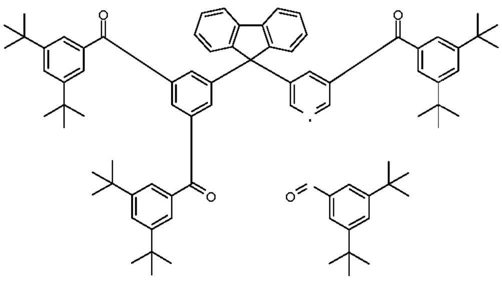 | 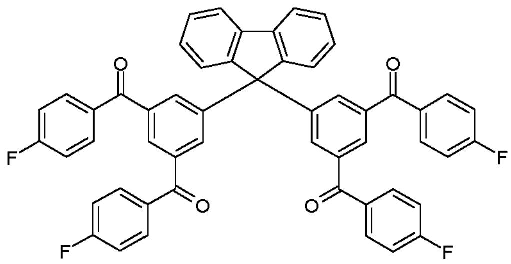 |
| (115) | (116) |
| 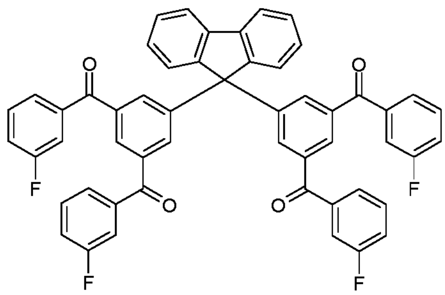 | 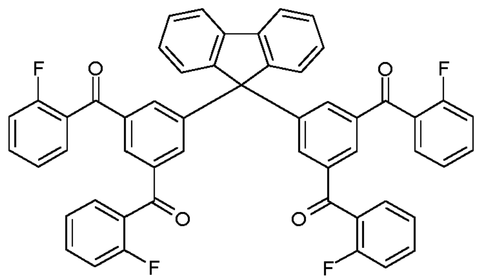 |
| (117) | (118) |
| 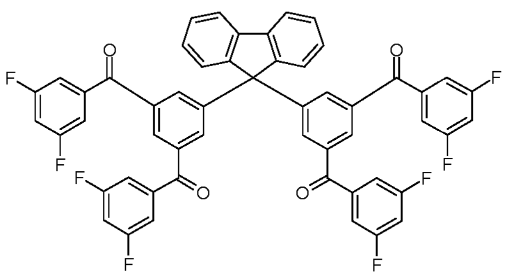 | 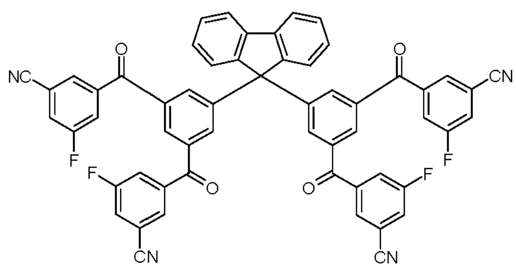 |
| (119) | (120) |

(continued)

| | |
|---|---|
| 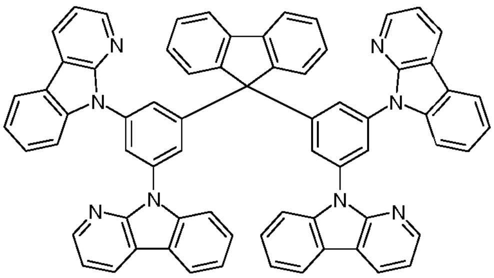 | 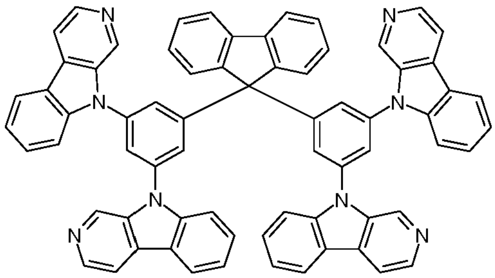 |
| (121) | (122) |
| 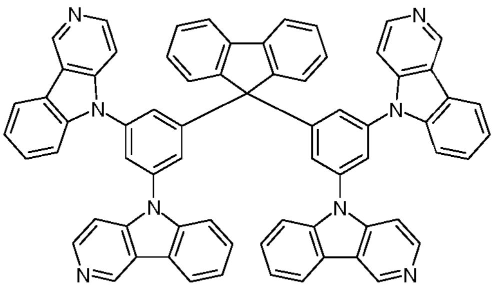 | 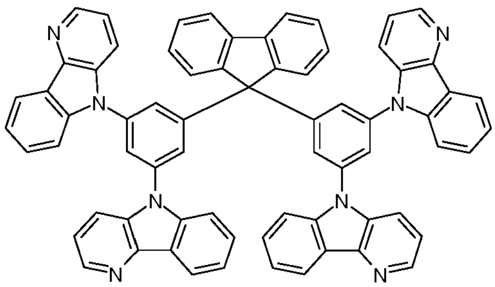 |
| (123) | (124) |
| 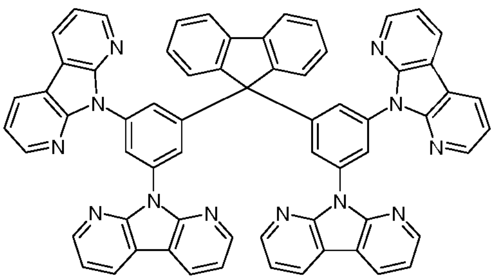 | 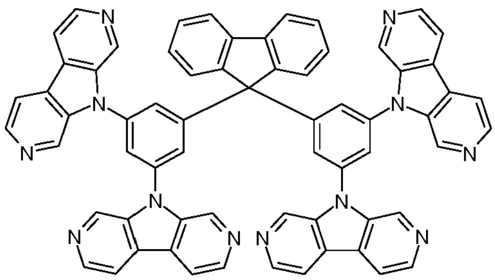 |
| (125) | (126) |
| 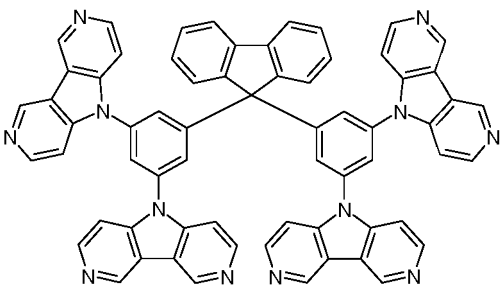 | 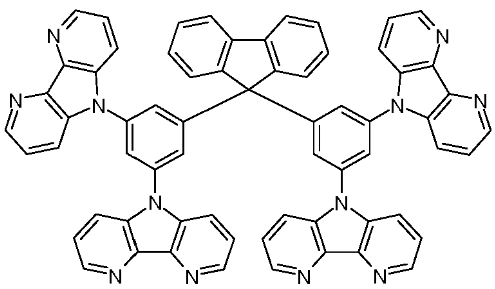 |
| (127) | (128) |
| 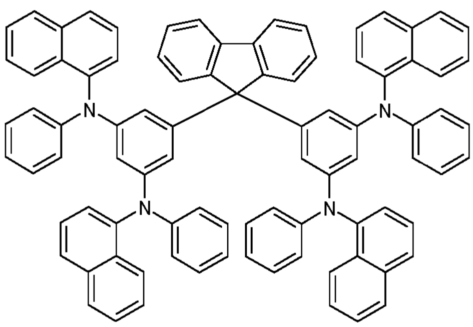 | 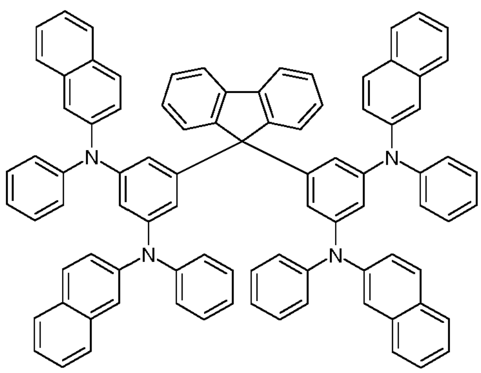 |

(continued)

| | |
|---|---|
| (129) | (130) |
| 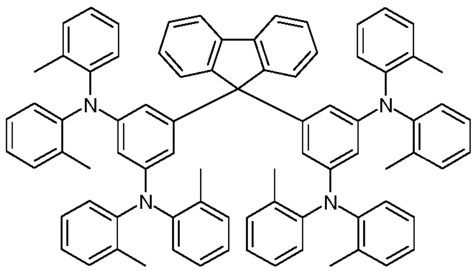 | 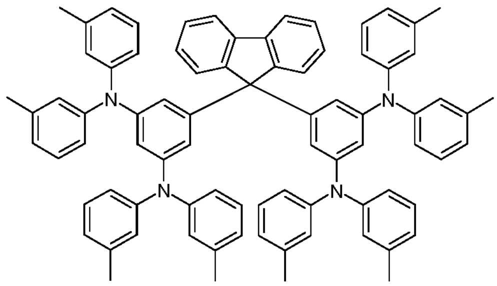 |
| (131) | (132) |
| 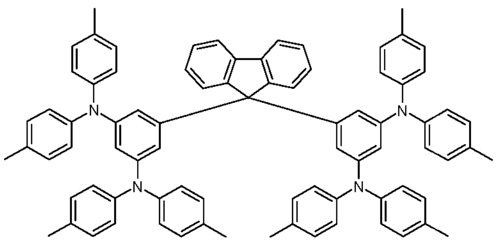 | 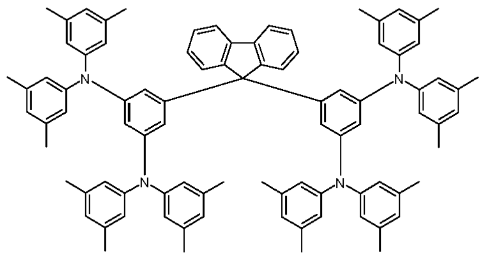 |
| (133) | (134) |
| 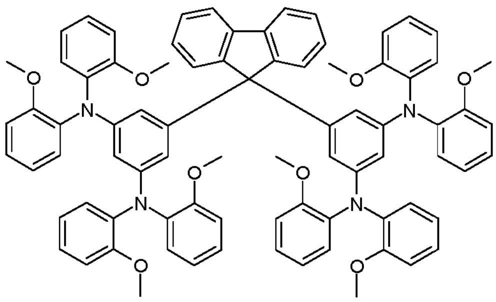 | 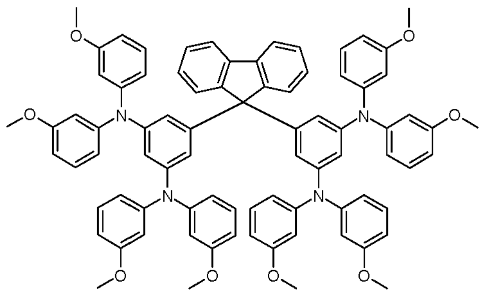 |
| (135) | (136) |
| 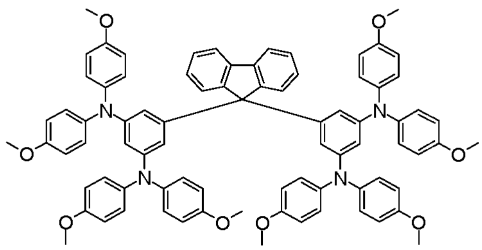 | 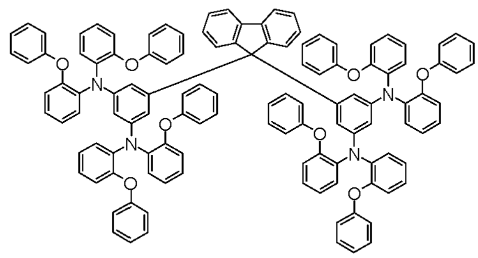 |
| (137) | (138) |
| 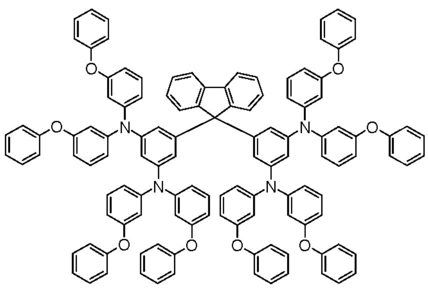 | 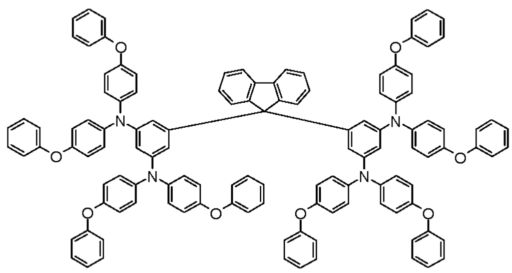 |
| (139) | (140) |

(continued)

| | |
|---|---|
| 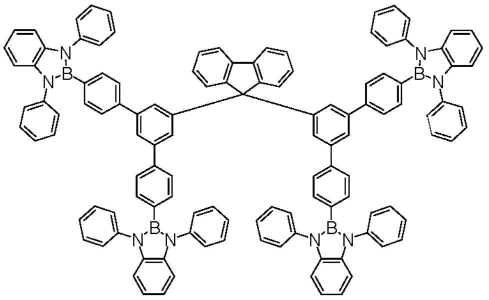 | 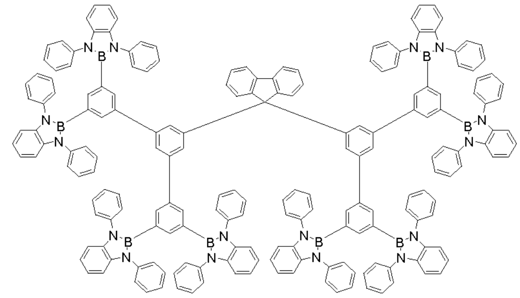 |
| (141) | (142) |
| 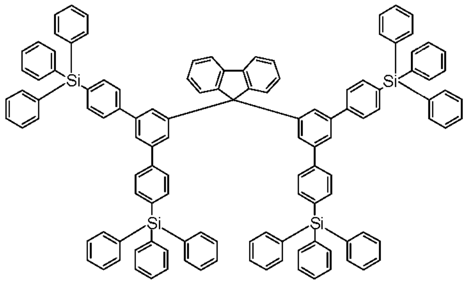 | 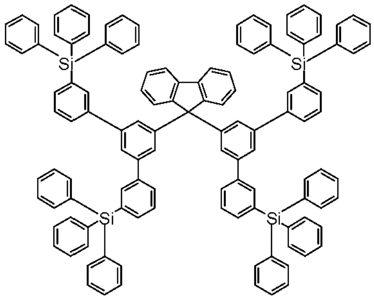 |
| (143) | (144) |
| 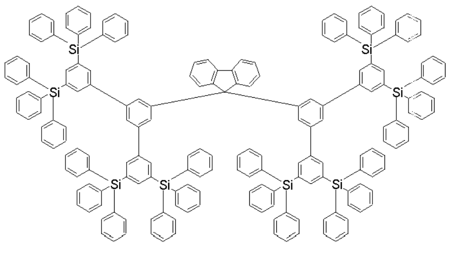 | 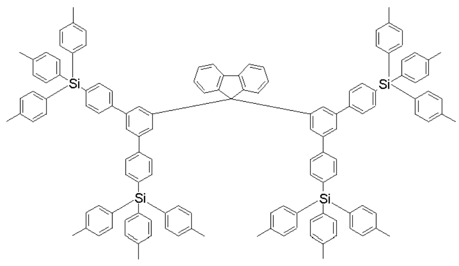 |
| (145) | (146) |
| 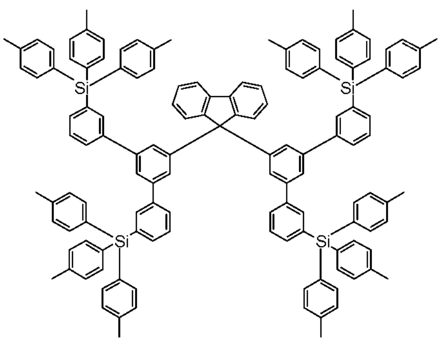 | 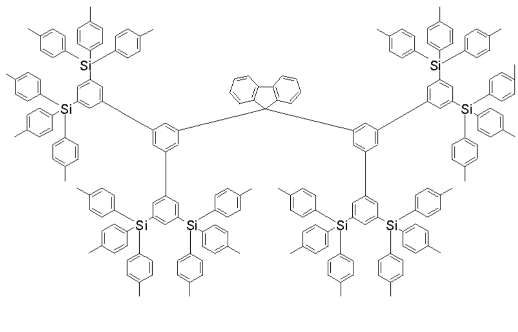 |
| (147) | (148) |

(continued)

| | |
|---|---|
| 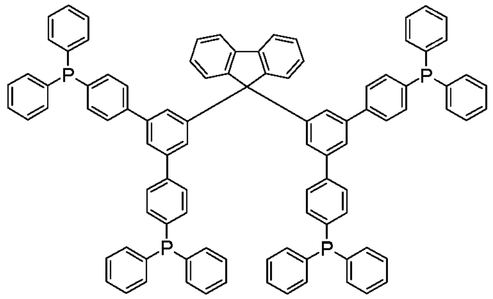 | 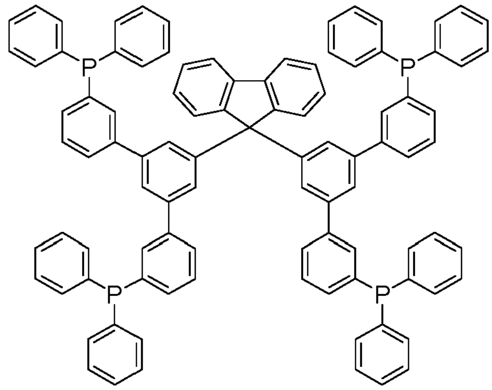 |
| (149) | (150) |
| 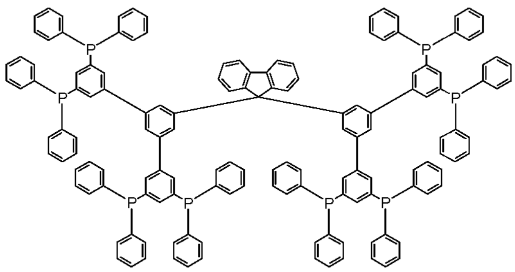 | 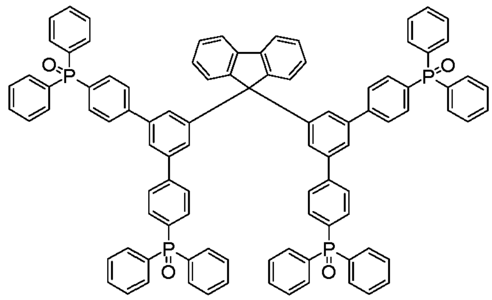 |
| (151) | (152) |
| 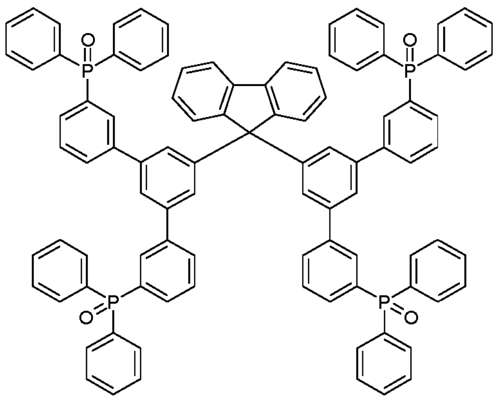 | 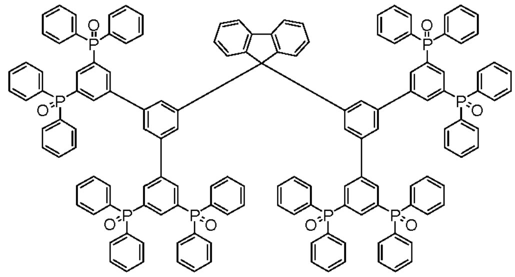 |
| (153) | (154) |
| 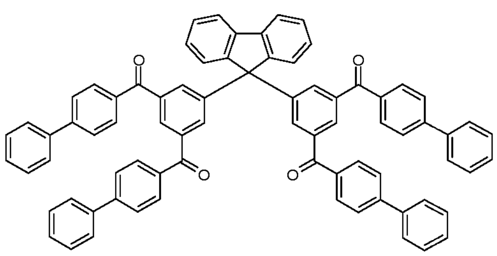 | 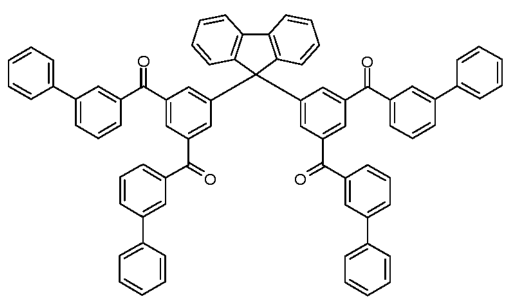 |
| (155) | (156) |

(continued)

| | |
|---|---|
| 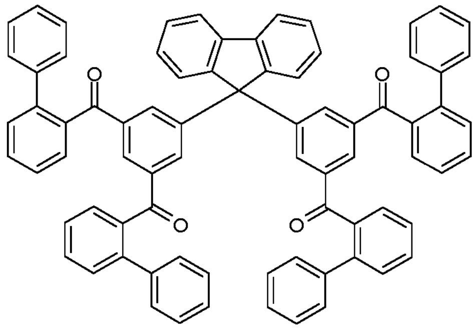 | 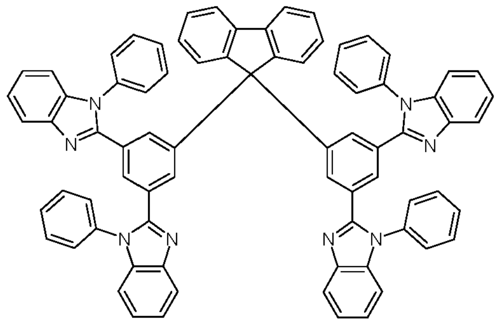 |
| (157) | (158) |
| 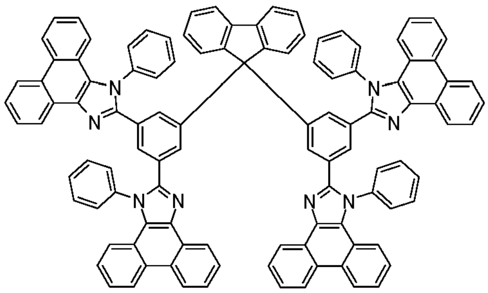 | 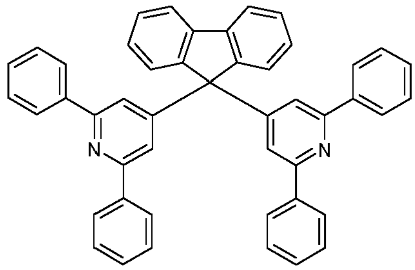 |
| (159) | (160) |
| 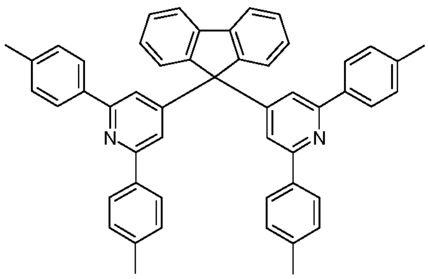 | 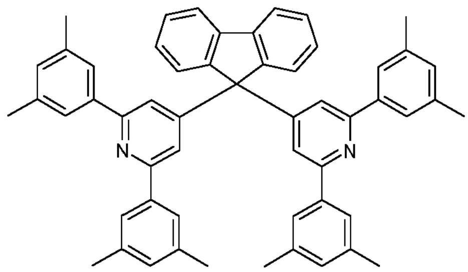 |
| (161) | (162) |
| 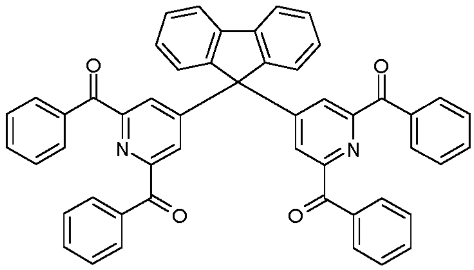 | 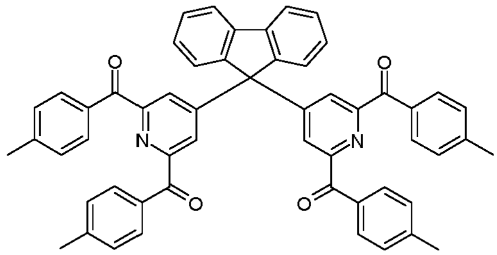 |
| (163) | (164) |
| 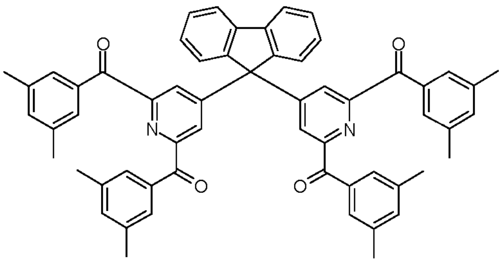 | 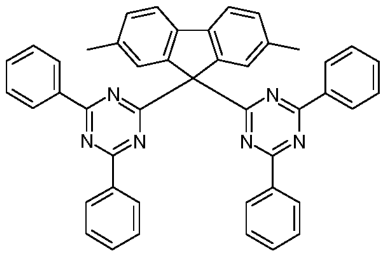 |
| (165) | (166) |

(continued)

| | |
|---|---|
| 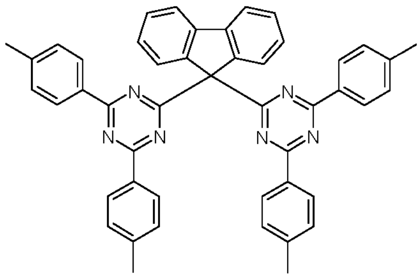 | 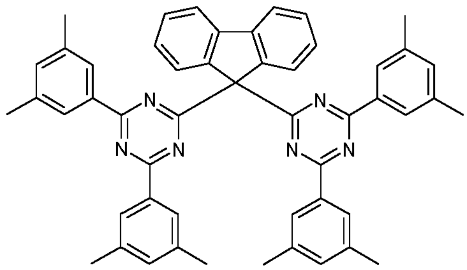 |
| (167) | (168) |
| 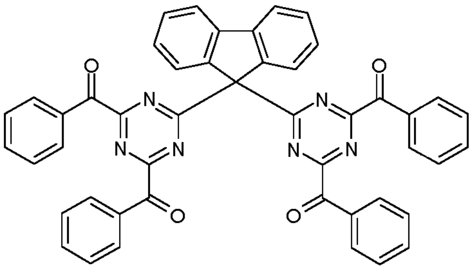 | 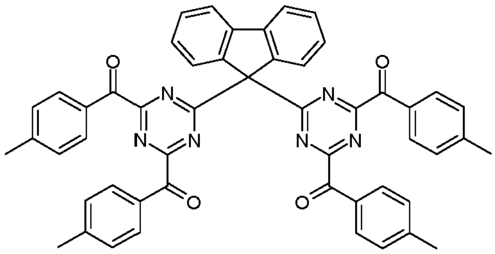 |
| (169) | (170) |
| 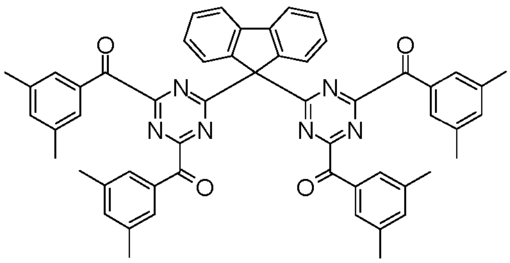 | 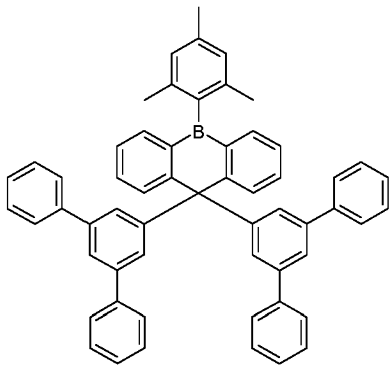 |
| (171) | (172) |
| 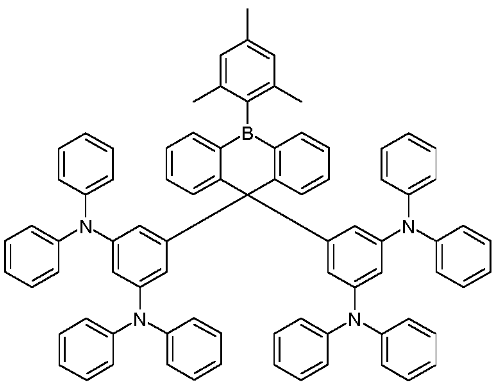 | 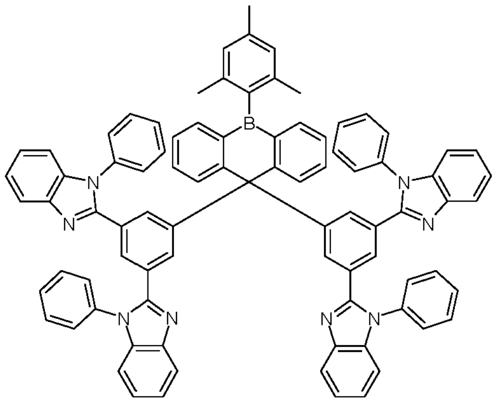 |
| (173) | (174) |

(continued)

| | |
|---|---|
| 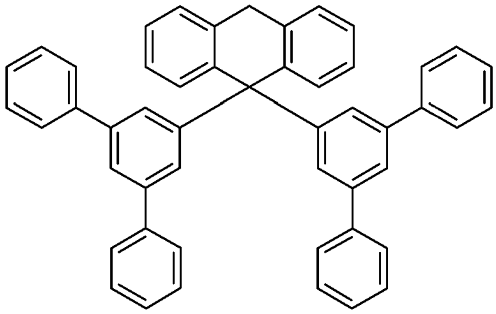 | 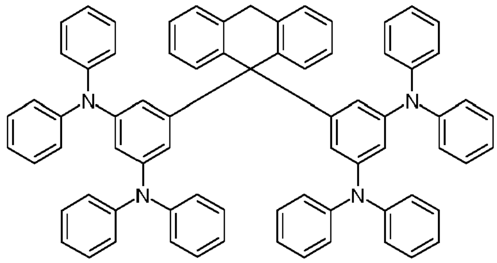 |
| (175) | (176) |
| 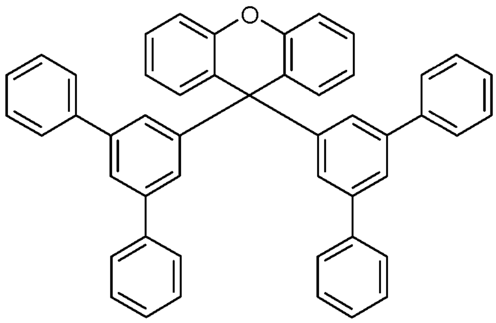 | 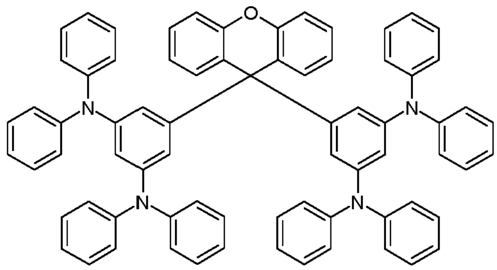 |
| (177) | (178) |
| 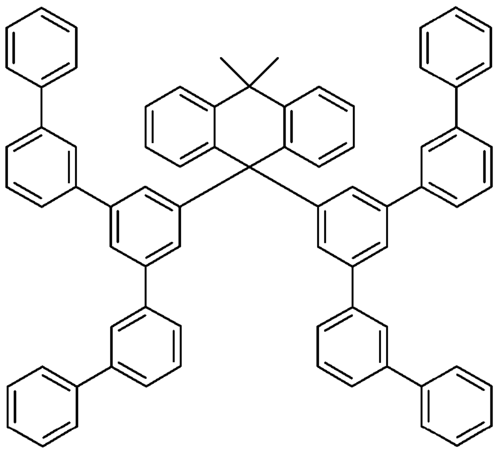 | 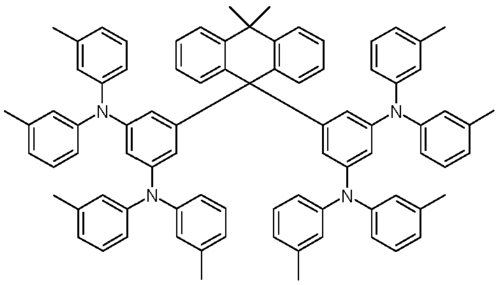 |
| (179) | (180) |
| 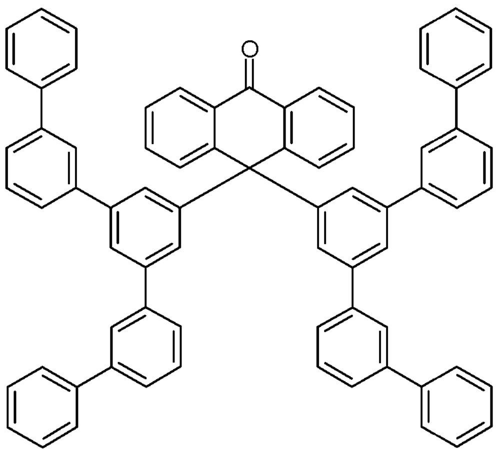 | 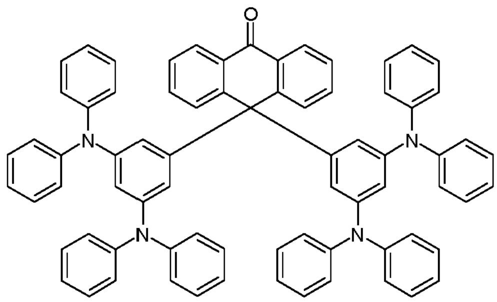 |

(continued)

| | |
|---|---|
| (181) | (182) |
| 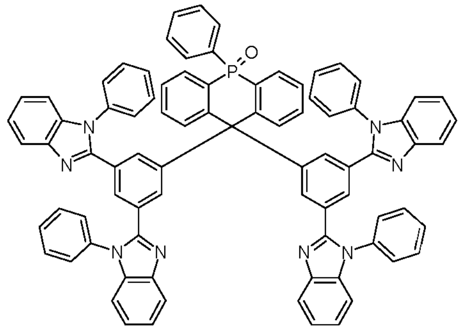 | 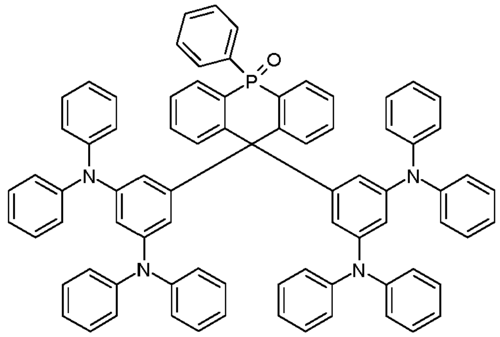 |
| (183) | (184) |
| 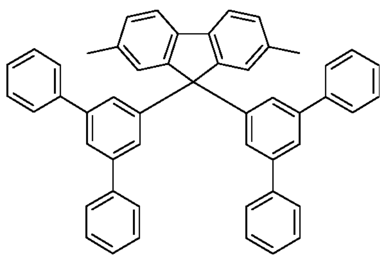 | 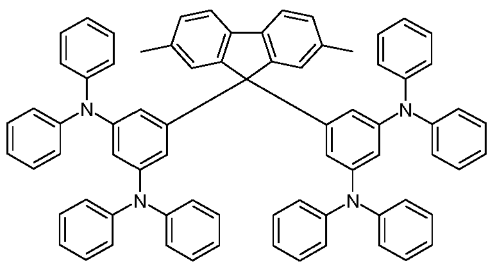 |
| (185) | (186) |
| 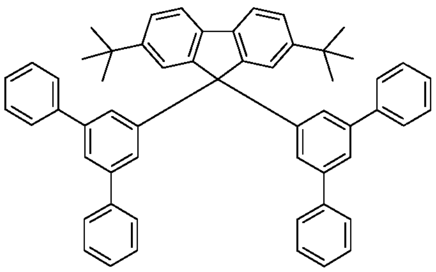 | 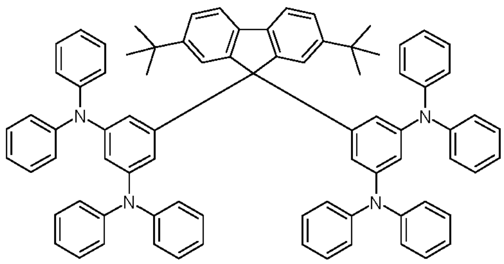 |
| (187) | (188) |
| 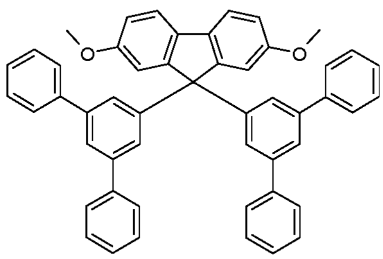 | 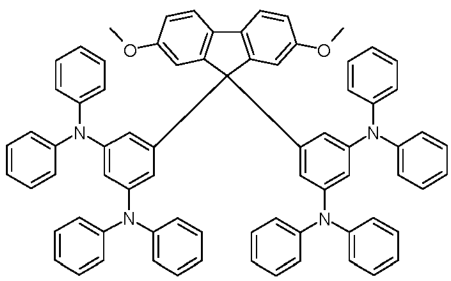 |
| (189) | (190) |

(continued)

| | |
|---|---|
| 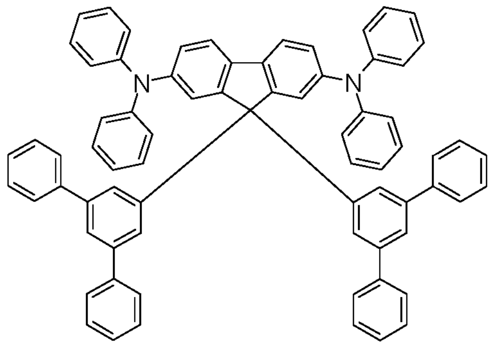 | 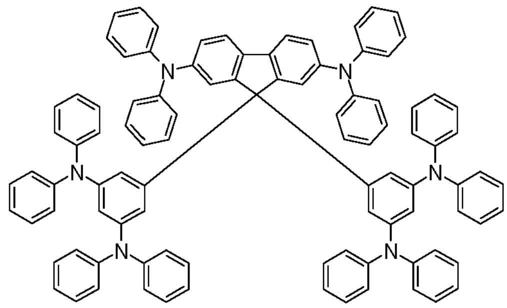 |
| (191) | (192) |
| 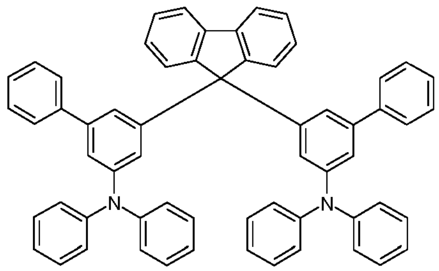 | 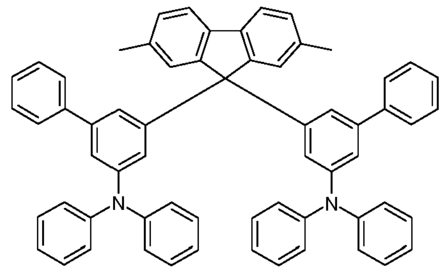 |
| (193) | (194) |
| 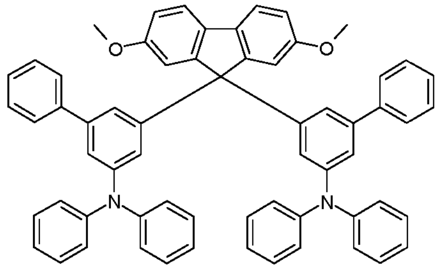 | 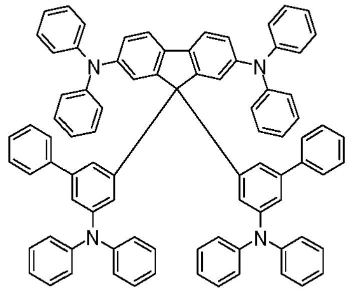 |
| (195) | (196) |
| 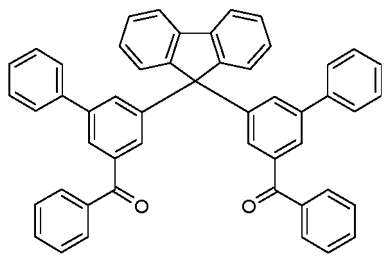 | 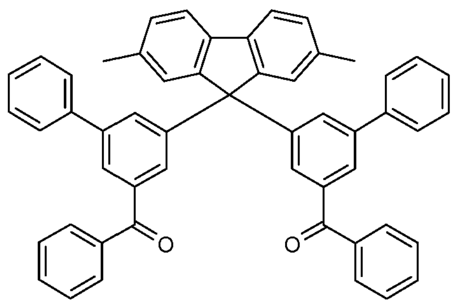 |
| (197) | (198) |
| 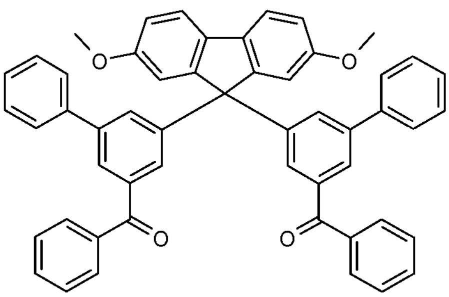 | 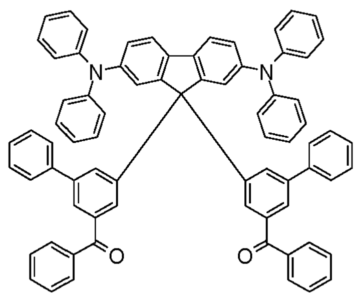 |

(continued)

| | |
|---|---|
| (199) | (200) |
| 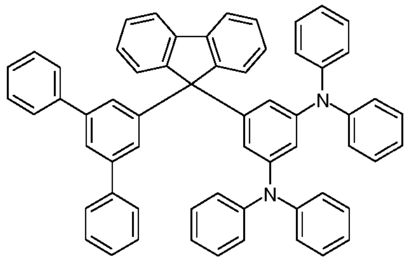 | 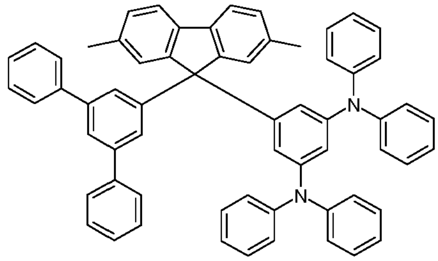 |
| (201) | (202) |
| 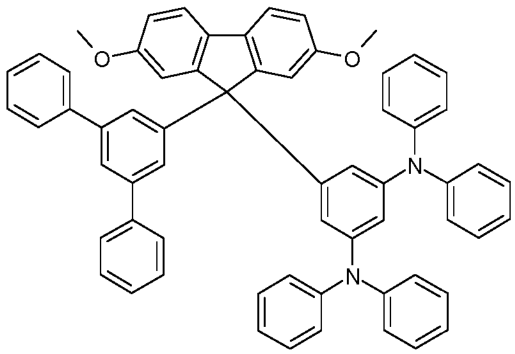 | 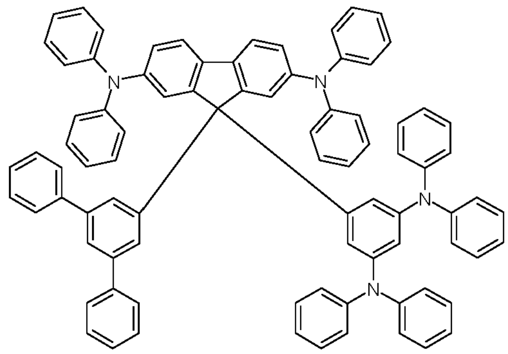 |
| (203) | (204) |
| 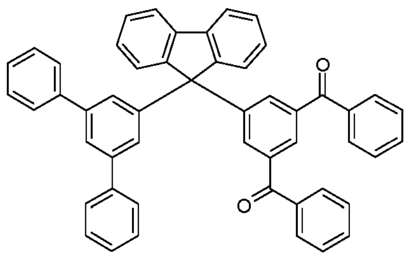 | 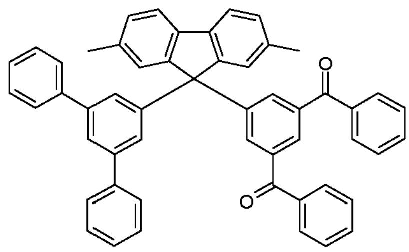 |
| (205) | (206) |
| 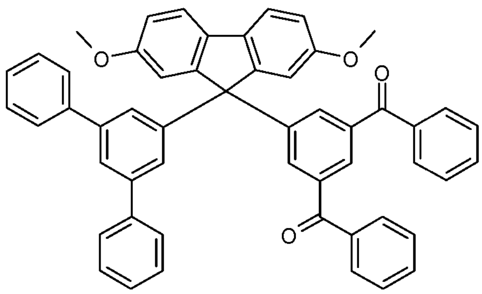 | 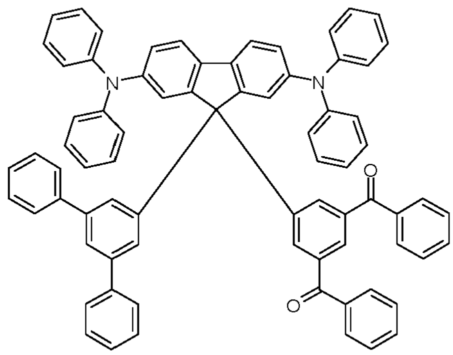 |
| (207) | (208) |

(continued)

| | |
|---|---|
| 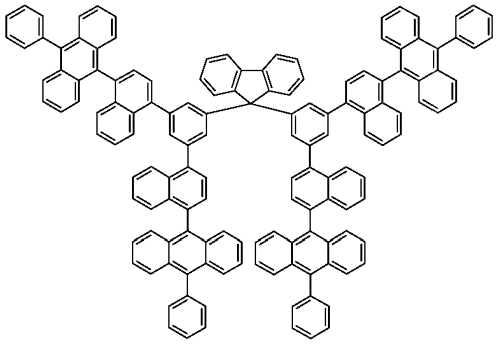 | 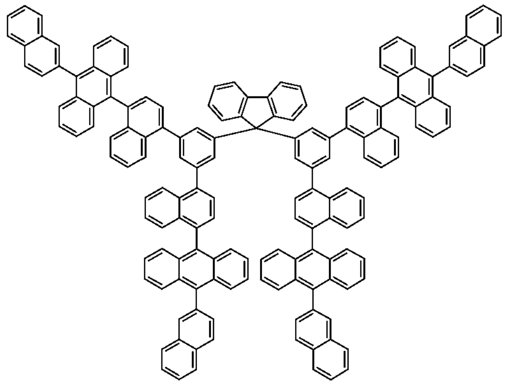 |
| (209) | (210) |
| 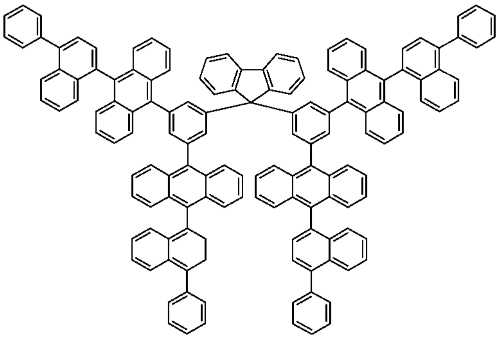 | 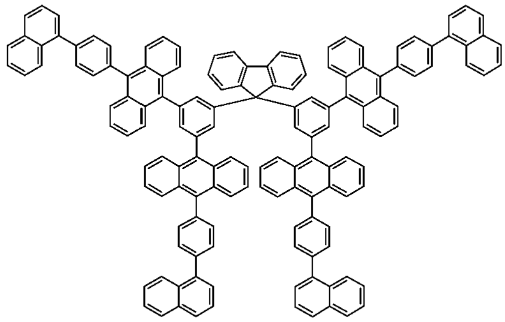 |
| (211) | (212) |
| 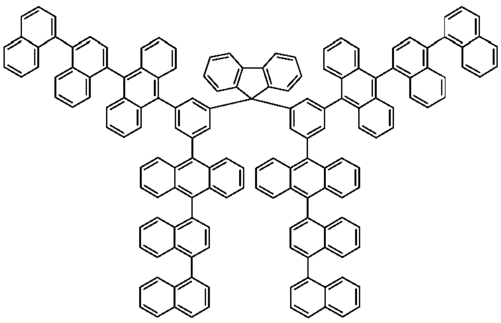 | 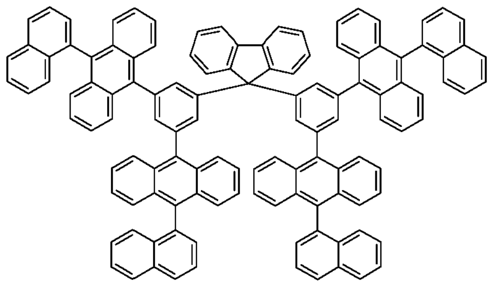 |
| (213) | (214) |
| 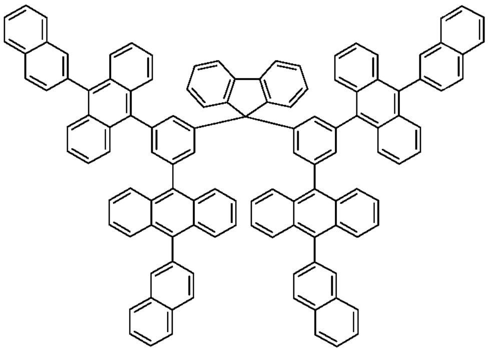 | 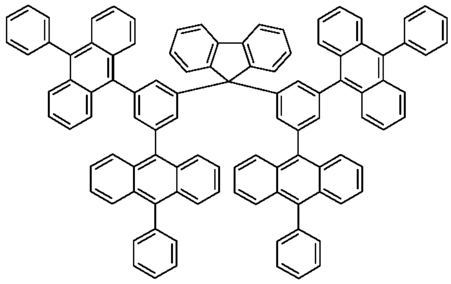 |
| (215) | (216) |

(continued)

| | |
|---|---|
| 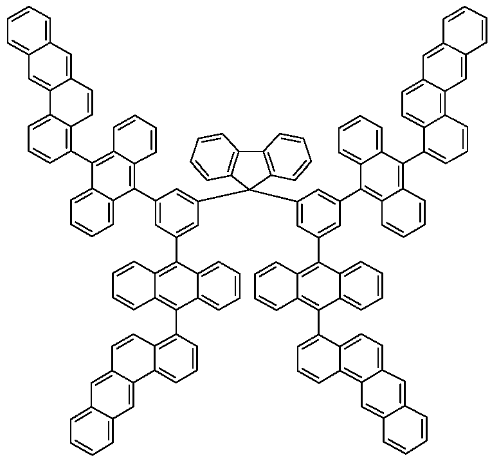 | 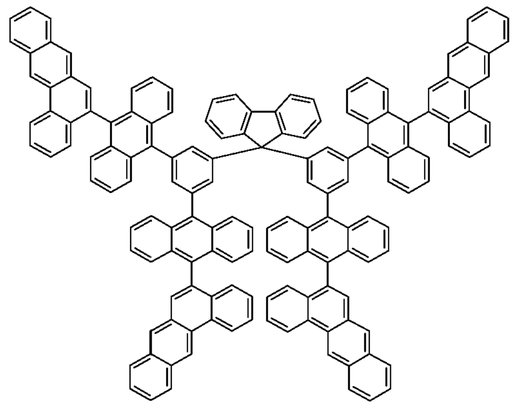 |
| (217) | (218) |
| 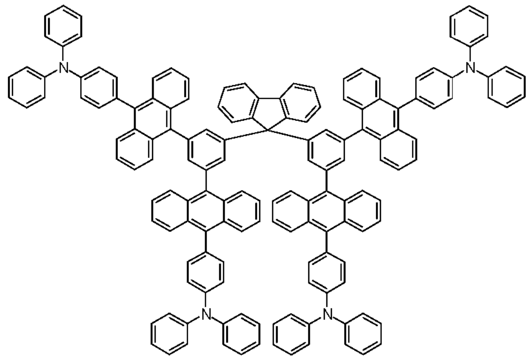 | 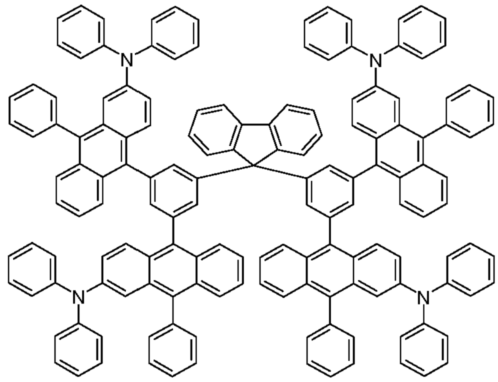 |
| (219) | (220) |
| 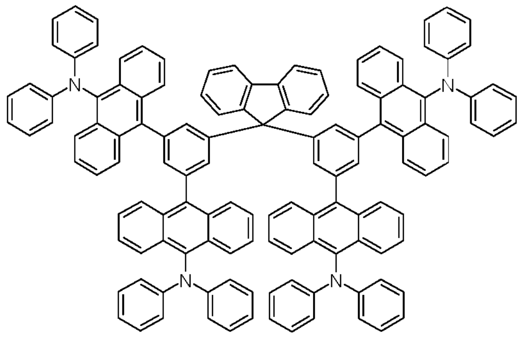 | 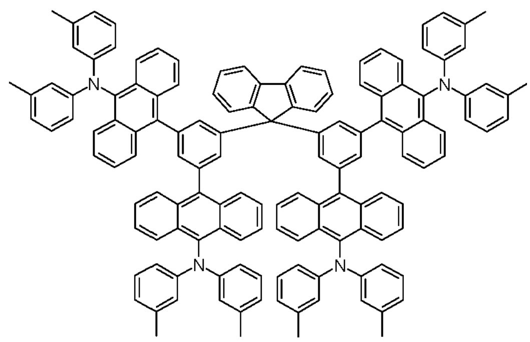 |
| (221) | (222) |
| 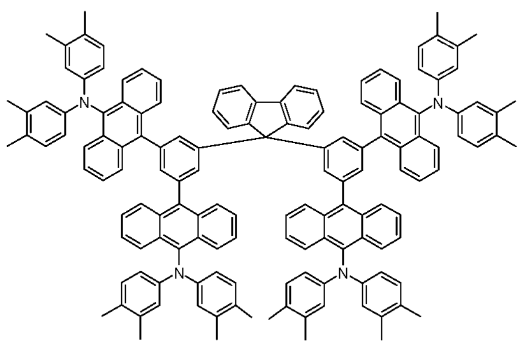 | 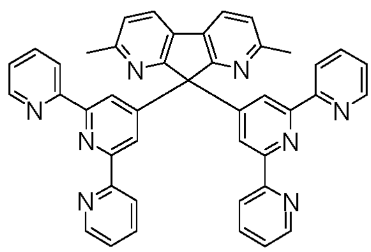 |
| (223) | (224) |

(continued)

| | |
|---|---|
| 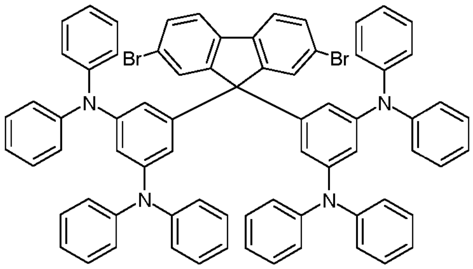 | 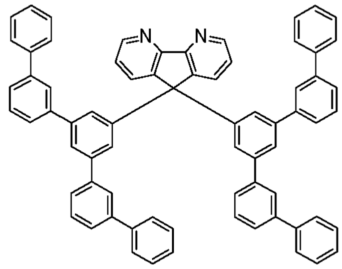 |
| (225) | (226) |
| 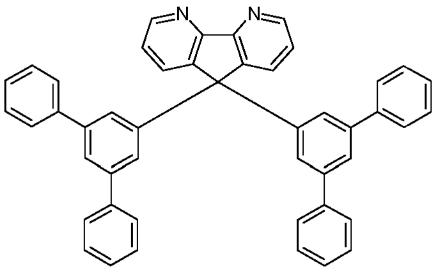 | 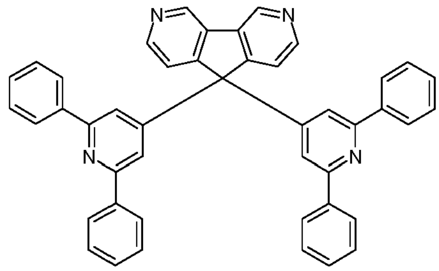 |
| (227) | (228) |
| 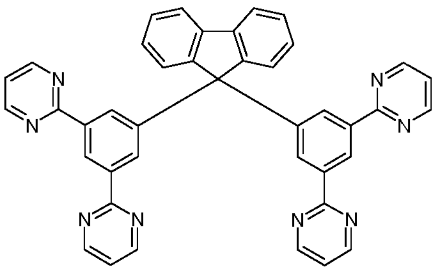 | 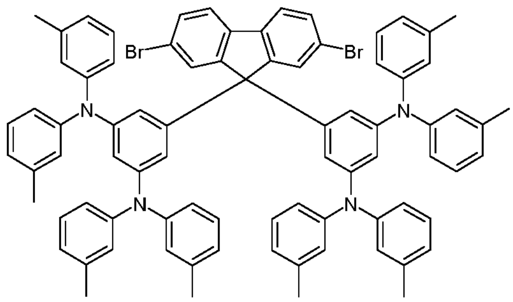 |
| (229) | (230) |
| 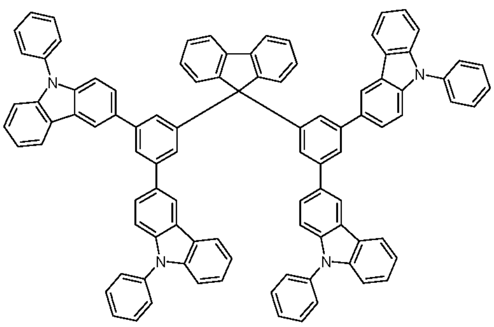 | 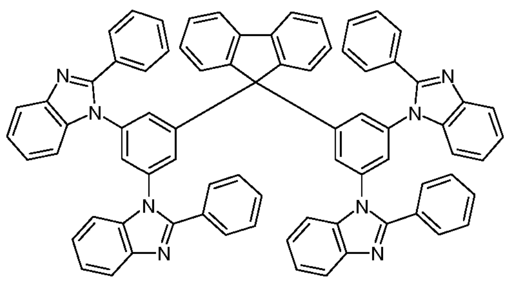 |
| (231) | (232) |
| 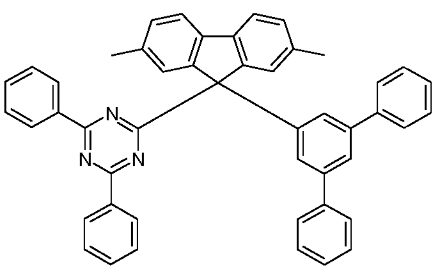 | 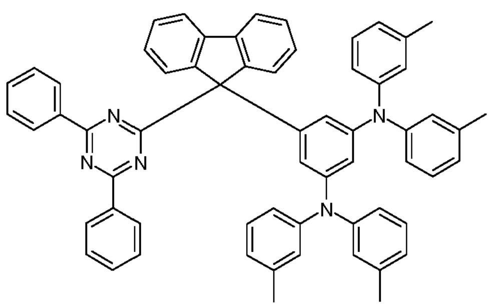 |
| (233) | (234) |

(continued)

| | |
|---|---|
| 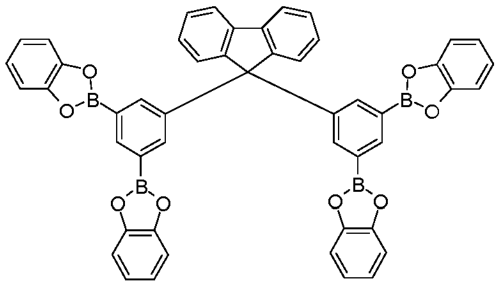 | 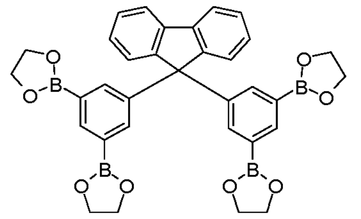 |
| (235) | (236) |
| 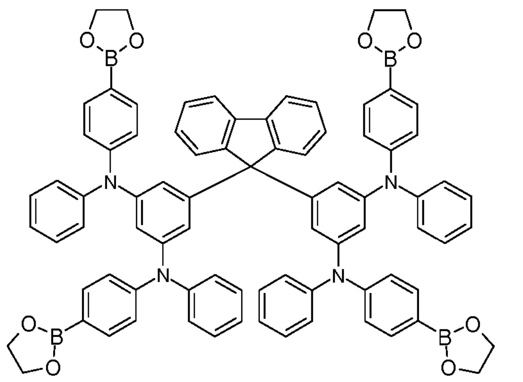 | 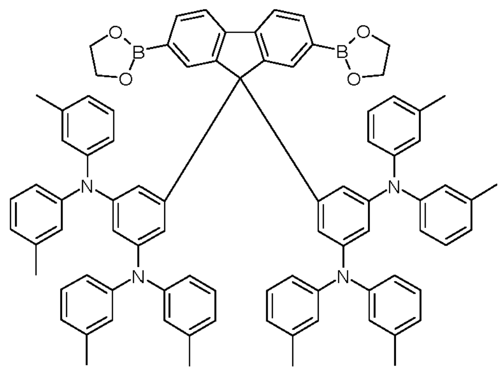 |
| (237) | (238) |
| 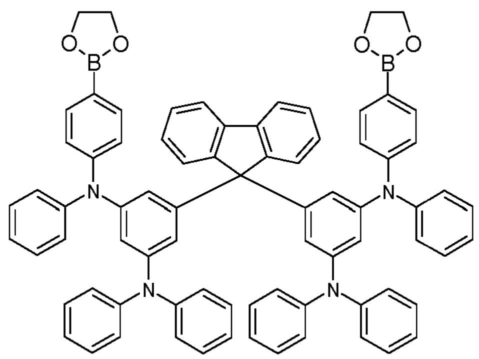 | 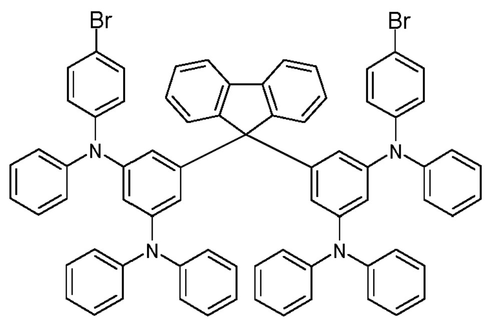 |
| (239) | (240) |
| 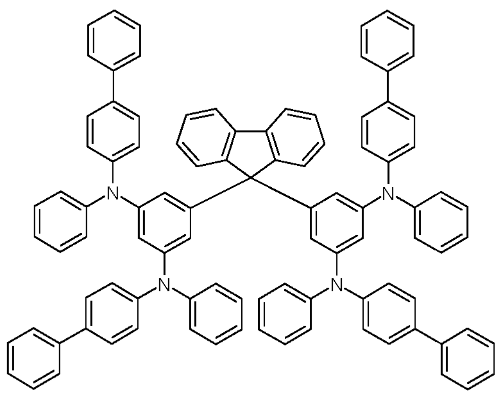 | 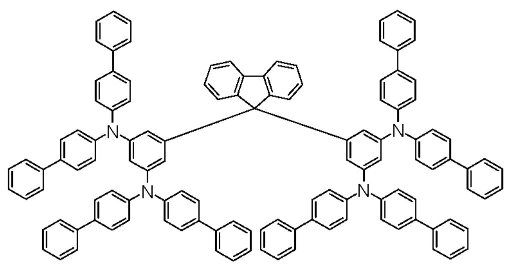 |
| (241) | (242) |

(continued)

| | |
|---|---|
| 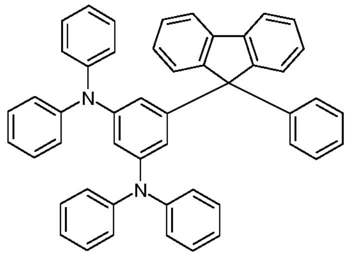 | 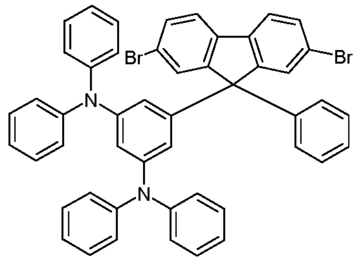 |
| (243) | (244) |
| 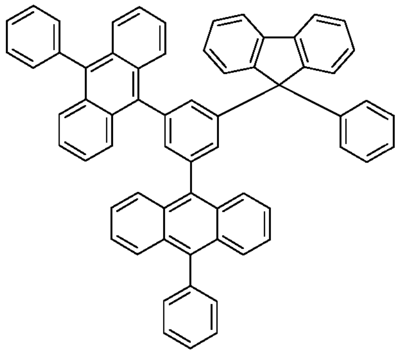 | 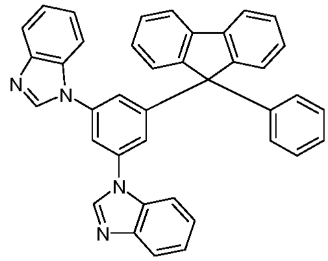 |
| (245) | (246) |
| 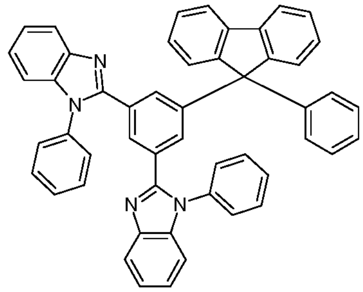 | 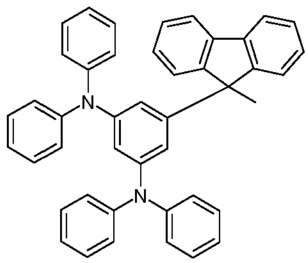 |
| (247) | (248) |
| 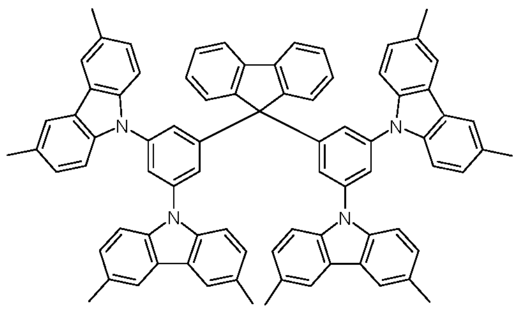 | 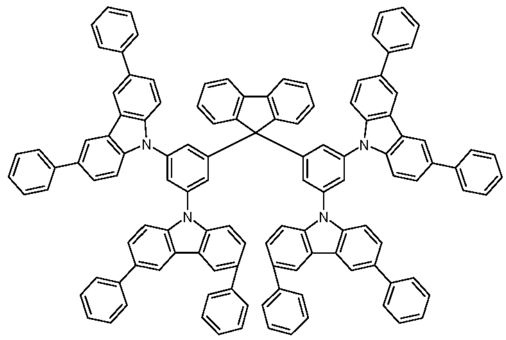 |
| (249) | (250) |

(continued)

| | |
|---|---|
| 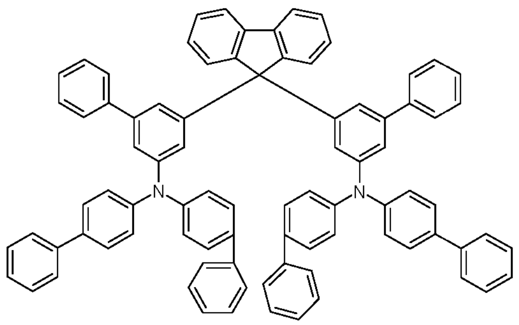 | 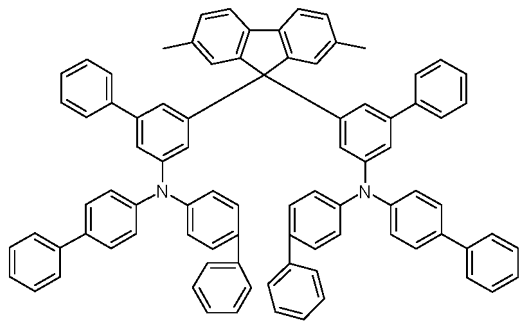 |
| (251) | (252) |
| 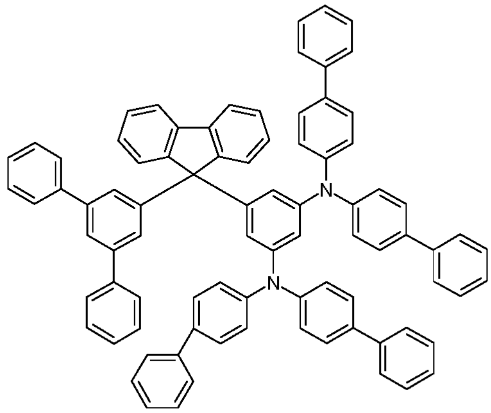 | 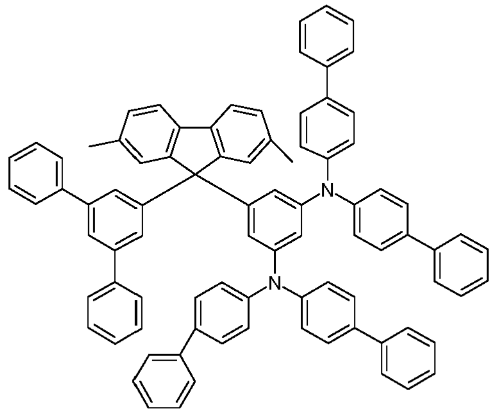 |
| (253) | (254) |
| 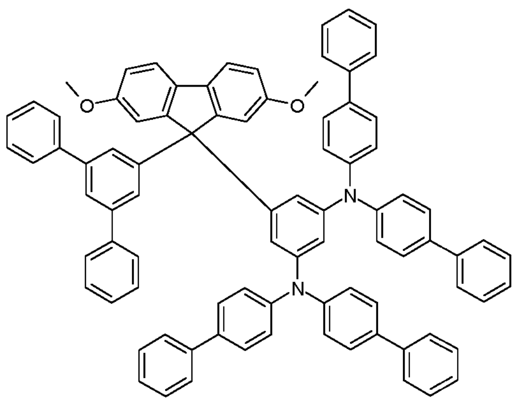 | 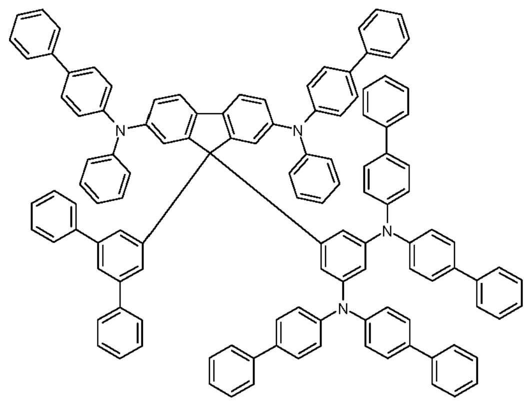 |
| (255) | (256) |
| 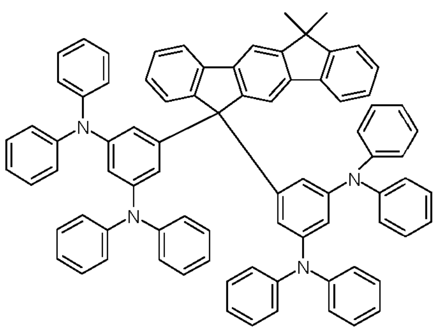 | 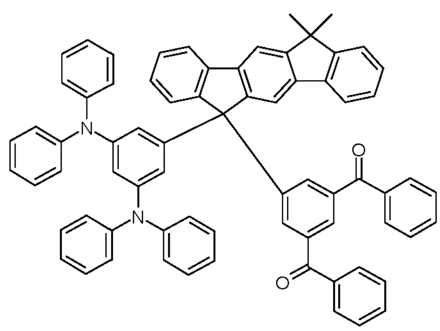 |
| (257) | (258) |

(continued)

| | |
|---|---|
| 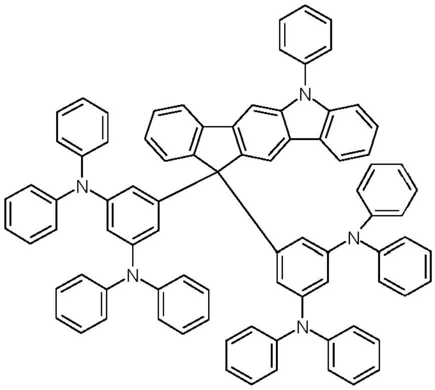 | 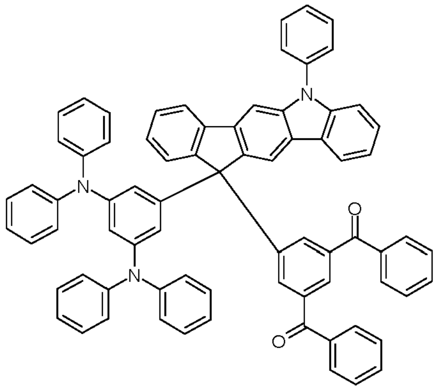 |
| (259) | (260) |
| 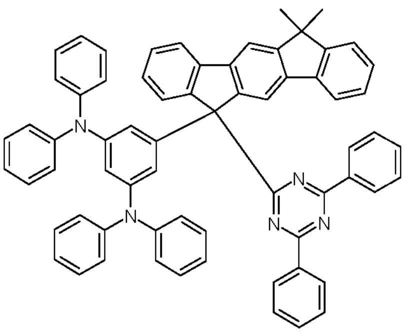 | 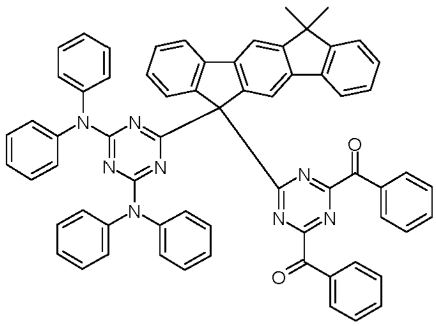 |
| (261) | (262) |
| 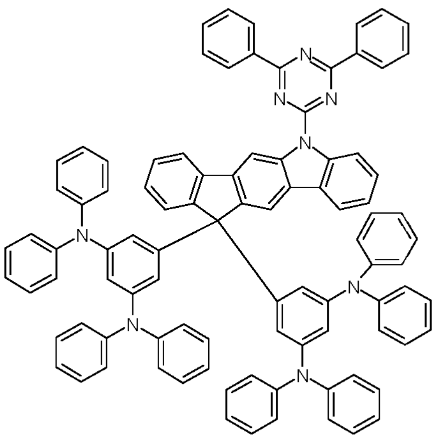 | 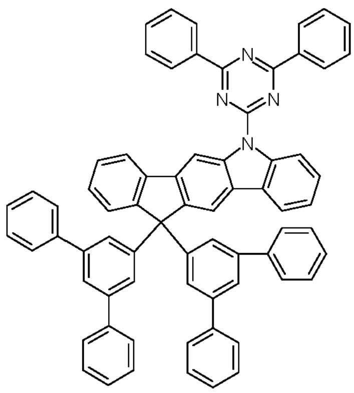 |
| (263) | (264) |
| 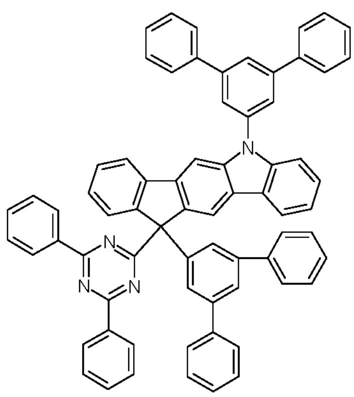 | 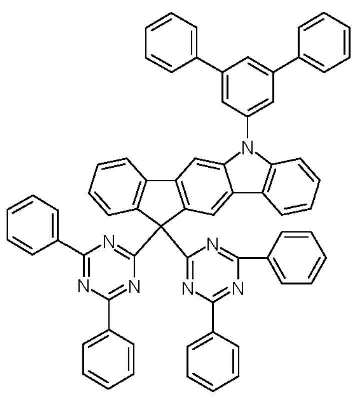 |

(continued)

| (265) | (266) |
|---|---|
| 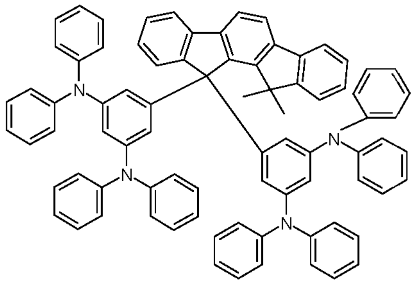 | 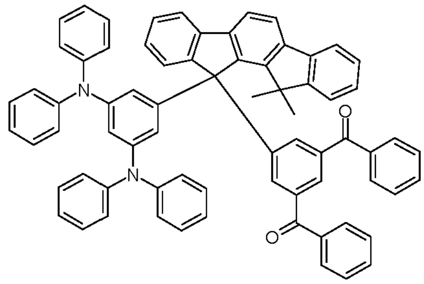 |
| (267) | (268) |
| 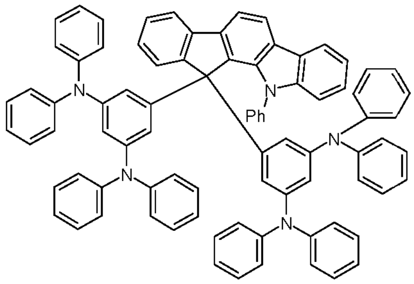 | 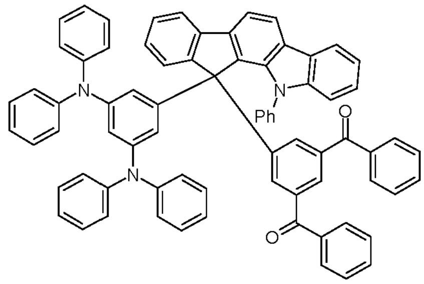 |
| (269) | (270) |
| 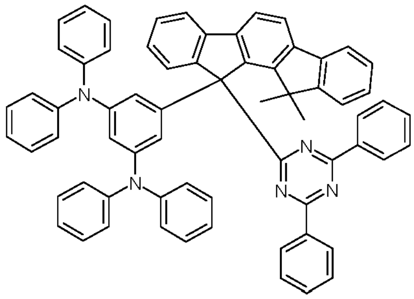 | 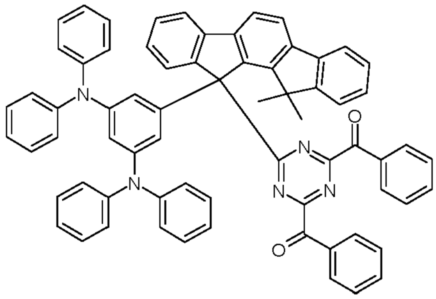 |
| (271) | (272) |
| 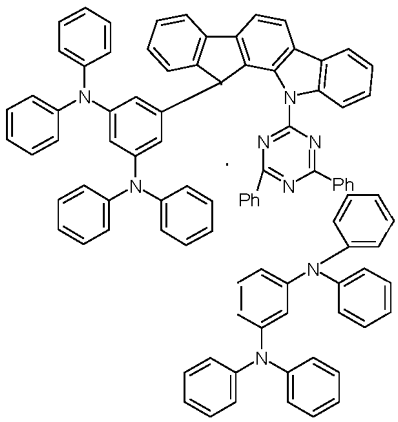 | 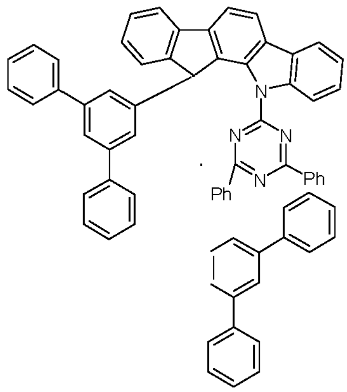 |
| (273) | (274) |

(continued)

| | |
|---|---|
| 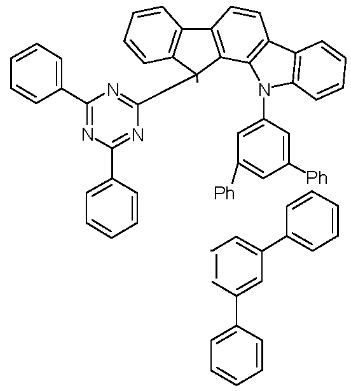 | 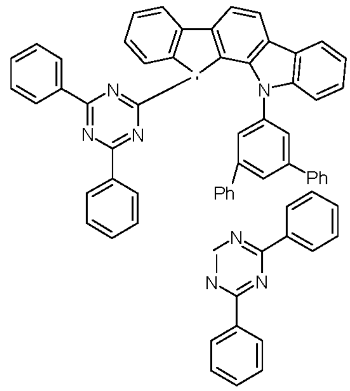 |
| (275) | (276) |
| 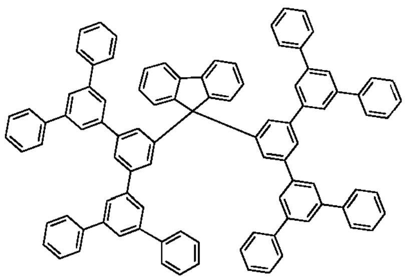 | 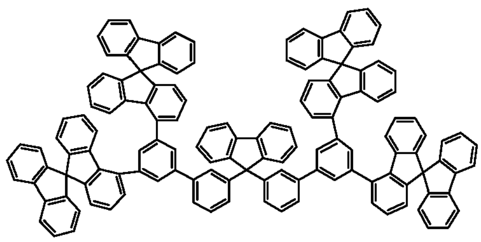 |
| (277) | (278) |
| 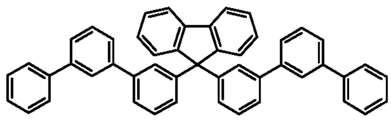 | 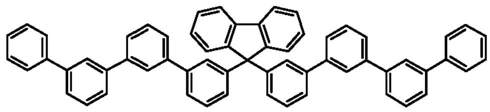 |
| (279) | (280) |
| 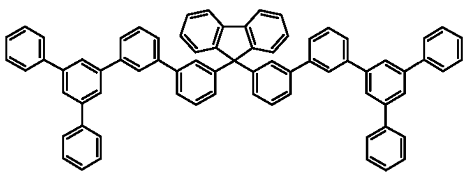 | 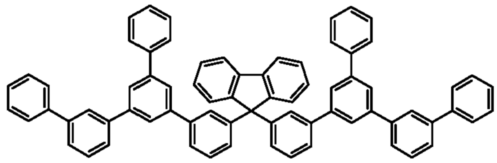 |
| (281) | (282) |
| 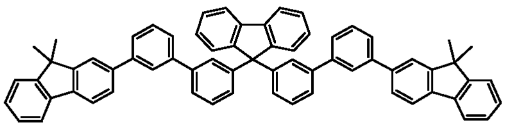 | 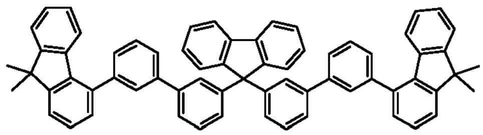 |
| (283) | (284) |
| 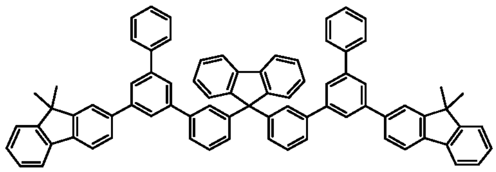 | 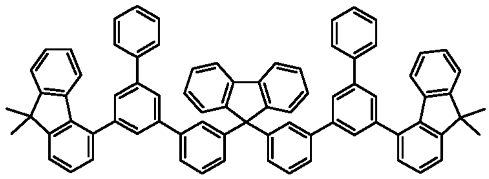 |
| (285) | (286) |

(continued)

| | |
|---|---|
| 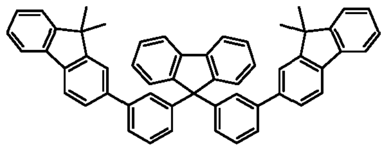 | 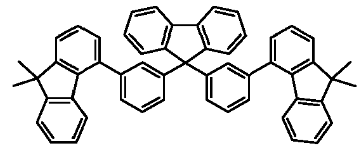 |
| (287) | (288) |
| 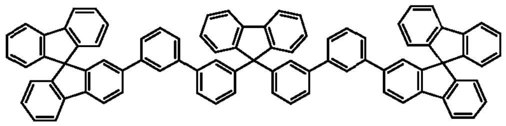 | 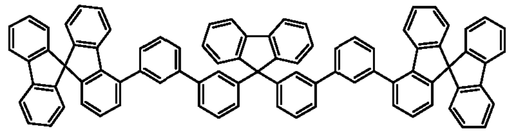 |
| (289) | (290) |
| 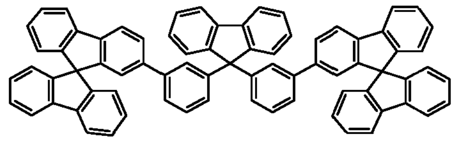 | 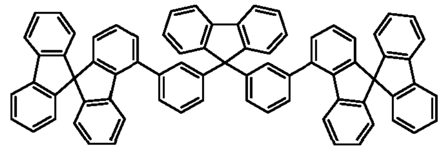 |
| (291) | (292) |
| 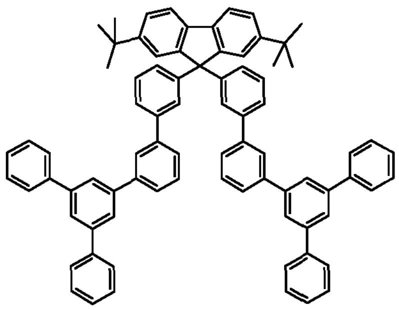 | 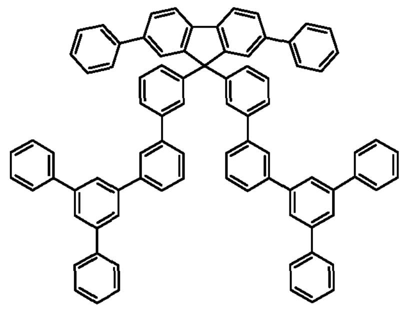 |
| (293) | (294) |
| 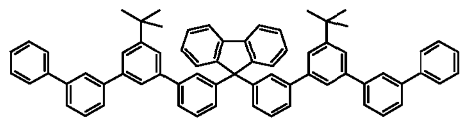 | 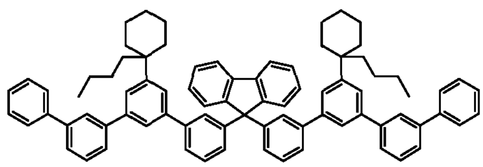 |
| (295) | (296) |
| 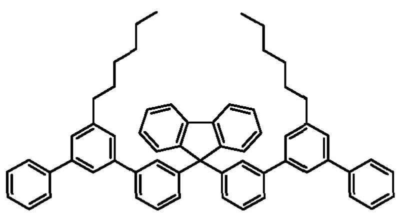 | 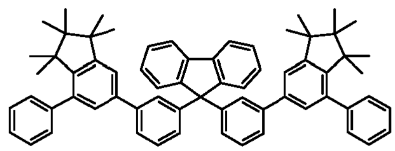 |
| (297) | (298) |
| 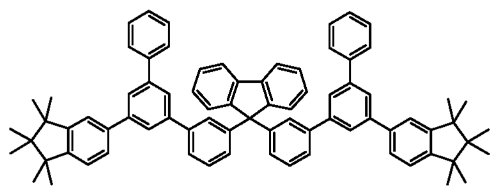 | 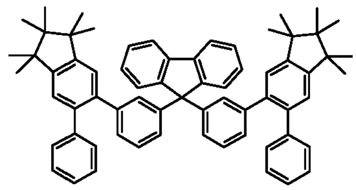 |
| (299) | (300) |

(continued)

| | |
|---|---|
| 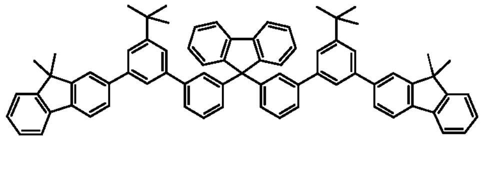 | 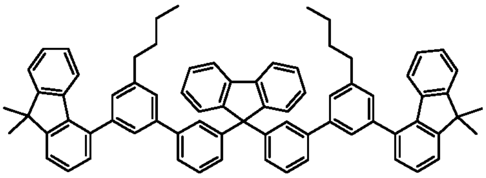 |
| (301) | (302) |
| 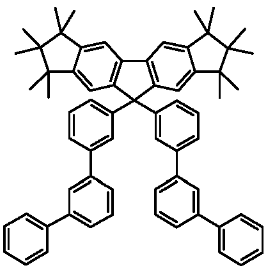 | 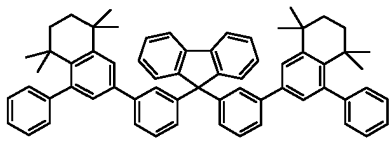 |
| (303) | (304) |
| 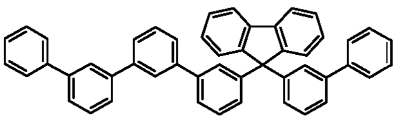 | 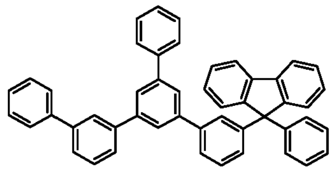 |
| (305) | (306) |
| 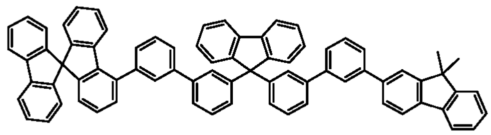 | 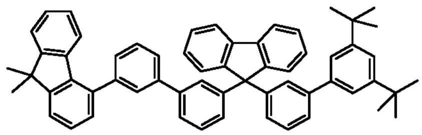 |
| (307) | (308) |
| 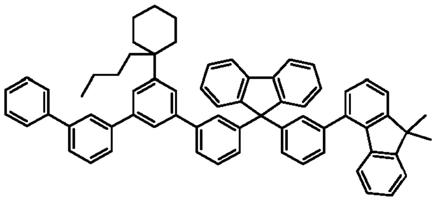 | 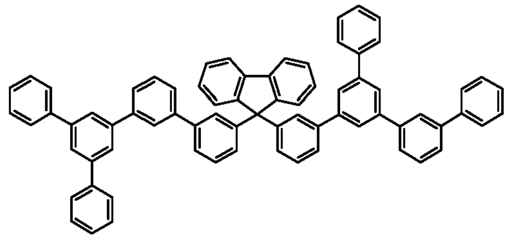 |
| (309) | (310) |
| 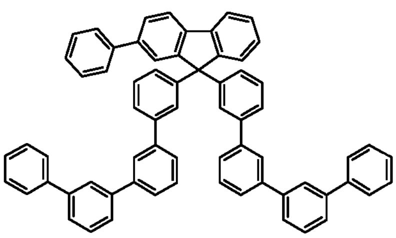 | 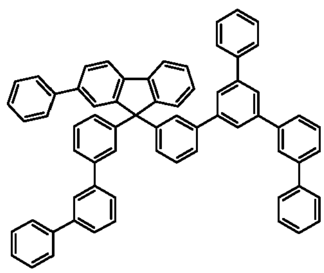 |
| (311) | (312) |

(continued)

| | |
|---|---|
| 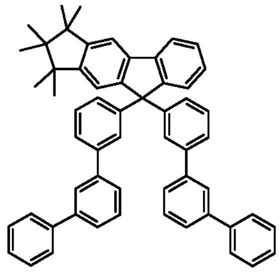 | 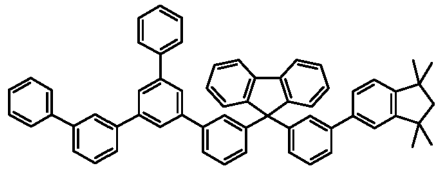 |
| (313) | (314) |
| 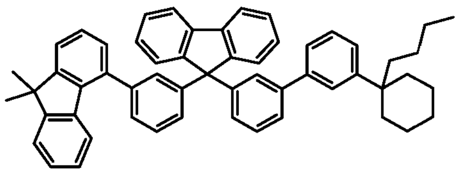 | 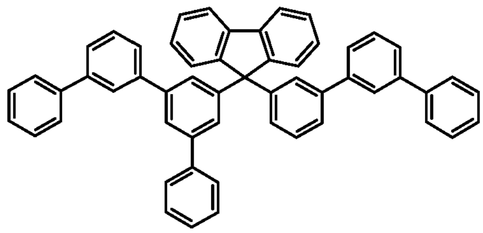 |
| (315) | (316) |
| 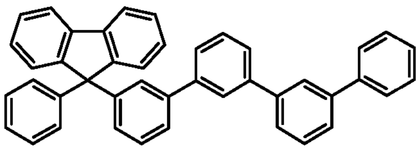 | 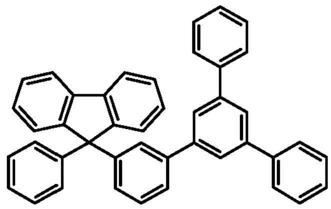 |
| (317) | (318) |
| 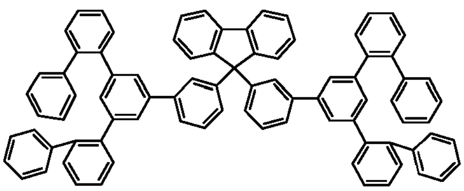 | 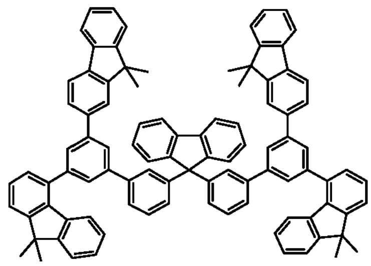 |
| (319) | (320) |
| 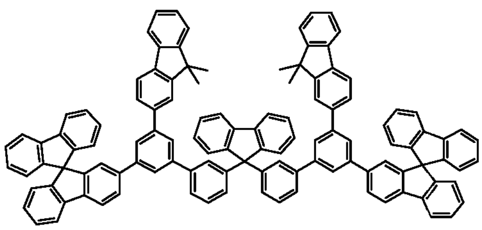 | 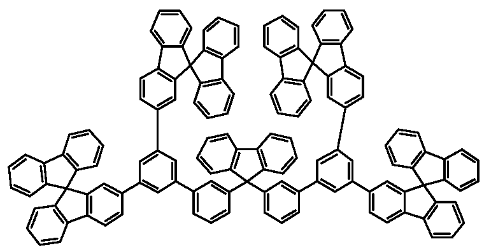 |
| (321) | (322) |

(continued)

| | |
|---|---|
| 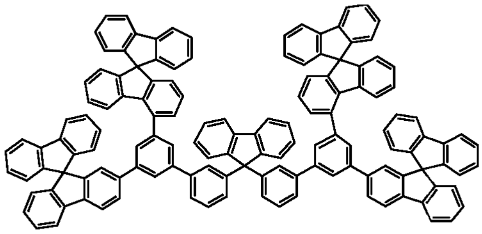 | |
| (323) | |

From the compounds of the formulae (1) to (323), the compounds of the formulae (70) to (75), (77), (93) to (100), (102), (105) to (108), (175), (179), (185), (187) and (277) to (323) are more preferred, the compounds of the formulae (70) to (75), (93) to (100), (106), (175), (179), (185), (187), (277), (279) to (304), (310) to (312), (316) and (319) are particularly preferred, and the compounds of the formulae (70) to (75), (93) to (100), (106), (185), (187), 277), (279) to (282) and (293) to (295) are most preferred.

In preferred embodiments, the compounds which can be represented by structures of the formula (1) or a preferred embodiment thereof as defined above, and in particular the preferred compounds represented by the structures (1) to (323) depicted above, may be a wide band gap material.

The compounds which can be represented by structures of the formula (1) or a preferred embodiment thereof as defined above, can be prepared by synthesis steps that are common knowledge to those skilled in the art, and which are, for example, disclosed in WO 2016184540 A1 or WO 2009124627 A1. The starting compound used may, for example, be 3,3'-dibromobenzophenone (J. Mater. Chem. C 2014, 2028-2036).

According to the present invention, as an inorganic part of the at least one semiconducting light emitting nanoparticle, a wide variety of publically known semiconducting light emitting nanoparticles can be used as desired.

As used herein, the term "nano" means a size of 200 nm or smaller, such as the range from 0.1 nm to 200 nm, preferably 0.5 nm to 150 nm.

According to the present invention, the term "size" means the average diameter of the longest axis of the light emitting nanoparticles. The size of the nanoparticles can be measured by using the standard technique like transmission electron microscopy (TEM) or dynamic light scattering.

A type of shape of the semiconducting light emitting nanoparticles of the present invention is not particularly limited. For example, the nanoparticles may be spherical shaped, elongated shaped, star shaped, polyhedron shaped, cube shaped, tetrapod shaped, tetrahedron shaped, platelet shaped, cone shaped, and irregularly shaped, without being limited thereto.

In a preferred embodiment of the present invention, the at least one semiconducting light emitting nanoparticle is a semiconducting quantumsized light emitting material, which is also called a "quantum material" and which terms are used interchangeably herein.

As used herein, the term "quantumsized" means the size of the inorganic, semiconducting light emitting material itself, i.e., without ligands or any other surface modification, which can show the quantum confinement effect, like described in, for example, ISBN:978-3-662-44822-9. Generally, it is said that quantumsized materials or quantum materials such as quantum dots and quantum rods can emit tunable, sharp and vivid colored light due to "quantum confinement" effect. Quantum dots (QDs) can emit light in the visible wavelength range. Further QDs can emit blue, green and red light.

A type of shape of the quantum material of the present invention is not particularly limited, and the above-mentioned shapes related to nanoparticles can be used. In a further preferred embodiment of the present invention, the quantumsized light emitting material is selected from quantum dots (QDs) and quantum rods, but quantum dots are particularly preferred.

Preferably, the size of the quantum sized materials such as quantum dots (i.e., of the inorganic, semiconducting light emitting material without ligands) is from 0.1 nm to 100 nm, more preferably from 0.5 nm to 50 nm, even more preferably from 1 nm to 20 nm, and particularly preferably from 3 nm to 20 nm.

As a quantum dot, publically available quantum dots, for examples, CdSeS/ZnS alloyed quantum dots with product number 753793, 753777, 753785, 753807, 753750, 753742, 753769, 753866, InP/ZnS quantum dots with product number 776769, 776750, 776793, 776777, 776785, PbS core-type quantum dots with product number 747017, 747025, 747076, 747084, or CdSe/ZnS alloyed quantum dots with product number 754226, 748021, 694592, 694657, 694649, 694630, 694622 from Sigma-Aldrich can be used as desired. Preferably, the quantum dots are selected from Cd-free quantum dots.

The at least one semiconducting light emitting nanoparticle has a core-shell-structure, wherein an inorganic core

is surrounded by one or more inorganic shell layers.

According to the present invention, said one or more shell layers of the semiconducting light emitting nanoparticle can be a single shell layer, a double shell layer, or multishell layers having more than two shell layers, but preferably is a double shell layer.

As used herein, the term "shell layer" means a layer fully or partially covering said core. Preferably, said one or more shell layers fully cover said core. The terms "core" and "shell" are well known in the art and typically used in the field of quantum materials, such as US 8221651 B2.

Further preferably, said at least one semiconducting light emitting nanoparticle of the present invention having the core-shell-structure is a quantum material, and in particular a quantum dot.

According to the present invention, said core material of the semiconducting light emitting nanoparticle, such as a quantum dot, is a material selected from CdS, CdSe, CdTe, ZnS, ZnSe, ZnSeS, ZnTe, ZnO, GaAs, GaP, GaSb, HgS, HgSe, HgSe, HgTe, InAs, InP, InPS, InPZnS, InPZn, InPGa, InSb, AlAs, AlP, AlSb, $Cu_2S$, $Cu_2Se$, CuInS2, $CuInSe_2$, $Cu_2(ZnSn)S_4$, $Cu_2(InGa)S_4$, $TiO_2$ alloys, and a combination of any of these.

Particularly preferably, said core of the semiconducting light emitting nanoparticle according to this embodiment of the present invention, for example a quantum dot, comprises one or more elements of group 12, 13 or 14 of the periodic table of elements and one or more elements of group 15 or 16 of the periodic table of elements. Preferred are the combinations of one or more elements of group 13 and of group 15, of group 12 and of group 16, of group 13 and of group 16, and of group 14 and of group 16, more preferred one or more elements of group 13 and of group 15, of group 12 and of group 16, and of group 13 and of group 16. Particularly preferred examples of the core are selected from GaAs, GaP, GaSb, InAs, InP, InPS, InPZnS, InPZn, InPGa, InSb, AlAs, AlP, AlSb, CuInS2, $CuInSe_2$, $Cu_2(InGa)S_4$, and a combination of any of these. In a very particularly preferred embodiment, the core comprises In and P atoms, for example, InP, InPS, InPZnS, InPZn or InPGa. Preferably, the core material is Cd-free.

According to the present invention, said at least one of the shell layers comprises a first element of group 12, 13 or 14 of the periodic table of elements, and a second element of group 15 or 16 of the periodic table of elements. Preferably, all shell layers comprises a first element of group 12, 13 or 14 of the periodic table of elements and a second element of group 15 or 16 of the periodic table of elements. In preferred combinations, the first element is of group 13 and the second of group 15, or the first element is of group 12 and the second of group 16, or the first element is of group 13 and the second of group 16, or the first element is of group 14 and the second of group 16. In more preferred combinations, the first element is of group 13 and the second of group 15, or the first element is of group 12 and the second of group 16, or the first element is of group 13 and the second of group 16. Preferably, the shell material is Cd-free.

Particularly preferably, at least one shell layer, preferably all shell layers, is represented by following formula (I),

$$ZnS_xSe_yTe_z, \qquad \text{formula (I)},$$

in which 0≤x≤1, 0≤y≤1, 0≤z≤1, and x+y+z=1, with 0≤x≤1, 0≤y≤1, z=0, and x+y=1 being even more preferred.

ZnS, ZnSe, ZnSeS, ZnSeSTe, CdS/ZnS, ZnSe/ZnS, ZnS/ZnSe shell layers are most preferably used.

Particularly preferred core-shell semiconducting light emitting nanoparticles, such as quantum dots, are selected from, CdSe/CdS, CdSeS/CdZnS, CdSeS/CdS/ZnS, ZnSe/CdS, CdSe/ZnS, InP/ZnS, InP/ZnSe, InP/ZnSe/ZnS, InP/ZnS/ZnSe, InPZn/ZnS, InPZn/ZnSe/ZnS, InPZn/ZnS/ZnSe, ZnSe/CdS, ZnSe/ZnS semiconducting light emitting nanoparticles or combination of any of these. Preferably, the core-shell semiconducting light emitting nanoparticle is Cd-free.

Very particular preference is given to InP/ZnS, InP/ZnSe, InP/ZnSe/ZnS, InP/ZnS/ZnSe, InPZn/ZnS, InPZn/ZnSe/ZnS and InPZn/ZnS/ZnSe core-shell semiconducting light emitting nanoparticles, such as quantum dots.

Such semiconducting light emitting nanoparticles are publically available, for example, from Sigma-Aldrich and / or described in, for example, ACS Nano, 2016, 10 (6), pp 5769-5781, Chem. Mater. 2015, 27, 4893-4898, and the international patent application No. WO 2010/095140 A2.

In a preferred embodiment of the present invention, the at least one semiconducting light emitting nanoparticle is a quantumsized light emitting material, in particular a quantum dot or quantum rod, which is further preferably Cd-free.

Thus, in a further preferred embodiment of the present invention, the electronic device comprises anode, cathode and at least one layer which comprises the following compounds:

a) at least one semiconducting light emitting nanoparticle selected from quantumsized light emitting materials, preferably from quantum dots and quantum rods, more preferably quantum dots, and particularly preferably selected from core-shell-structured quantum dots, as defined above; and

b) at least one compound having a band gap of 2.5 eV or more, preferably 3.0 eV or more, more preferably 3.5 eV or more, and very preferably 4.0 eV or morerepresented by the formula (1), or a preferred embodiment thereof, as defined above.

The at least one semiconducting light emitting nanoparticle, such as a quantum dot, quantum rod, or core-shell structured semiconducting light emitting nanoparticle, may further have one or more different types of surface modifying ligands attached to its surface. Thus, the outermost surface of the light emitting material or the shell layers of the semiconducting light emitting nanoparticles may be over coated with one or more kinds of surface modifying ligands, particularly in order to improve dispersibility of the semiconducting light emitting nanoparticle in a solvent. Preferred examples of such surface ligands include, without being limited thereto, polyethylenimine (PEI), phosphines and phosphine oxides such as Trioctylphosphine oxide (TOPO), Trioctylphosphine (TOP), and Tributylphosphine (TBP); phosphonic acids such as Dodecylphosphonic acid (DDPA), Tridecylphosphonic acid (TDPA), Octadecylphosphonic acid (ODPA), and Hexylphosphonic acid (HPA); amines such as Oleylamine, Dedecyl amine (DDA), Tetradecyl amine (TDA), Hexadecyl amine (HDA), and Octadecyl amine (ODA), Oleylamine (OLA), 1-Octadecene (ODE), thiols such as hexadecane thiol, dodecanethiol and hexane thiol; mercapto carboxylic acids such as mercapto propionic acid and mercaptoundecanoicacid; carboxylic acids such as oleic acid, stearic acid, myristic acid, palmitic acid, acetic acid; and a combination of any of these.

Preferred examples of surface ligands have also been described, for example, in the international patent application No. WO 2012/059931 A.

As mentioned above, the electronic device according to the invention comprises anode, cathode and at least one layer which comprises the at least one semiconducting light emitting nanoparticle and the at least one compound having a band gap of 2.5 eV or more represented by the formula (1) or a preferred embodiment thereof as defined above.

The electronic device is preferably an EL device selected from organic light-emitting transistors (OLETs), organic field-quench devices (OFQDs), organic laser diodes (O-lasers) and organic light emitting diodes (OLEDs), of which OLEDs are most preferred.

As mentioned above, the term organic electroluminescent devices in the context of the present application is understood to also include such hybrid systems of organic electroluminescent devices, such as OLEDs, which employ inorganic light emitting materials such as quantum dots (QD) as light emitting materials, and additionally may include one or more further inorganic layer, for example ZnO as the electron transport material (ETM) in OLEDs.

The electronic device here may comprise, apart from anode, cathode and one or more emission layers or emitting layers, which terms are used interchangeably herein, hole-injection layers, hole-transport layers, hole-blocking layers, electron-transport layers, electron-injection layers, exciton-blocking layers, electron-blocking layers and/or charge-generation layers (IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer*).* Interlayers, which have, for example, an exciton-blocking function, may likewise be introduced between two emitting layers. However, it should be pointed out that each of these layers does not necessarily have to be present.

According to a preferred embodiment of the invention, the at least one layer which comprises the at least one semiconducting light emitting nanoparticle and the at least one compound having a band gap of 2.5 eV or more represented by the formula (1) or a preferred embodiment thereof as defined above is an emitting layer (EML). Besides the at least one semiconducting light emitting nanoparticle, the EML preferably comprises one or more host or matrix materials, at least one of which is a wide band gap material.

In this preferred embodiment of the electronic device of the invention, the at least one compound having a band gap of 2.5 eV or more is preferably employed in the EML as a host or matrix material for the at least one semiconducting light emitting nanoparticle, and more preferably a host or matrix material having the properties of a wide band gap material.

The electronic device here may comprise one emitting layer or a plurality of emitting layers, where according to this embodiment at least one emitting layer comprises the at least one semiconducting light emitting nanoparticle and the at least one compound having a band gap of 2.5 eV or more as host or matrix material. If a plurality of emission layers is present, these preferably have in total a plurality of emission maxima between 380 nm and 750 nm, resulting overall in white emission, i.e. various emitting compounds and/or materials besides the at least one semiconducting light emitting nanoparticle which are able to fluoresce or phosphoresce are used in the emitting layers.

In a further preferred embodiment of the invention, the at least one layer comprising the at least one semiconducting light emitting nanoparticle and the at least one compound having a band gap of 2.5 eV or more represented by the formula (1) or a preferred embodiment thereof as defined above comprises from 5 to 95% by weight, preferably from 10 to 90% by weight, particularly preferably from 20 to 80% by weight, in particular from 25 to 75% by weight, of the at least one semiconducting light emitting nanoparticle, based on all components comprised in the layer.

In a still further preferred embodiment of the present invention, the proportion of the at least one semiconducting light emitting nanoparticle in the emitting layer is from 5 to 95% by weight, preferably from 10 to 90% by weight, particularly preferably from 20 to 80% by weight, in particular from 25 to 75% by weight, and the proportion of the one or more host or matrix materials comprising the at least one compound having a band gap of 2.5 eV or more, is from 95 to 5 % by weight, preferably from 90 to 10% by weight, particularly preferably from 80 to 20% by weight, in particular from 75 to 25% by weight.

Further preferably, the at least one layer which comprises the at least one semiconducting light emitting

nanoparticle and the at least one compound having a band gap of 2.5 eV or more, which is preferably an emitting layer, may comprise at least one further material preferably selected from host materials, matrix materials, electron transporting materials, electron injecting materials, hole transporting materials, hole injecting materials, electron blocking materials, hole blocking materials and wide band gap materials, as typically used according to the prior art.

In one embodiment of the electronic device of the present invention, the at least one compound having a band gap of 2.5 eV or more represented by the formula (1) or a preferred embodiment thereof as defined above is employed as the sole host or matrix material in the mixture with the at least one semiconducting light emitting nanoparticle, such as a quantum dot, preferably in the emitting layer.

In another embodiment of the electronic device of the present invention, the at least one compound having a band gap of 2.5 eV or more represented by the formula (1) or a preferred embodiment thereof as defined above is employed as host or matrix material for the at least one semiconducting light emitting nanoparticle, such as a quantum dot, in combination with one or more further materials, preferably one or more further host or matrix materials, and preferably in the emitting layer. Suitable further host or matrix materials which may be employed in combination with the at least one compound having a band gap of 2.5 eV or more as host or matrix components of a mixed matrix or host system are aromatic ketones, aromatic phosphine oxides or aromatic sulfoxides or sulfones, for example in accordance with WO 2004/013080, WO 2004/093207, WO 2006/005627 or WO 2010/006680, triarylamines, carbazole derivatives, for example CBP (N,N-biscarbazolylbiphenyl), m-CBP or the carbazole derivatives disclosed in WO 2005/039246, US 2005/0069729, JP 2004/288381, EP 1205527 or WO 2008/086851, indolocarbazole derivatives, for example in accordance with WO 2007/063754 or WO 2008/056746, indenocarbazole derivatives, for example in accordance with WO 2010/136109 or WO 2011/000455, aza-carbazole derivatives, for example in accordance with EP 1617710, EP 1617711, EP 1731584, JP 2005/347160, bipolar matrix materials, for example in accordance with WO 2007/137725, silanes, for example in accordance with WO 2005/111172, azaboroles or boronic esters, for example in accordance with WO 2006/117052, triazine derivatives, for example in accordance with WO 2010/015306, WO 2007/063754 or WO 08/056746, zinc complexes, for example in accordance with EP 652273 or WO 2009/062578, fluorene derivatives, for example in accordance with WO 2009/124627, diazasilole or tetraazasilole derivatives, for example in accordance with WO 2010/054729, diazaphosphole derivatives, for example in accordance with WO 2010/054730, or bridged carbazole derivatives, for example in accordance with US 2009/0136779, WO 2010/050778, WO 2011/042107 or WO 2011/088877. Preferably according to this embodiment, the further host or matrix material is a material having hole- and/or electron-transporting properties, preferably hole-transporting properties, or a "bipolar" matrix material having both hole-transporting and electron-transporting properties. More preferably, the compound having a band gap of 2.5 eV has the properties of a wide band gap material and the further host or matrix material is hole- and/or electron-transporting, preferably hole-transporting.

Preferred electron-transporting compounds which can be used together with the at least one compound having a band gap of 2.5 eV or more represented by the formula (1) or a preferred embodiment thereof as defined above is employed, include those described in WO 2014/094964, particularly preferred electron-conducting compounds having a LUMO of $\leq$ -2.4 eV.

It is likewise possible to use one or more phosphorescent emitters in addition to the at least one semiconducting light emitting nanoparticle in the emitting layer. In this case, the emitter which emits at shorter wavelength acts as co-host.

Suitable phosphorescent compounds (= triplet emitters) are, in particular, compounds which emit light, preferably in the visible region, on suitable excitation and in addition contain at least one atom having an atomic number greater than 20, preferably greater than 38 and less than 84, particularly preferably greater than 56 and less than 80, in particular a metal having this atomic number. The phosphorescent emitters used are preferably compounds which contain copper, molybdenum, tungsten, rhenium, ruthenium, osmium, rhodium, iridium, palladium, platinum, silver, gold or europium, in particular compounds which contain iridium, platinum or copper.

Examples of the emitters described above are revealed by the applications WO 2000/70655, WO 2001/41512, WO 2002/02714, WO 2002/15645, EP 1191613, EP 1191612, EP 1191614, WO 2005/033244, WO 2005/019373, US 2005/0258742, WO 2009/146770, WO 2010/015307, WO 2010/031485, WO 2010/054731, WO 2010/054728, WO 2010/086089, WO 2010/099852, WO 2010/102709, WO 2011/157339 or WO 2012/007086. In general, all phosphorescent complexes as used in accordance with the prior art for phosphorescent OLEDs and as are known to the person skilled in the art in the area of organic electroluminescence are suitable, and the person skilled in the art will be able to use further phosphorescent complexes without inventive step.

The at least one semiconducting light emitting nanoparticle and the at least one compound having a band gap of 2.5 eV or more may also be present, additionally or exclusively, in another layer of the electronic device than the emitting layer, preferably in a layer adjoining the emitting layer, for example a hole- or electron-blocking layer. In a further embodiment of the invention, the at least one compound having a band gap of 2.5 eV or more represented by the formula (1) or a preferred embodiment thereof as defined above is exclusively employed as hole-transport material or as hole injection material or as electron blocker material or as exciton blocker material in a hole-transport or hole-injection or electron-blocking or exciton-blocking layer, or is employed both in a hole-transport or hole-injection or electron-blocking or

exciton-blocking layer and as a host or matrix material in the emitting layer. In the first case, the emitting layer comprises another organic compound having a band gap of 2.5 eV or more, which preferably has the properties of a wide band gap material, as host or matrix material for the at least one semiconducting light emitting nanoparticle.

In a further embodiment, the electronic device according to the invention does not comprise a separate hole-injection layer and/or hole-transport layer and/or hole-blocking layer and/or electron-transport layer, i.e. the emitting layer is directly adjacent to the hole-injection layer or the anode, and/or the emitting layer is directly adjacent to the electron-transport layer or the electron-injection layer or the cathode, as described, for example, in WO 2005/053051.

In the further layers of the electronic device of the invention besides the at least one layer comprising the at least one semiconducting light emitting nanoparticle and the at least one compound having a band gap of 2.5 eV or more represented by the formula (1) or a preferred embodiment thereof as defined above especially in the emitting layer, in the hole injection (HIL) and hole transport layers (HTL) and in the electron injection (EIL) and electron transport layers (ETL), it is possible to use any materials as typically used according to the prior art. The hole transport layers may also be p-doped and/or the electron transport layers may also be n-doped. A p-doped layer is understood to mean a layer in which free holes are generated and which has increased conductivity as a result. A comprehensive discussion of doped transport layers in OLEDs can be found in Chem. Rev. 2007, 107, 1233. More preferably, the p-dopant is capable of oxidizing the hole transport material in the hole transport layer, i.e. has a sufficiently high redox potential, especially a higher redox potential than the hole transport material. Suitable dopants are in principle any compounds which are electron acceptor compounds and which can increase the conductivity of the organic layer by oxidizing the host. The person skilled in the art, in the context of his common knowledge in the art, is able to identify suitable compounds without any great effort. Especially suitable dopants are the compounds disclosed in WO 2011/073149, EP 1968131, EP 2276085, EP 2213662, EP 1722602, EP 2045848, DE 102007031220, U.S. Pat. No. 8,044,390, U.S. Pat. No. 8,057,712, WO 2009/003455, WO 2010/094378, WO 2011/120709 and US 2010/0096600.

The person skilled in the art will therefore be able, without exercising inventive skill, to use all the materials known for electronic device, in particular electroluminescent devices, in combination with the at least one layer comprising the at least one semiconducting light emitting nanoparticle and the at least one compound having a band gap of 2.5 eV or more represented by the formula (1) or a preferred embodiment thereof as defined above.

Preferred cathodes are metals having a low work function, metal alloys or multilayer structures composed of various metals, for example alkaline earth metals, alkali metals, main group metals or lanthanoids (e.g. Ca, Ba, Mg, Al, In, Mg, Yb, Sm, etc.). Additionally suitable are alloys composed of an alkali metal or alkaline earth metal and silver, for example an alloy composed of magnesium and silver. In the case of multilayer structures, in addition to the metals mentioned, it is also possible to use further metals having a relatively high work function, for example Ag, in which case combinations of the metals such as Mg/Ag, Ca/Ag or Ba/Ag, for example, are generally used. It may also be preferred to introduce a thin interlayer of a material having a high dielectric constant between a metallic cathode and the layer comprising the at least one semiconducting light emitting nanoparticle. Suitable for this purpose are, for example, alkali metal fluorides or alkaline-earth metal fluorides, but also the corresponding oxides or carbonates (for example LiF, $Li_2O$, $BaF_2$, MgO, NaF, CsF, $Cs_2CO_3$, etc.). Furthermore, lithium quinolinate (LiQ) can be used for this purpose. The layer thickness of this layer is preferably between 0.5 and 5 nm.

Preferred anodes are materials having a high work function. Preferably, the anode has a work function of greater than 4.5 eV versus vacuum. Firstly, metals having a high redox potential are suitable for this purpose, for example Ag, Pt or Au. On the other hand, metal/metal oxide electrons (e.g. Al/Ni/NiOx, Al/PtOx) may also be preferred. In this case, at least one of the electrodes has to be transparent or semitransparent in order to enable the emission of light. A preferred structure uses a transparent anode. Preferred anode materials here are conductive mixed metal oxides. Particular preference is given to indium tin oxide (ITO), aluminium doped zinc oxide (AZO) or indium zinc oxide (IZO). Preference is further given to conductive doped organic materials, especially conductive doped polymers.

In a further preferred embodiment of the invention, the electronic device is characterized in that one or more layers, preferably the at least one layer which comprises the at least one semiconducting light emitting nanoparticle and the at least one compound having a band gap of 2.5 eV or more represented by the formula (1) or a preferred embodiment thereof as defined above are coated by a sublimation method. In this case, the materials are applied by vapor deposition in vacuum sublimation systems at an initial pressure of less than $10^{-5}$ mbar, preferably less than $10^{-6}$ mbar. It is also possible that the initial pressure is even lower, for example less than $10^{-7}$ mbar.

In a further preferred embodiment of the invention, the electronic device is characterized in that one or more layers, preferably the at least one layer which comprises the at least one semiconducting light emitting nanoparticle and the at least one compound having a band gap of 2.5 eV or more represented by the formula (1) or a preferred embodiment thereof as defined above are coated by the OVPD (organic vapor phase deposition) method or with the aid of a carrier gas sublimation. In this case, the materials are applied at a pressure between $10^{-5}$ mbar and 1 bar. A special case of this method is the OVJP (organic vapor jet printing) method, in which the materials are applied directly by a nozzle and thus structured (for example, M. S. Arnold et al., Appl. Phys. Lett. 2008, 92, 053301).

In a further preferred embodiment of the invention, the electronic device is characterized in that one or more

layers, preferably the at least one layer which comprises the at least one semiconducting light emitting nanoparticle and the at least one compound having a band gap of 2.5 eV or more represented by the formula (1) or a preferred embodiment thereof as defined above are applied from solution, for example by spin-coating, flood coating, dip coating, spray coating, or by any printing method, for example screen printing, relief printing, gravure printing, rotary printing, roller coating, flexographic printing, offset printing, LITI (light-induced thermal imaging, thermal transfer printing), inkjet printing or nozzle printing. For this purpose, soluble compounds are needed, which are obtained, for example, through suitable substitution. These methods are also particularly suitable for preparing the electronic device according to the invention, in particular when compounds represented by the formula (1) or a preferred embodiment thereof as defined above are employed, since these compounds generally have very good solubility in organic solvents.

Also possible are hybrid processes, in which, for example, one or more layers are applied from solution and one or more further layers are applied by vapour deposition. Thus, for example, the emitting layer can be applied from solution and the electron-transport layer by vapour deposition.

These methods are known in general terms to those skilled in the art and can be applied by those skilled in the art without exercising inventive skill to electronic devices, in particular electroluminescent device, comprising the compounds and materials of the invention.

The present invention therefore further provides a method for preparing an an electronic device according to the present invention, characterized in that at least one layer is coated by a sublimation method and/or in that at least one layer is coated by an OVPD (organic vapor phase deposition) method or by means of a carrier gas sublimation and/or in that at least one layer is applied from solution by spin-coating or by a printing method. Preferably, the at least one layer coated or applied by the methods outlined above is the layer which comprises the at least one semiconducting light emitting nanoparticle and the at least one compound having a band gap of 2.5 eV or more represented by the formula (1) or a preferred embodiment thereof as defined above.

The electronic device comprising anode, cathode and at least one layer which comprises at least one semiconducting light emitting nanoparticle and the at least one compound having a band gap of 2.5 eV or more represented by the formula (1) or a preferred embodiment thereof as defined above is appropriately (depending on its application) structured, provided with contacts and finally sealed, since the lifetime of the devices according to the invention is shortened in the presence of water and/or air.

For the processing of the compounds having a band gap of 2.5 eV or more represented by the formula (1) or preferred embodiments thereof as defined above, or compositions comprising at least one semiconducting light emitting nanoparticle and at least one compound having a band gap of 2.5 eV or more represented by the formula (1) or a preferred embodiment thereof as defined above, from a liquid phase, for example by spin-coating or by printing methods, formulations of the compounds or compositions are required. These formulations may, for example, be solutions, dispersions or emulsions. For this purpose, it may be preferable to use mixtures of two or more solvents, for example mixtures of 1 to 5 solvents, or 1 to 4 solvents, more preferably organic solvents.

Suitable solvents are selected from the group consisting of alcohols, aldehydes, ketones, ethers, esters, amides such as dialkylformamides, sulfur compounds, nitro compounds, hydrocarbons, halogenated hydrocarbons, for example, chlorinated hydrocarbons, aromatic or heteroaromatic hydrocarbons, halogenated aromatic or heteroaromatic hydrocarbons and (cyclic)siloxanes, and mixtures of one or more thereof.

Preferred organic solvents are, for example, n-octane, n-decane, n-dodecane, iso-octane, iso-decane, iso-dodecane, 1,2,3,4-tetramethylbenzene, 1,2,3,5-tetramethylbenzene, 1,2,3-trimethylbenzene, 1,2,4-trichlorobenzene, 1,2,4-trimethylbenzene, 1,2-dihydronaphthalene, 1,2-dimethylnaphthalene, 1,3-benzodioxolane, 1,3-diisopropylbenzene , 1,3-dimethylnaphthalene, 1,4-benzodioxane, 1,4-diisopropylbenzene , 1,4-dimethylnaphthalene, 1,5-dimethyltetralin, 1-benzothiophene, 1-bromonaphthalene, 1-chloromethylnaphthalene, 1-ethylnaphthalene, 1-methoxynaphthalene, 1-methylnaphthalene, 1-methylindole, 2,3-benzofuran, 2,3-dihydrobenzofuran, 2,3-dimethyl-anisole, 2,4-dimethylanisole, 2,5-dimethylanisole, 2,6-dimethylanisole, 2,6-dimethylnaphthalene, 2-bromo-3-bromomethylnaphthalene, 2-bromomethylnaphthalene, 2-bromonaphthalene, 2-ethoxynaphthalene, 2-ethylnaphthalene, 2-isopropylanisole , 2-methylanisole, 2-methylindole, 3,4-dimethylanisole, 3,5-dimethylanisole, 3-bromoquinoline, 3-methylanisole, 4-methylanisole, 5-decanolide, 5-methoxyindane, 5-methoxyindole, 5-tert-butyl-m-xylene, 6-methylquinoline, 8-methylquinoline, acetophenone, anisole, benzonitrile, benzothiazole, benzyl acetate, bromobenzene, butyl benzoate, butyl phenyl ether, cyclohexylbenzene, decahydronaphthol, dimethoxytoluene, 3-phenoxytoluene, diphenyl ether, propiophenone, ethylbenzene, ethyl benzoate, $\gamma$-terpinene, hexylbenzene, indane, hexamethylindane, indene, isochroman, cumene, *m*-cymene, mesitylene, methyl benzoate, *o*-, *m*-, *p*-xylene, propyl benzoate, propylbenzene, *o*-dichlorobenzene, pentylbenzene, phenetol, ethoxybenzene, phenyl acetate, *p*-cymene, propiophenone, sec-butylbenzene, *t*-butylbenzene, thiophene, toluene, ethylbenzene, veratrol, monochlorobenzene, o-dichlorobenzene, pyridine, pyrazine, pyrimidine, pyrrolidinone, morpholine, dimethylacet-amide, dimethyl sulfoxide, decaline, and mixtures of one or more of these compounds.

There may be provided a composition comprising at least one semiconducting light emitting nanoparticle and at least one compound having a band gap of 2.5 eV or more, preferably at least one compound represented by the formula (1)

or a preferred embodiment thereof as defined above.

The at least one semiconducting light emitting nanoparticle is preferably a semiconducting light emitting nanoparticle as defined above.

The at least one semiconducting light emitting nanoparticle and the at least one compound having a band gap of 2.5 eV or more represented by the formula (1) or a preferred embodiment thereof as defined above may be used or applied together with further materials. A great variety of suitable organic functional materials is known to those skilled in the art in the field of electronic devices. Therefore the composition may comprise one or more further materials, which are more preferably selected from from host materials, matrix materials, electron transporting materials, electron injecting materials, hole transporting materials, hole injecting materials, electron blocking materials, hole blocking materials and wide band gap materials, as typically used according to the prior art. Preferred further host or matrix materials are selected from the further host or matrix materials defined above.

There may be provided a formulation, in particular a solution, dispersion or emulsion, comprising a composition as defined above, and at least a first solvent, in particular an organic solvent, which is more preferably selected from the group consisting of alcohols, aldehydes, ketones, ethers, esters, amides such as dialkylformamides, sulfur compounds, nitro compounds, hydrocarbons, halogenated hydrocarbons, for example, chlorinated hydrocarbons, aromatic or heteroaromatic hydrocarbons, halogenated aromatic or heteroaromatic hydrocarbons and (cyclic)siloxanes, and mixtures of one or more thereof.

That is, the formulation may comprise at least one semiconducting light emitting nanoparticle and at least one compound having a band gap of 2.5 eV or more, preferably a compound represented by the formula (1) or a preferred embodiment thereof as defined above, and at least a first solvent, in particular an organic solvent, as defined above. The at least one semiconducting light emitting nanoparticle is preferably a semiconducting light emitting nanoparticle as defined above. The way in which solutions of this type can be prepared is known to the person skilled in the art and is described, for example, in WO 2002/072714, WO 2003/019694 and the literature cited therein.

The first solvent may have a surface tension of ≥ 20 mN/m.

The surface tension can be measured using a commonly and commercially available high precision drop shape analysis tool, namely FTA1000 from

First Ten Angstrom. The surface tension is determined by the software FTA1000. All measurements were performed at room temperature which is in the range between 20°C and 25°C. The standard operating procedure includes the determination of the surface tension of each formulation using a fresh disposable drop dispensing system (syringe and needle). Each drop is measured over the duration of one minute with sixty measurements which are later on averaged. For each formulation three drops are measured. The final value is averaged over said measurements. The tool is regularly cross-checked against various liquids having well known surface tensions.

The first solvent may have a boiling point in the range from 150 to 350°C.

The formulation may comprise a second solvent, which is different from the first solvent and is preferably selected from the group defined above in relation to the first solvent.

It is particularly preferred that the content of the first solvent is in the range from 50 to 100 vol.-%, based on the total amount of solvents in the formulation.

The second solvent may have a boiling point in the range from 150 to 350°C.

In the formulation , the at least one compound having a band gap of 2.5 eV or more, which is preferably a compound represented by the formula (1) or a preferred embodiment thereof as defined above, may have a solubility in the first solvent in the range from 1 to 250 g/l.

The formulation may have a surface tension in the range from 15 to 80 mN/m.

The formulation may have a viscosity in the range from 1 to 50 mPa·s.

The viscosity of the formulations and solvents can be measured with a 1° cone-plate rotational rheometer of the type Discovery AR3 (Thermo

Scientific). The equipment allows a precise control of the temperature and sheer rate. The measurement of the viscosity is carried out at a temperature of 25.0°C (+/- 0.2°C) and a sheer rate of 500 $s^{-1}$. Each sample is measured three times and the obtained measured values are averaged.

In the formulation, the content of the at least one compound having a band gap of 2.5 eV or more, which is preferably a compound represented by the formula (1) or a preferred embodiment thereof as defined above, and the semiconducting light emitting nanoparticle in the formulation may be in the range from 0.001 to 50 weight-%, preferably 0.001 to 20 weight-% , based on the total weight of the formulation.

The electronic devices according to the invention are distinguished by one or more of the following surprising advantages over the prior art:

1. By using a compound having a band gap of 2.5 eV or more represented by the formula (1) or a preferred embodiment thereof as defined above in combination with a semiconducting light emitting nanoparticle, such as a quantum dot, which is in particular Cd-free, improved layer film homogeneity and morphology can be achieved. The electronic

devices according to the invention, in particular Cd-free devices, which contain a compound having a band gap of 2.5 eV or more represented by the formula (1) or a preferred embodiment thereof as defined above in combination with a semiconducting light emitting nanoparticle, such as a quantum dot, in particular in the emission layer, exhibit improved device performance, in particular reduced voltage, high efficiencies, longer lifetime and improved transport characteristics.

2. The formulations which contain a compound having a band gap of 2.5 eV or more, preferably a compound represented by the formula (1) or a preferred embodiment thereof as defined above in combination with a semiconducting light emitting nanoparticle, such as a quantum dot, which is in particular Cd-free, exhibit long-term stability, so that improved ink and film stability can be achieved.

3. The formulations which contain a compound having a band gap of 2.5 eV or more, preferably a compound represented by the formula (1) or a preferred embodiment thereof as defined above in combination with a semiconducting light emitting nanoparticle, such as a quantum dot, which is in particular Cd-free, exhibit excellent processability by inkjet printing and good wetting properties on a wide variety of substrates including transparent conductive oxides, hole injection materials, hole transporting materials, electron blocking, hole blocking, electron transporting and electron injecting materials. The formulation can be dried to form a smooth and continuous film with a homogenous composition and thickness.

The invention is explained in greater detail by the following examples, without wishing to restrict it thereby. On the basis of the descriptions, the person skilled in the art will be able to carry out the invention throughout the range disclosed and prepare further compounds according to the invention without inventive step and use them in electronic devices or use the process according to the invention.

**Examples:**

**Fabrication of solution processed OLED**

The production of solution-based OLEDs has already been described for example in WO 2004/037887 and WO 2010/097155. The process is adapted to the circumstances described below (layer-thickness variation, materials).
The inventive material combinations are used in the following layer sequence:

- substrate,
- ITO (50 nm),
- Hole injection layer HIL (20 nm),
- hole transport layer HTL (20 nm),
- emission layer (EML) (30 nm),
- electron-transport layer (ETL) (55 nm),
- electron injection layer (EIL) (2 nm),
- cathode (Al) (100 nm).

Glass plates coated with structured ITO (indium tin oxide) in a thickness of 50 nm serve as substrate. These are coated with the hole injection material (PEDOT) Clevios P VP AI 4083 (Heraeus Clevios GmbH, Leverkusen) by spin-coating in air. The layer is subsequently dried in air at 180°C for 10 minutes.
For the hole transport layer, the polymer (HTM) of the structure shown in Table 1 is used, which is synthesised in accordance with WO 2010/097155. The polymer is dissolved in toluene with a solid concentration of 5 g/l, in order to prepare a 20 nm thick layer. The layer is applied by spin-coating and dried at 220°C for 30 min. The deposition and drying are done under argon atmosphere.

Table 1: Structural formula of the material used for the solution processed HTL layer in OLEDs

| |
|---|
| 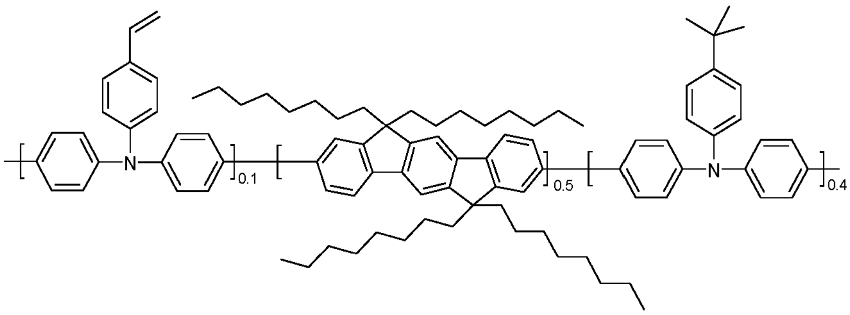 |
| HTM |

The emission layer is composed of a host material H (see the structures in Table 2) and the emitting material. The emitting material are InP/ZnS nanoparticles (quantum dots), which emit red light ($QD_{627}$; $PL_{max}$ 627 nm). The quantum dots are synthesized according to US 2017/0009134 A1, Example 3 for red QDs.

The solids are dissolved in toluene and the solid content of such a solution is 8.5 g/l, a layer thickness of 30nm is achieved by spin-coating. The layers are applied by spin-coating in an inert-gas atmosphere, and dried by heating at 120°C for 10min. The materials used to prepare the EML in the devices and the ratios of host material and quantum dots are shown in Table 3.

Table 2: Chemical structures of the organic host materials used for solution processed EML

| | |
|---|---|
| 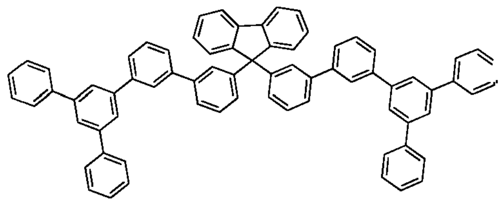 | 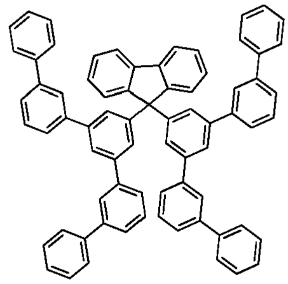 |
| H1 | H2 |
| 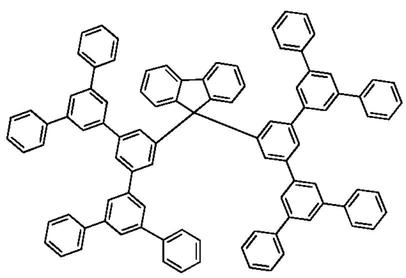 | |
| H3 | |

Table 3: EML compositions

| Experiment | EML | | |
|---|---|---|---|
| | QD | Host | Energy gap host (eV) |
| Ref | 100 wt-% | | |
| E1 | 75 wt-% | H1 (25%) | 4.43 |
| E2 | 50 wt-% | H1 (50%) | 4.43 |
| E3 | 60 wt-% | H2 (40%) | 4.35 |

(continued)

| Experiment | EML | | |
|---|---|---|---|
| | QD | Host | Energy gap host (eV) |
| E4 | 45 wt-% | H3 (55%) | 4.33 |

The materials for the electron-transport layer and the electron injection layer are likewise applied by thermal vapour deposition in a vacuum chamber and are shown in Table 4. The electron-transport layer is composed of the material ETM and the electron injection layer is composed of the material EIM. The cathode is formed by thermal evaporation of an aluminium layer with a thickness of 100 nm.

Table 4: Chemical structures of the materials used for thermally evaporatec layers in OLEDs

| | |
|---|---|
| 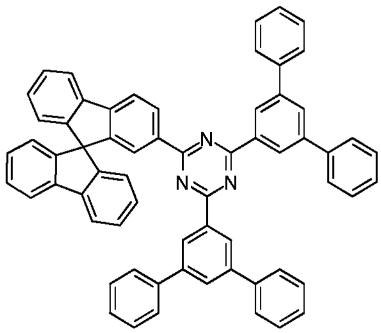 | 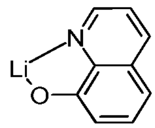 |
| ETM | EIM |

**Device characterization**

The OLEDs are characterised by standard methods. For this purpose, the electroluminescence spectra are recorded and the external quantum efficiencies (EQE, in percent) as a function of the luminous density assuming Lambert emission characteristics are calculated from current/voltage/luminous density characteristic lines (UIL characteristic lines). The electroluminescence (EL) spectra are recorded at a luminous density of 50 cd/m$^2$, and the CIE 1931 x and y colour coordinates are calculated from this data. The device data of the Quantumdot-OLEDs are summarized in Table 5.

Table 5: Device data of solution processed OLEDs

| ***Example*** | | ***Voltage @ 10mA/cm$^2$*** | ***EQE @10cd/m$^2$*** | ***CIE*** | | ***EL max*** |
|---|---|---|---|---|---|---|
| | | *V* | % | *X* | y | nm |
| T | Ref | 5.5 | 1.4 | 0.67 | 0.33 | 638 |
| a | E1 | 4.1 | 3.5 | 0.57 | 0.31 | 635 |
| b | E2 | 3.9 | 3.2 | 0.53 | 0.30 | 634 |
| I | E3 | 4.1 | 3.4 | 0.56 | 0.31 | 635 |
| e | E4 | 4.0 | 3.2 | 0.53 | 0.30 | 634 |

Table 5 shows that the use of wide-band-gap host materials H1 to H3 (E1 to E4), according to the present invention, give rise in efficiency while keeping the colour similar compared to the reference device (Ref) when used as matrix materials in red Quantumdot-OLED devices.

**Fabrication of inkjet printable solutions**

**Example 5**

A solution of red quantum dots synthesized according to US 170009134 A1 Example 2 in toluene was concentrated under reduced pressure to obtain 5 g of solid Quantum dots. To the solid, an identical amount (5 g) of

H1 is added and the combined solids are dissolved in a total of 500 ml of Cyclohexylbenzene to obtain an ink with the concentration of 20 g/l.

**Example 6**

A solution of red quantum dots synthesized according to US 170009134 A1 Example 3 in toluene was concentrated under reduced pressure to obtain 5 g of solid Quantum dots. To the solid, an identical amount (5 g) of H2 is added and the combined solids are dissolved in a total of 500 ml of 3,4-Dimethylanisole to obtain an ink with the concentration of 20 g/l.

**Example 7**

A solution of red quantum dots synthesized according to US 170009134 A1 Example 3 in toluene was concentrated under reduced pressure to obtain 5 g of solid Quantum dots. To the solid, an identical amount (5 g) of H2 is added and the combined solids are dissolved in a total of 500 ml of Cyclohexylbenzene/3,4-Dimethylanisole (50/50 V/V) to obtain an ink with the concentration of 20 g/l.

The jetting performance of the inks of Ex. 5-7 are tested with a Dimatix DMP-2831 printer with 10 pl cartridges. The ligament length and the voltage is recorded for different droplet speeds while keeping the pulse width and the pulse shape constant. Also the maximum drop ejection frequency with stable drop ejection and drop volume is recorded.

The inks of Ex. 5-7 have very good properties for inkjet printing, the high boiling point of the solvents prevents nozzle clogging and ensures formation of a homogenous and smooth film upon drying. Depending on the substrate, the target film thickness and printing pattern, additional solvents or additives can be added to improve wetting, levelling, flatness and film homogeneity.

**Claims**

**1.** Electronic device comprising anode, cathode and at least one layer which comprises the following compounds:

a) at least one semiconducting light emitting nanoparticle having a core-shell structure wherein, in the core-shell structure, an inorganic core is surrounded by one or more inorganic shell layers, optionally wherein the shell layers are over coated with one or more surface modifying ligands; and
b) at least one compound having a band gap, as measured by the method disclosed in the description, of 2.5 eV or more, preferably 3.0 eV or more, more preferably 3.5 eV or more, and very preferably 4.0 eV or more,

wherein the core of the semiconducting light emitting nanoparticle is a material selected from CdS, CdSe, CdTe, ZnS, ZnSe, ZnSeS, ZnTe, ZnO, GaAs, GaP, GaSb, HgS, HgSe, HgSe, HgTe, InAs, InP, InPS, InPZnS, InPZn, InPGa, InSb, AlAs, AlP, AlSb, $Cu_2S$, $Cu_2Se$, CuInS2, $CuInSe_2$, $Cu_2(ZnSn)S_4$, $Cu_2(InGa)S_4$, $TiO_2$ alloys, and a combination of any of these;
wherein the electronic device is selected from organic light-emitting transistors (OLETs), organic field-quench devices (OFQDs), organic laser diodes (O-lasers) and organic light emitting diodes (OLEDs); and wherein

the at least one compound having a band gap of 2.5 eV or more is represented by the formula (1):

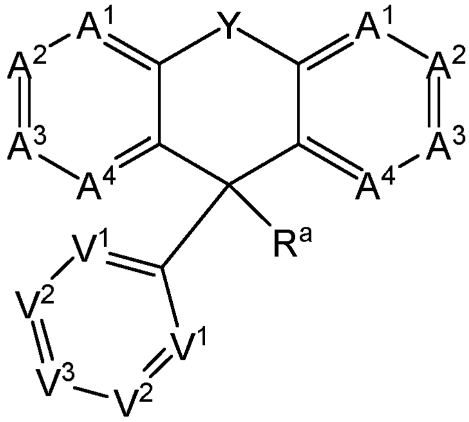

formula (1)

where the symbols used are as follows:

$A^1$, $A^2$, $A^3$, $A^4$ is, identically or different at each occurrence, N or $CR^1$, preferably $CR^1$, with the proviso that not more than two of the groups $A^1$, $A^2$, $A^3$, $A^4$ in one cycle are N; or two directly adjacent groups $A^1$, $A^2$, $A^3$, $A^4$ stand for a unit of the following formula (7)

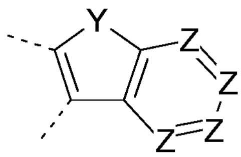

formula (7)

where the dashed bonds indicate the link of the unit to the adjacent C or N atoms;

Y is on each occurrence, identically or differently, a single bond or a group selected from $BR^1$, $C(R^1)_2$, C(=O), $C(=NR^1)$, $C(=C(R^1)_2)$, $Si(R^1)_2$, $NR^1$, $PR^1$, $P(=O)R^1$, O, S, S(=O), $S(=O)_2$, $C(R^1)_2$-$C(R^1)_2$, $C(R^1)_2$-$NR^1$ or $CR^1$=$CR^1$;

Z is on each occurrence, identically or differently, $CR^1$ or N, where a maximum of two groups Z in each cycle stand for N;

$V^1$, $V^2$, $V^3$ is, identically or different at each occurrence, N or $CR^2$, preferably $CR^2$, with the proviso that not more than three of the groups $V^1$, $V^2$, $V^3$ in one cycle are N;

$R^a$ is on each occurrence, identically or differently, H, D, F, Cl, Br, I, CHO, $N(R^3)_2$, $N(Ar)_2$, C(=O)Ar, P(=O)$(Ar)_2$, S(=O)Ar, $S(=O)_2Ar$, $CR^3$=$CR^3$Ar, CN, $NO_2$, $Si(R^3)_3$, $B(OR^3)_2$, $B(R^3)_2$, $B(N(R^3)_2)_2$, $OSO_2R^3$, a straight-chain alkyl, alkenyl, alkynyl, alkoxy or thioalkoxy group having 1 to 40 C atoms or a branched or cyclic alkyl, alkenyl, alkynyl, alkoxy or thioalkoxy group having 3 to 40 C atoms, each of which may be substituted by one or more radicals $R^3$, where one or more nonadjacent $CH_2$ groups may be replaced by $R^3C$=$CR^3$, C≡C, $Si(R^3)_2$, $Ge(R^3)_2$, $Sn(R^3)_2$, C=O, C=S, C=Se, C=$NR^3$, P(=O)$(R^3)$, SO, $SO_2$, $NR^3$, O, S or $CONR^3$ and where one or more H atoms may be replaced by F, Cl, Br, I, CN or $NO_2$, or an aromatic or heteroaromatic ring system having 5 to 60 aromatic ring atoms, which may in each case be substituted by one or more radicals $R^3$, or an aryloxy or heteroaryloxy group having 5 to 60 aromatic ring atoms, which may be substituted by one or more radicals $R^3$, or a combination of these systems; at the same time, one substituent $R^a$ and one adjacent group $V^1$, $V^2$, or $V^2$, preferably $V^1$ here may also be linked to one another by a single bond or a bridge selected from $B(R^3)$, $C(R^3)_2$, $Si(R^3)_2$, C=O, C=$NR^3$, C=$C(R^3)_2$, O, S, S=O, $SO_2$, $N(R^3)$, $P(R^3)$ and P(=O)$R^3$, preferably a single bond;

Ar is on each occurrence, identically or differently, an aromatic or heteroaromatic ring system having 5 to 30 aromatic ring atoms, which may be substituted by one or more non-aromatic radicals $R^5$; two radicals Ar here which are bonded to the same nitrogen or phosphorus atom may also be linked to one another by a single bond or a bridge selected from $B(R^6)$, $C(R^6)_2$, $Si(R^6)_2$, C=O, C=$NR^6$, C=$C(R^6)_2$, O, S, S=O, $SO_2$, $N(R^6)$, $P(R^6)$

and $P(=O)R^6$;

$R^1$ is, identically or different at each occurrence, H, D, F, Cl, Br, I, $B(OR^5)_2$, CHO, $C(=O)R^5$, $CR^5=C(R^5)_2$, CN, $C(=O)OR^5$, $C(=O)N(R^5)_2$, $Si(R^5)_3$, $N(R^5)_2$, $NO_2$, $P(=O)(R^5)_2$, $OSO_2R^5$, $OR^5$, $S(=O)R^5$, $S(=O)_2R^5$, a straight-chain alkyl, alkoxy or thioalkoxy group having 1 to 40 carbon atoms or a branched or cyclic alkyl, alkoxy or thioalkoxy group having 3 to 40 carbon atoms, each of which may be substituted by one or more $R^5$ radicals, where one or more nonadjacent $CH_2$ groups may be replaced by $-R^5C=CR^5-$, -C≡C-, $Si(R^5)_2$, $Ge(R^5)_2$, $Sn(R^5)_2$, C=O, C=S, C=Se, $C=NR^5$, -C(=O)O-, $-C(=O)NR^5-$, $NR^5$, $P(=O)(R^5)$, -O-, -S-, SO or $SO_2$ and where one or more hydrogen atoms may be replaced by D, F, Cl, Br, I, CN or $NO_2$, or an aromatic or heteroaromatic ring system which has 5 to 40 aromatic ring atoms and may be substituted in each case by one or more $R^5$ radicals, or an aryloxy or heteroaryloxy group which has 5 to 40 aromatic ring atoms and may be substituted by one or more $R^5$ radicals, or a combination of these systems; at the same time, it is also possible for two or more adjacent $R^1$ substituents together to form a mono- or polycyclic, aliphatic or aromatic ring system;

$R^2$, $R^3$ is, identically or different at each occurrence, H, D, F, Cl, Br, I, $B(OR^4)_2$, CHO, $C(=O)R^4$, $CR^4=C(R^4)_2$, CN, $C(=O)OR^4$, $C(=O)N(R^4)_2$, $Si(R^4)_3$, $N(R^4)_2$, $NO_2$, $P(=O)(R^4)_2$, $OSO_2R^4$, $OR^4$, $S(=O)R^4$, $S(=O)_2R^4$, a straight-chain alkyl, alkoxy or thioalkoxy group having 1 to 40 carbon atoms or a branched or cyclic alkyl, alkoxy or thioalkoxy group having 3 to 40 carbon atoms, each of which may be substituted by one or more $R^4$ radicals, where one or more nonadjacent $CH_2$ groups may be replaced by $-R^4C=CR^4-$, -C≡C-, $Si(R^4)_2$, $Ge(R^4)_2$, $Sn(R^4)_2$, C=O, C=S, C=Se, $C=NR^4$, -C(=O)O-, $-C(=O)NR^4-$, $NR^4$, $P(=O)(R^4)$, -O-, -S-, SO or $SO_2$ and where one or more hydrogen atoms may be replaced by D, F, Cl, Br, I, CN or $NO_2$, or an aromatic or heteroaromatic ring system which has 5 to 40 aromatic ring atoms and may be substituted in each case by one or more $R^4$ radicals, or an aryloxy or heteroaryloxy group which has 5 to 40 aromatic ring atoms and may be substituted by one or more $R^4$ radicals, or a combination of these systems; at the same time, it is also possible for two or more adjacent $R^2$ substituents together to form a mono- or polycyclic, aliphatic or aromatic ring system; at the same time, it is also possible for two or more adjacent $R^3$ substituents together to form a mono- or polycyclic, aliphatic or aromatic ring system;

$R^4$, $R^5$ is, identically or different at each occurrence, H, D, F, Cl, Br, I, $B(OR^6)_2$, CHO, $C(=O)R^6$, $CR^6=C(R^6)_2$, CN, $C(=O)OR^6$, $C(=O)N(R^6)_2$, $Si(R^6)_3$, $N(R^6)_2$, $NO_2$, $P(=O)(R^6)_2$, $OSO_2R^6$, $OR^6$, $S(=O)R^6$, $S(=O)_2R^6$, a straight-chain alkyl, alkoxy or thioalkoxy group having 1 to 40 carbon atoms or a branched or cyclic alkyl, alkoxy or thioalkoxy group having 3 to 40 carbon atoms, each of which may be substituted by one or more $R^6$ radicals, where one or more nonadjacent $CH_2$ groups may be replaced by $-R^6C=CR^6-$, -C≡C-, $Si(R^6)_2$, $Ge(R^6)_2$, $Sn(R^6)_2$, C=O, C=S, C=Se, $C=NR^6$, -C(=O)O-, $-C(=O)NR^6-$, $NR^6$, $P(=O)(R^6)$, -O-, -S-, SO or $SO_2$ and where one or more hydrogen atoms may be replaced by D, F, Cl, Br, I, CN or $NO_2$, or an aromatic or heteroaromatic ring system which has 5 to 40 aromatic ring atoms and may be substituted in each case by one or more $R^6$ radicals, or an aryloxy or heteroaryloxy group which has 5 to 40 aromatic ring atoms and may be substituted by one or more $R^6$ radicals, or a combination of these systems; at the same time, it is also possible for two or more adjacent $R^4$ substituents together to form a mono- or polycyclic, aliphatic or aromatic ring system; at the same time, it is also possible for two or more adjacent $R^5$ substituents together to form a mono- or polycyclic, aliphatic or aromatic ring system and

$R^6$ is, identically or different at each occurrence, H, D, F or an aliphatic, aromatic and/or heteroaromatic hydrocarbyl radical having 1 to 20 carbon atoms, in which hydrogen atoms may also be replaced by F; at the same time, it is also possible for two or more adjacent $R^6$ substituents together to form a mono- or polycyclic, aliphatic or aromatic ring system.

2. Electronic device according to claim 1, **characterized in that** the at least one compound has a molecular weight of not more than 5000 g/mol, preferably not more than 4000 g/mol, particularly preferably not more than 3000 g/mol, especially preferably not more than 2000 g/mol and most preferably not more than 1000 g/mol.

3. Electronic device according to claim 1 or 2, **characterized in that** the at least one compound is represented by the formula (2), (3), (4), (5), (6), (8) or (9)

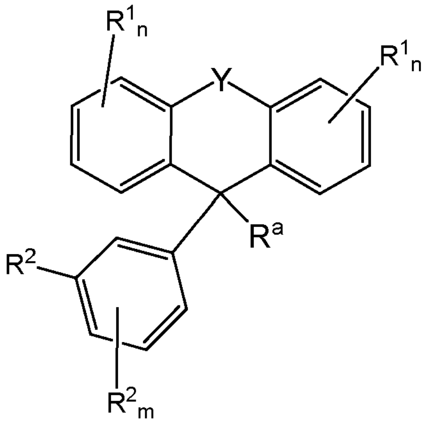

formula (2)

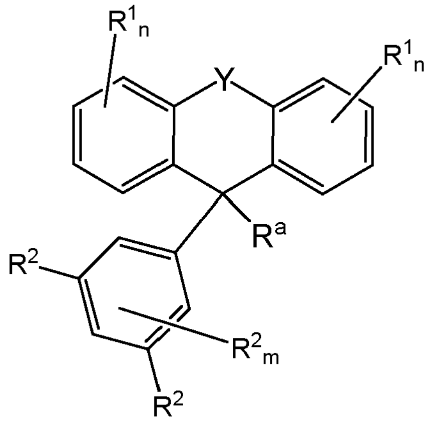

formula (3)

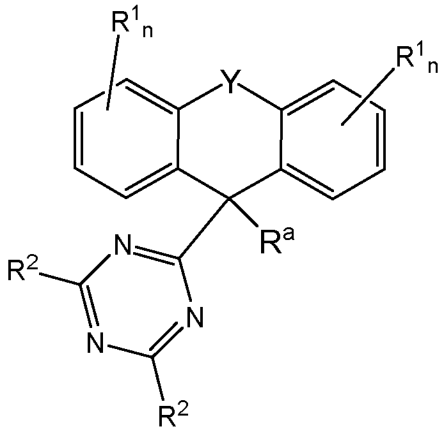

formula (4)

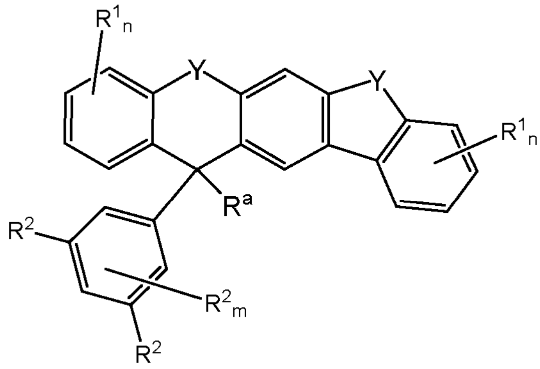

formula (5)

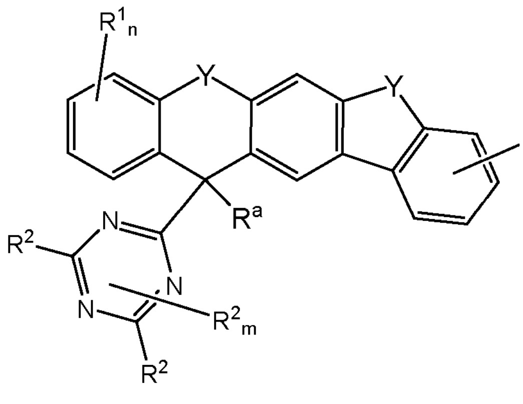

formula (6)

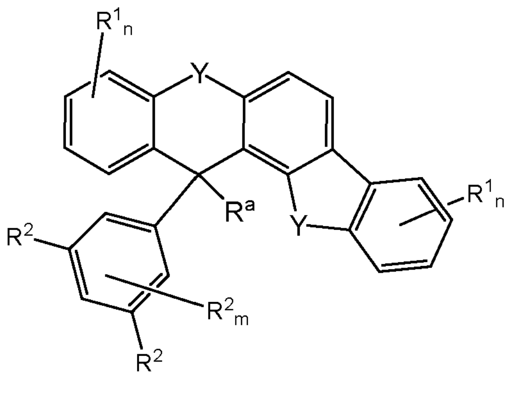

formula (8)

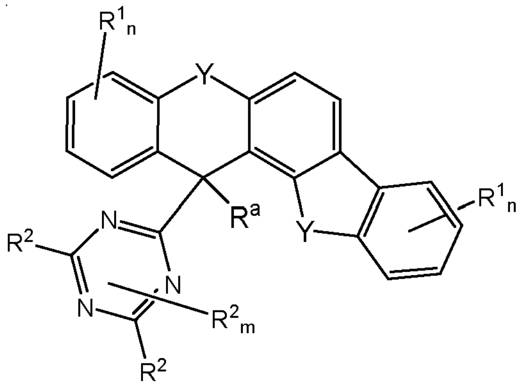

formula (9)

where the symbols used are as defined in claim 1, m is 0 or 1, and each n is independently 0, 1, 2, 3 or 4, preferably 0, 1 or 2.

4. Electronic device according to one or more of claims 1 to 3, **characterized in that** the symbol Y is, identically or different at each occurrence, a single bond or a group selected from $C(R^1)_2$, O or $NR^1$.

5. Electronic device according to one or more of claims 1 to 4, **characterized in that** the at least one compound is represented by the formula (2a), (3a), (4a), (5a), (5b), (6a), (6b), (8a), (8b), (9a) or (9b)

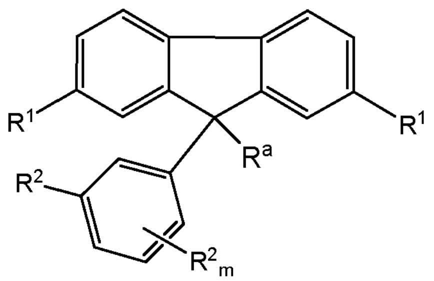

formula (2a)

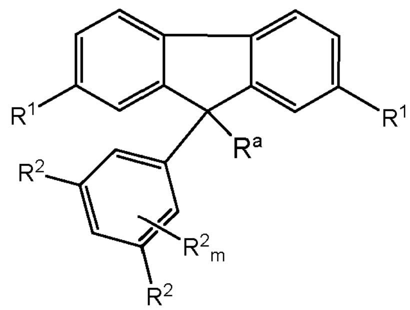

formula (3a)

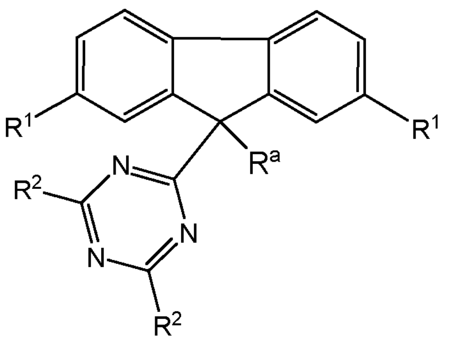

formula (4a)

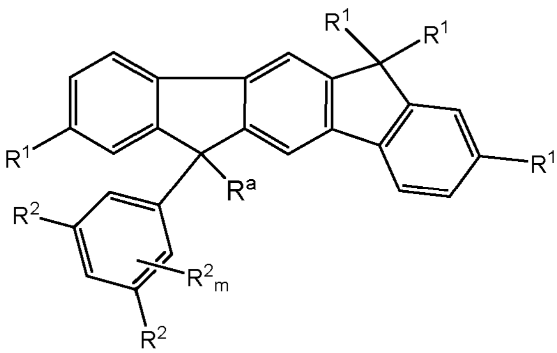

formula (5a)

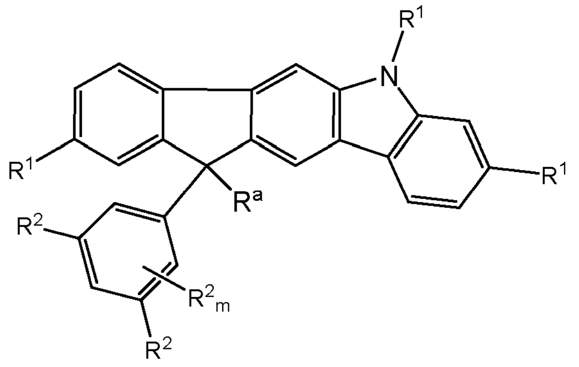

formula (5b)

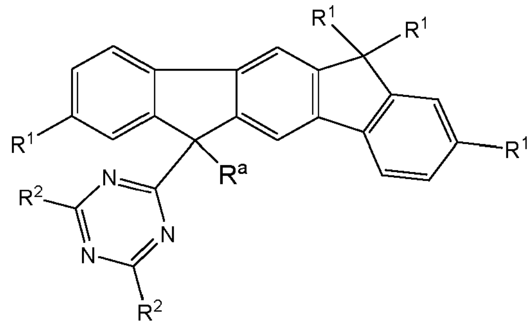

formula (6a)

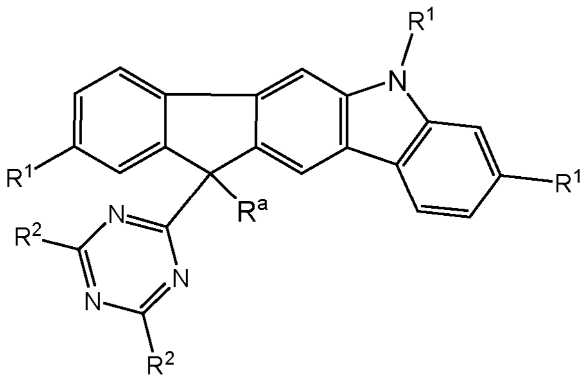

formula (6b)

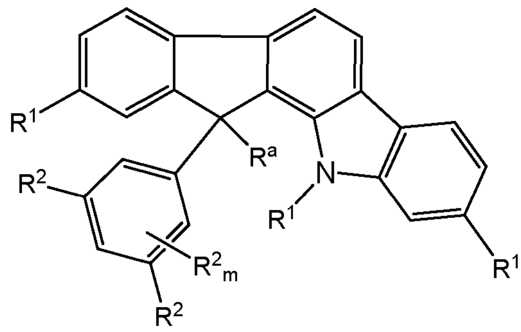

formula (8a)

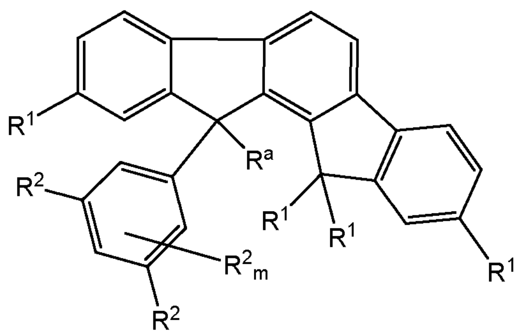

formula (8b)

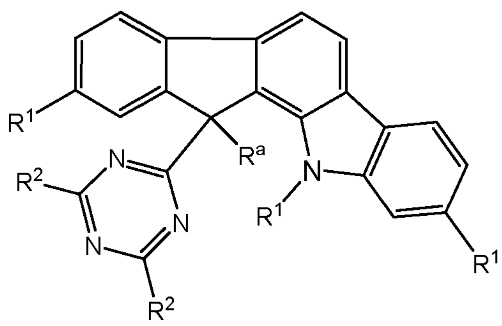

formula (9a)

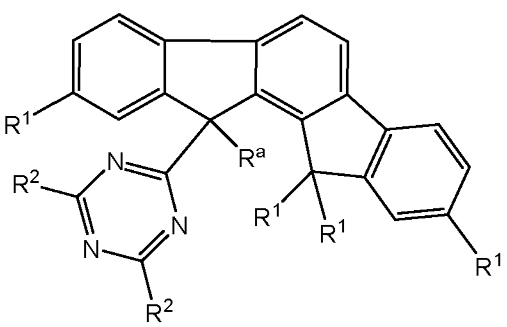

formula (9b)

where the symbols used are as defined in claim 1 and m is 0 or 1.

**6.** Electronic device according to one or more of claims 1 to 5, **characterized in that** the at least one compound is represented by the formula (10), (11) or (12)

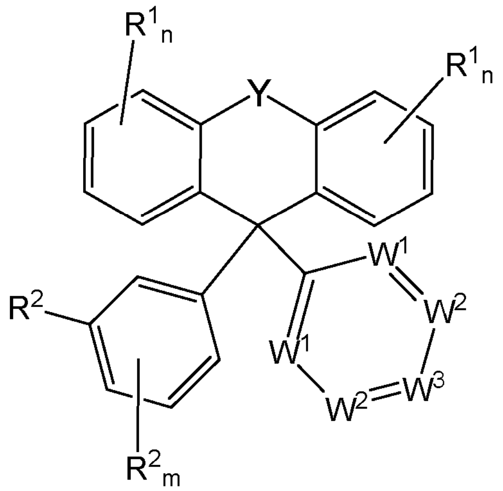

formula (10)

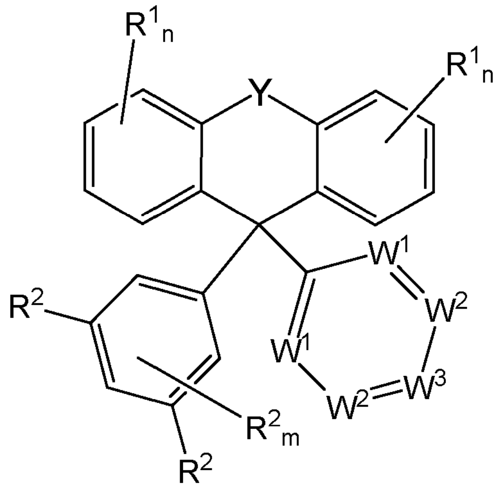

formula (11)

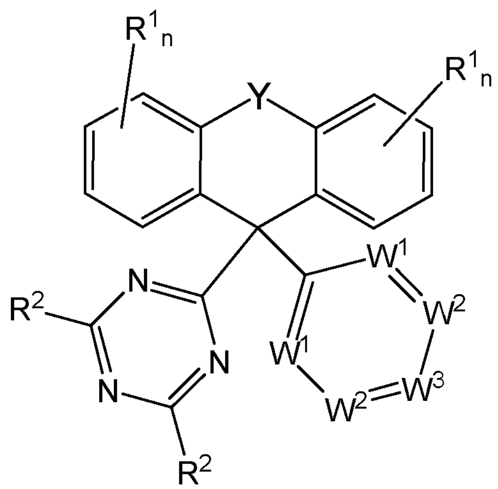

formula (12)

where $W^1$, $W^2$, $W^3$ is, identically or different at each occurrence, N or $CR^3$, preferably $CR^3$, with the proviso that not more than three of the groups $W^1$, $W^2$, $W^3$ in one cycle are N; and where the symbols $R^1$, $R^2$, $R^3$ and Y are as defined in claim 1, m is 0 or 1, and each n is independently 0, 1, 2, 3 or 4, preferably 0, 1 or 2.

**7.** Electronic device according to one or more of claims 1 to 6, **characterized in that** the at least one compound is represented by the formula (13), (14), (15), (16), (17), (18), (19), (20), (21), (22), (23) or (24)

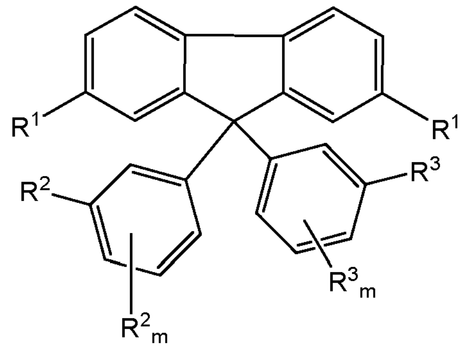

formula (13)

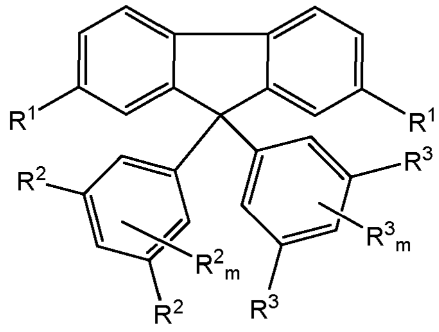

formula (14)

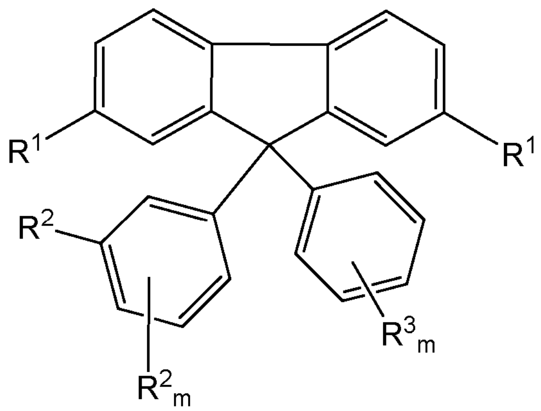

formula (15)

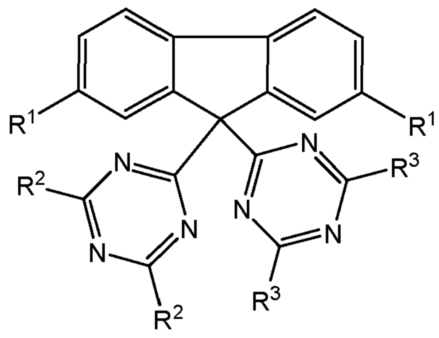

formula (16)

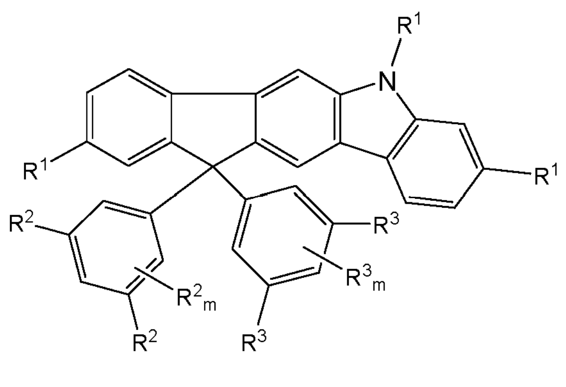

formula (17)

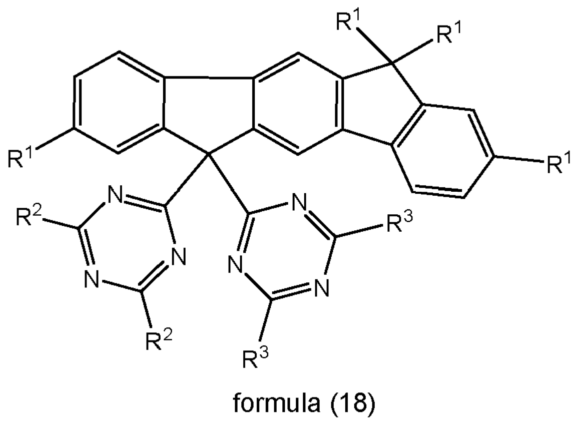

formula (18)

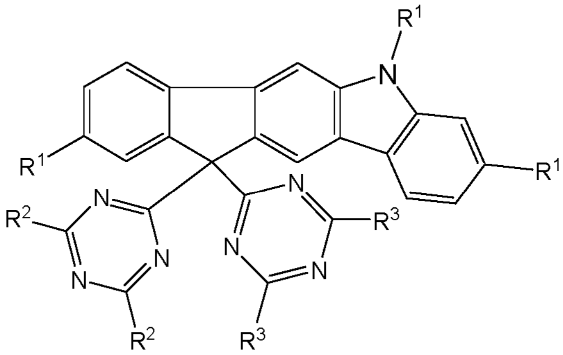

formula (19)

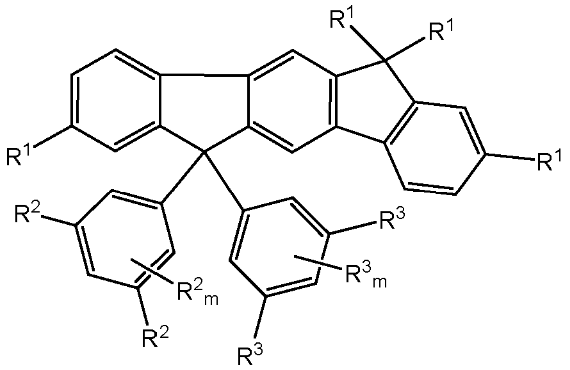

formula (20)

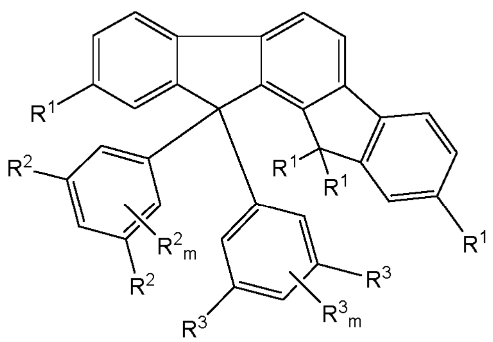

formula (21)

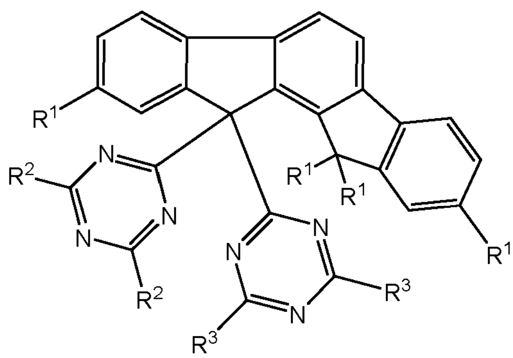

formula (22)

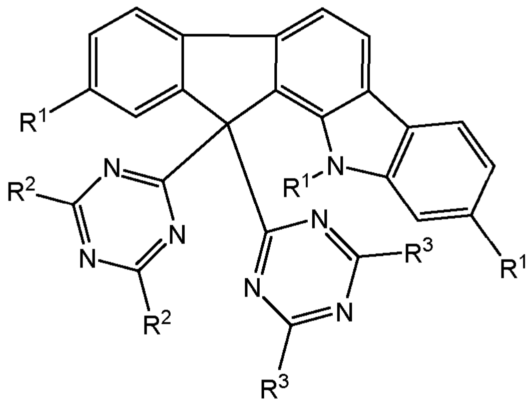

formula (23)

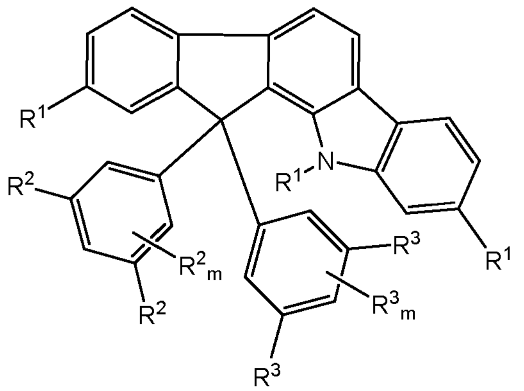

formula (24)

where the symbols $R^1$, $R^2$ and $R^3$ are as defined in claim 1 and each m is independently 0 or 1, where the total sum of the indices m is not more than 1.

8. Electronic device according to one or more of claims 1 to 7, **characterized in that** radicals $R^2$, $R^3$ are, identically or differently on each occurrence, $N(Ar)_2$, C(=O)Ar, $P(=O)Ar_2$ or an aromatic or heteroaromatic ring system having 5 to 30 aromatic ring atoms, which may be substituted by one or more non-aromatic radicals $R^4$.

9. Electronic device according to one or more of claims 1 to 8, **characterized in that** the at least one compound is represented by the formula (27), (28), (29), (30) or (31)

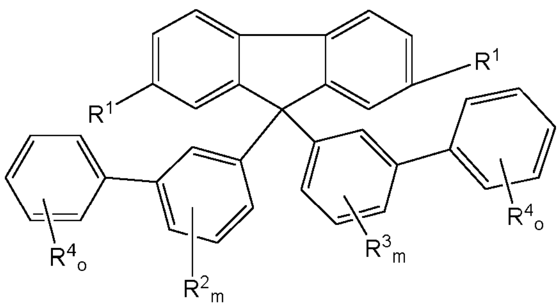

formula (27)

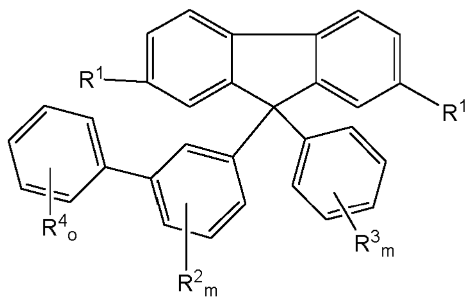

formula (28)

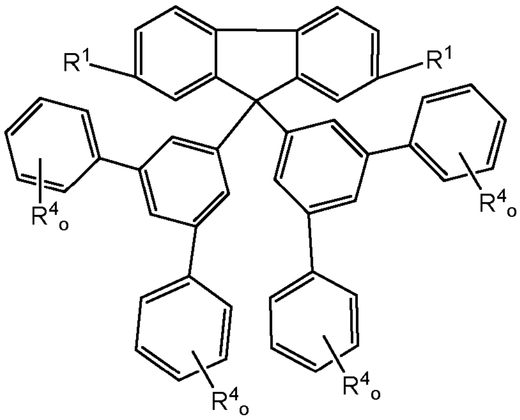

formula (29)

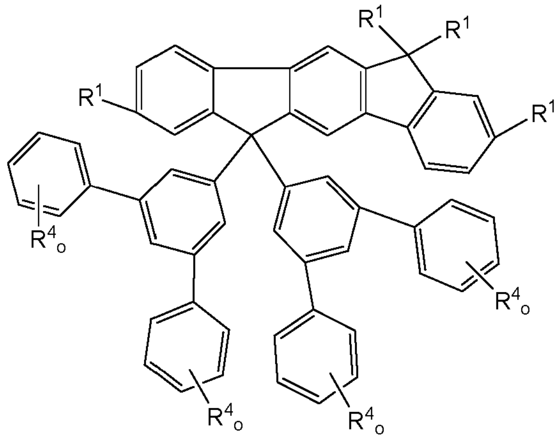

formula (30)

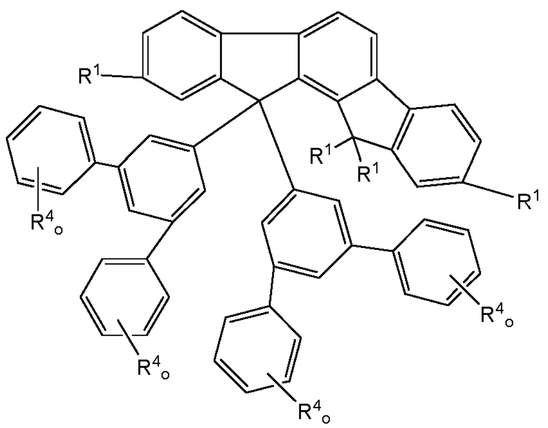

formula (31)

where the symbols $R^1$, $R^2$, $R^3$ and $R^4$ are as defined in claim 1, and each m is independently 0 or 1, where the total sum of the indices m is not more than 1, and each o is independently 0, 1, 2, 3, 4 or 5, preferably 1, 2 or 3.

**10.** Electronic device according to one or more of claims 1 to 9, **characterized in that** the at least one compound has a total of not more than 5 nitrogen atoms, preferably a total of not more than 3 nitrogen atoms, more preferably a total of not more than 5 heteroatoms, preferably a total of not more than 3 heteroatoms, apart from fluorine.

**11.** Electronic device according to one or more of claims 1 to 10, **characterized in that** the at least one semiconducting light emitting nanoparticle is selected from quantumsized light emitting materials, in particular from quantum dots and quantum rods.

**12.** Electronic device according to one or more of claims 1 to 11, **characterized in that** the at least one semiconducting

light emitting nanoparticle is Cd-free.

**13.** Electronic device according to one or more of claims 1 to 12, wherein the electronic device is an organic light emitting diode (OLED).

**14.** Electronic device according to one or more of claims 1 to 13, **characterized in that** the at least one layer is an emitting layer.

**15.** Method for preparing an electronic device according to one or more of claims 1 to 14, **characterized in that** at least one layer, preferably the at least one layer which comprises the at least one semiconducting light emitting nanoparticle and the at least one compound having a band gap of 2.5 eV or more represented by the formula (1), is coated by a sublimation method and/or is coated by an OVPD method or by means of a carrier gas sublimation and/or is applied from solution by spin-coating or by a printing method.

**Patentansprüche**

**1.** Elektronische Vorrichtung, umfassend Anode, Kathode und zumindest eine Schicht, welche die folgenden Verbindungen umfasst:

a) zumindest einem halbleitenden lichtemittierenden Nanopartikel mit einer Kern-Hülle-Struktur, wobei in der Kern-Hülle-Struktur ein anorganischer Kern durch eine oder mehrere anorganische Hüllschichten umgeben ist, wobei die Hüllschichten optional mit einem oder mehreren oberflächenmodifizierenden Liganden beschichtet sind; und

b) zumindest eine Verbindung mit einer Bandlücke, wie gemessen nach dem in der Beschreibung offenbarten Verfahren, von 2,5 eV oder mehr, bevorzugt 3,0 eV oder mehr, bevorzugter 3,5 eV oder mehr und besonders bevorzugt 4,0 eV oder mehr, wobei der Kern des halbleitenden lichtemittierenden Nanopartikels ein Material ist, ausgewählt aus Legierungen von CdS, CdSe, CdTe, ZnS, ZnSe, ZnSeS, ZnTe, ZnO, GaAs, GaP, GaSb, HgS, HgSe, HgSe, HgTe, InAs, InP, InPS, InPZnS, InPZn, InPGa, InSb, AlAs, AlP, AlSb, $Cu_2S$, $Cu_2Se$, CuInS2, $CuInSe_2$, $Cu_2(ZnSn)S_4$, $Cu_2(InGa)S_4$, $TiO_2$ und eine Kombination aus diesen;

wobei die elektronische Vorrichtung ausgewählt ist aus organischen lichtemittierenden Transistoren (OLETs), organischen Feldlöschvorrichtungen (OFQDs), organischen Laserdioden (O-Lasern) und organischen lichtemittierenden Dioden (OLEDs); und wobei

die zumindest eine Verbindung mit einer Bandlücke von 2,5 eV oder mehr dargestellt ist durch die Formel (1):

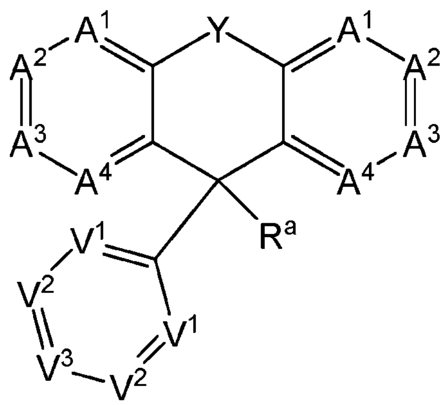

Formel (1)

wo die Symbole wie folgt verwendet werden:

$A^1$, $A^2$, $A^3$, $A^4$ bei jedem Auftreten, identisch oder unterschiedlich, N oder $CR^1$ ist,

bevorzugt $CR^1$, mit der Maßgabe, dass nicht mehr als zwei der Gruppen $A^1$, $A^2$, $A^3$, $A^4$ in einem Zyklus N sind; oder zwei direkt benachbarte Gruppen $A^1$, $A^2$, $A^3$, $A^4$ für eine Einheit der folgenden Formel (7) stehen

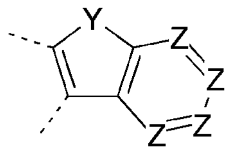

Formel (7)

wo die gestrichelten Bindungen die Verbindung der Einheit mit den benachbarten C- oder N-Atomen angeben;

Y bei jedem Auftreten, identisch oder unterschiedlich, eine Einzelbindung oder eine Gruppe ist, ausgewählt aus $BR^1$, $C(R^1)_2$, C(=O), $C(=NR^1)$, $C(=C(R^1)_2)$, $Si(R^1)_2$, $NR^1$, $PR^1$, $P(=O)R^1$, O, S, S(=O), $S(=O)_2$, $C(R^1)_2$-$C(R^1)_2$, $C(R^1)_2$-$NR^1$ oder $CR^1$=$CR^1$;

Z bei jedem Auftreten, identisch oder unterschiedlich, $CR^1$ oder N ist, wo maximal zwei Gruppen Z in jedem Zyklus für N stehen;

$V^1$, $V^2$, $V^3$ bei jedem Auftreten, identisch oder unterschiedlich, N oder $CR^2$ ist, bevorzugt $CR^2$, mit der Maßgabe, dass nicht mehr als drei der Gruppen $V^1$, $V^2$, $V^3$ in einem Zyklus N sind;

$R^a$ bei jedem Auftreten, identisch oder unterschiedlich, H, D, F, Cl, Br, I, CHO, $N(R^3)_2$, $N(Ar)_2$, C(=O)Ar, $P(=O)(Ar)_2$, S(=O)Ar, $S(=O)_2Ar$, $CR^3$=$CR^3$Ar, CN, $NO_2$, $Si(R^3)_3$, $B(OR^3)_2$, $B(R^3)_2$, $B(N(R^3)_2)_2$, $OSO_2R^3$, eine geradkettige Alkyl-, Alkenyl-, Alkinyl-, Alkoxy- oder Thioalkoxygruppe mit 1 bis 40 C-Atomen oder eine verzweigte oder cyclische Alkyl-, Alkenyl-, Alkinyl-, Alkoxy- oder Thioalkoxygruppe mit 3 bis 40 C-Atomen, welche jeweils substituiert sein können durch ein oder mehrere Radikale $R^3$, wo eine oder mehrere nicht benachbarte $CH_2$-Gruppen ersetzt sein können durch $R^3C$=$CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S oder $CONR^3$ und wo ein oder mehrere H-Atome ersetzt sein können durch F, Cl, Br, I, CN oder $NO_2$, oder ein aromatisches oder heteroaromatisches Ringsystem mit 5 bis 60 aromatischen Ringatomen, welche in jedem Fall substituiert sein können durch ein oder mehrere Radikale $R^3$, oder eine Aryloxy- oder Heteroaryloxygruppe mit 5 bis 60 aromatischen Ringatomen, welche durch ein oder mehrere Radikale $R^3$ substituiert sein können, oder eine Kombination dieser Systeme ist; gleichzeitig können auch ein Substituent $R^a$ und eine benachbarte Gruppe $V^1$, $V^2$ oder $V^3$, bevorzugt $V^1$, durch eine Einfachbindung oder eine Brücke verbunden sein, ausgewählt aus $B(R^3)$, $C(R^3)_2$, $Si(R^3)_2$, C=O, $C=NR^3$, $C=C(R^3)_2$, O, S, S=O, $SO_2$, $N(R^3)$, $P(R^3)$ und $P(=O)R^3$, bevorzugt eine Einfachbindung;

Ar bei jedem Auftreten, identisch oder unterschiedlich, ein aromatisches oder heteroaromatisches Ringsystem mit 5 bis 30 aromatischen Ringatomen ist, welche durch ein oder mehrere nicht-aromatische Radikale $R^5$ substituiert sein können; wobei zwei Radikale Ar hier, welche an dasselbe Stickstoff- oder Phosphoratom gebunden sind, auch durch eine Einfachbindung oder eine Brücke miteinander verbunden sein können, ausgewählt aus $B(R^6)$, $C(R^6)_2$, $Si(R^6)_2$, C=O, $C=NR^6$, $C=C(R^6)_2$, O, S, S=O, $SO_2$, $N(R^6)$, $P(R^6)$ und $P(=O)R^6$;

$R^1$ bei jedem Auftreten, identisch oder unterschiedlich, H, D, F, Cl, Br, I, $B(OR^5)_2$, CHO, $C(=O)R^5$, $CR^5$=$C(R^5)_2$, CN, $C(=O)OR^5$, $C(=O)N(R^5)_2$, $Si(R^5)_3$, $N(R^5)_2$, $NO_2$, $P(=O)(R^5)_2$, $OSO_2R^5$, $OR^5$, $S(=O)R^5$, $S(=O)_2R^5$, eine geradkettige Alkyl-, Alkoxy- oder Thioalkoxygruppe mit 1 bis 40 Kohlenstoffatomen oder eine verzweigte oder cyclische Alkyl-, Alkoxy- oder Thioalkoxygruppe mit 3 bis 40 Kohlenstoffatomen, welches jeweils substituiert sein kann durch ein oder mehrere $R^5$-Radikale, wo eine oder mehrere nicht benachbarte $CH_2$ -Gruppen ersetzt sein können durch - $R^5C$=$CR^5$-, -C≡C-, $Si(R^5)_2$, $G_e(R^5)_2$, $Sn(R^5)_2$, C=O, C=S, C=Se, $C=NR^5$, -C(=O)O-, -$C(=O)NR^5$-, $NR^5$, $P(=O)(R^5)$, -O-, -S-, SO oder $SO_2$ und wo ein oder mehrere Wasserstoffatome ersetzt sein können durch D, F, Cl, Br, I, CN oder $NO_2$, oder ein aromatisches oder heteroaromatisches Ringsystem, welches 5 bis 40 aromatische Ringatome aufweist und in jedem Fall substituiert sein kann durch ein oder mehrere $R^5$-Radikale, oder eine Aryloxy- oder Heteroaryloxygruppe, welche 5 bis 40 aromatische Ringatome aufweist und substituiert sein kann durch ein oder mehrere $R^5$-Radikale, oder eine Kombination dieser Systeme ist; gleichzeitig ist es auch für zwei oder mehr benachbarte $R^1$-Substituenten möglich, zusammen ein mono- oder polycyclisches, aliphatisches oder aromatisches Ringsystem zu bilden;

$R^2$, $R^3$ bei jedem Auftreten, identisch oder unterschiedlich, H, D, F, Cl, Br, I, $B(OR^4)_2$, CHO, $C(=O)R^4$, $CR^4$=$C(R^4)_2$, CN, $C(=O)OR^4$, $C(=O)N(R^4)_2$, $Si(R^4)_3$, $N(R^4)_2$, $NO_2$, $P(=O)(R^4)_2$, $OSO_2R^4$, $OR^4$, $S(=O)R^4$, $S(=O)_2R^4$, eine geradkettige Alkyl-, Alkoxy- oder Thioalkoxygruppe mit 1 bis 40 Kohlenstoffatomen oder eine verzweigte oder cyclische Alkyl-, Alkoxy- oder Thioalkoxygruppe mit 3 bis 40 Kohlenstoffatomen ist, welche jeweils substituiert sein können durch ein oder mehrere $R^4$-Radikale, wo ein oder mehrere nicht benachbarte $CH_2$-Gruppen ersetzt sein können durch -$R^4C$=$CR^4$-, -C≡C-, $Si(R^4)_2$, $Ge(R^4)_2$, $Sn(R^4)_2$, C=O, C=S, C=Se, $C=NR^4$, - C(=O)O-, -$C(=O)NR^4$-, $NR^4$, $P(=O)(R^4)$, -O-, -S-, SO oder $SO_2$ und wo ein oder mehrere

Wasserstoffatome ersetzt sein können durch D, F, Cl, Br, I, CN oder $NO_2$, oder ein aromatisches oder heteroaromatisches Ringsystem, welches 5 bis 40 aromatische Ringatome aufweist und in jedem Fall substituiert sein kann durch ein oder mehrere $R^4$-Radikale, oder eine Aryloxy- oder Heteroaryloxygruppe, welche 5 bis 40 aromatische Ringatome aufweist und substituiert sein kann durch ein oder mehrere $R^4$-Radikale, oder eine Kombination dieser Systeme ist; gleichzeitig ist es auch für zwei oder mehr benachbarte $R^2$-Substituenten möglich, zusammen ein mono- oder polycyclisches, aliphatisches oder aromatisches Ringsystem zu bilden; gleichzeitig ist es auch für zwei oder mehr benachbarte $R^3$-Substituenten möglich, zusammen ein mono- oder polycyclisches, aliphatisches oder aromatisches Ringsystem zu bilden;

$R^4$, $R^5$ bei jedem Auftreten, identisch oder unterschiedlich, H, D, F, Cl, Br, I, $B(OR^6)_2$, CHO, $C(=O)R^6$, $CR^6=C(R^6)_2$, CN, $C(=O)OR^6$, $C(=O)N(R^6)_2$, $Si(R^6)_3$, $N(R^6)_2$, $NO_2$, $P(=O)(R^6)_2$, $OSO_2R^6$, $OR^6$, $S(=O)R^6$, $S(=O)_2R^6$, eine geradkettige Alkyl-, Alkoxy- oder Thioalkoxygruppe mit 1 bis 40 Kohlenstoffatomen oder eine verzweigte oder cyclische Alkyl-, Alkoxy- oder Thioalkoxygruppe mit 3 bis 40 Kohlenstoffatomen ist, welche jeweils substituiert sein können durch ein oder mehrere $R^6$-Radikale, wo eine oder mehrere nicht benachbarte $CH_2$-Gruppen ersetzt sein können durch $-R^6C=CR^6-$, -C≡C-, $Si(R^6)_2$, $Ge(R^6)_2$, $Sn(R^6)_2$, C=O, C=S, C=Se, $C=NR^6$, - C(=O)O-, $-C(=O)NR^6-$, $NR^6$, $P(=O)(R^6)$, -O-, -S-, SO oder $SO_2$ und wo ein oder mehrere Wasserstoffatome ersetzt sein können durch D, F, Cl, Br, I, CN oder $NO_2$, oder ein aromatisches oder heteroaromatisches Ringsystem, welches 5 bis 40 aromatische Ringatome aufweist und in jedem Fall substituiert sein kann durch ein oder mehrere $R^6$-Radikale, oder eine Aryloxy- oder Heteroaryloxygruppe, welche 5 bis 40 aromatische Ringatome aufweist und substituiert sein kann durch ein oder mehrere $R^6$-Radikale, oder eine Kombination dieser Systeme; gleichzeitig ist es auch für zwei oder mehr benachbarte $R^4$-Substituenten möglich, zusammen ein mono- oder polycyclisches, aliphatisches oder aromatisches Ringsystem zu bilden; gleichzeitig ist es auch für zwei oder mehr benachbarte $R^5$-Substituenten möglich, zusammen ein mono- oder polycyclisches, aliphatisches oder aromatisches Ringsystem zu bilden und

$R^6$ bei jedem Vorkommen, identisch oder unterschiedlich, H, D, F oder ein aliphatisches, aromatisches und/oder heteroaromatisches Kohlenwasserstoffradikal mit 1 bis 20 Kohlenstoffatomen ist, in welchem auch Wasserstoffatome ersetzt sein können durch F; gleichzeitig ist es auch für zwei oder mehr benachbarte $R^6$-Substituenten möglich, zusammen ein mono- oder polycyclisches, aliphatisches oder aromatisches Ringsystem zu bilden.

2. Elektronische Vorrichtung gemäß Anspruch 1, **dadurch gekennzeichnet, dass** die zumindest eine Verbindung ein Molekulargewicht von höchstens 5000 g/mol, bevorzugt höchstens 4000 g/mol, besonders bevorzugt höchstens 3000 g/mol, insbesondere bevorzugt höchstens 2000 g/mol und am bevorzugtesten höchstens 1000 g/mol aufweist.

3. Elektronische Vorrichtung gemäß Anspruch 1 oder 2, **dadurch gekennzeichnet, dass** die zumindest eine Verbindung dargestellt ist durch die Formel (2), (3), (4), (5), (6), (8) oder (9)

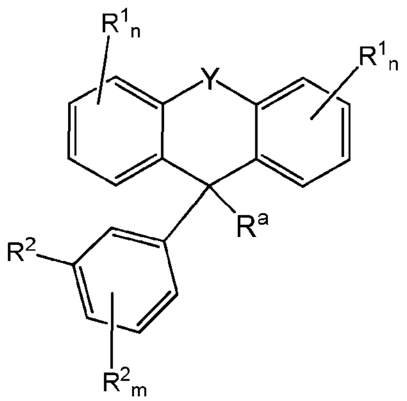

Formel (2)

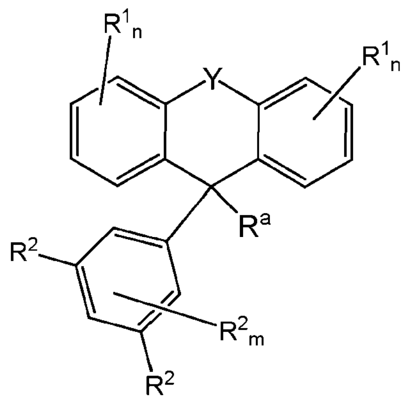

Formel (3)

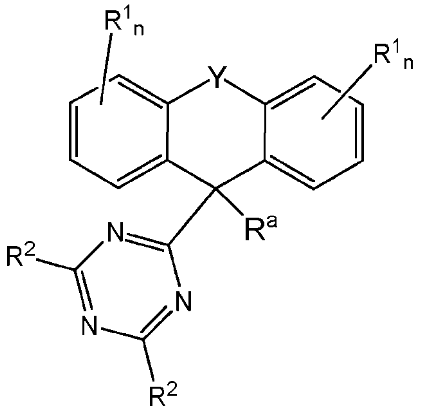

Formel (4)

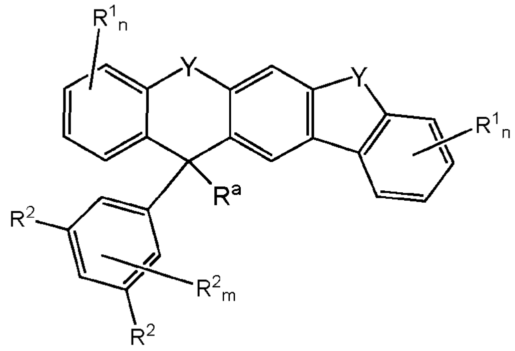

Formel (5)

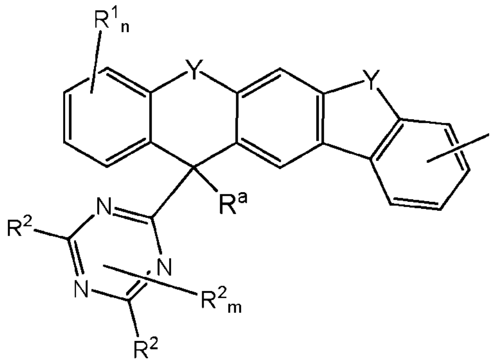

Formel (6)

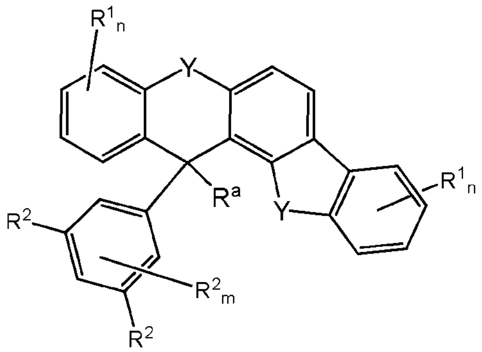

Formel (8)

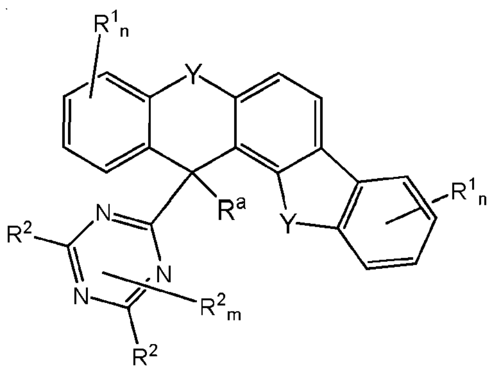

Formel (9)

wo die verwendeten Symbole wie in Anspruch 1 definiert sind, m 0 oder 1 ist und n jeweils unabhängig 0, 1, 2, 3 oder 4, bevorzugt 0, 1 oder 2 ist.

4. Elektronische Vorrichtung gemäß einem oder mehreren der Ansprüche 1 bis 3, **dadurch gekennzeichnet, dass** das Symbol Y bei jedem Auftreten, identisch oder unterschiedlich, eine Einfachbindung oder eine Gruppe ist, ausgewählt aus $C(R^1)_2$, O oder $NR^1$.

5. Elektronische Vorrichtung gemäß einem oder mehreren der Ansprüche 1 bis 4, **dadurch gekennzeichnet, dass** die zumindest eine Verbindung dargestellt ist durch die Formel (2a), (3a), (4a), (5a), (5b), (6a), (6b), (8a), (8b), (9a) oder (9b)

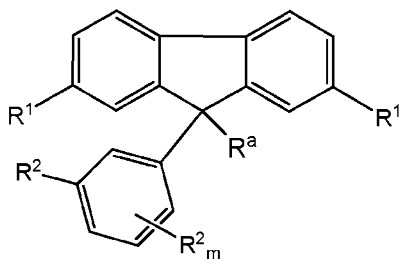

Formel (2a)

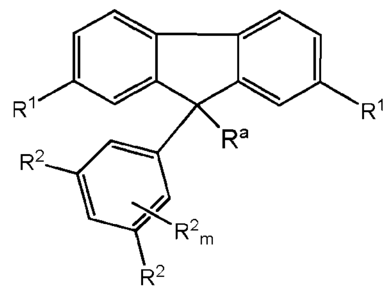

Formel (3a)

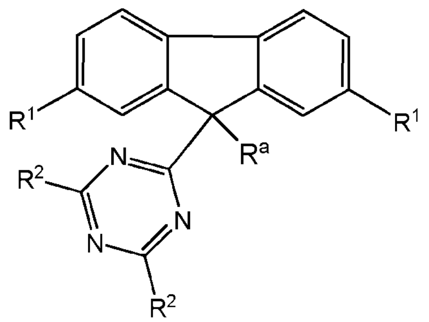

Formel (4a)

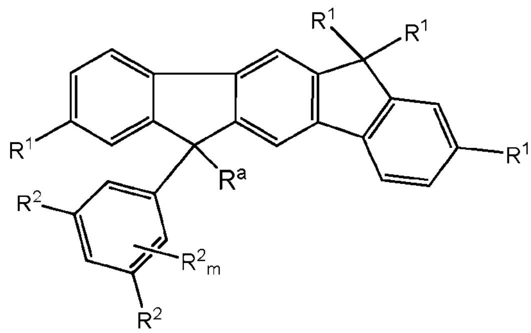

Formel (5a)

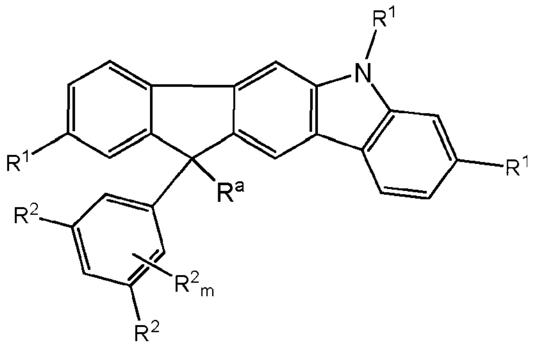

Formel (5b)

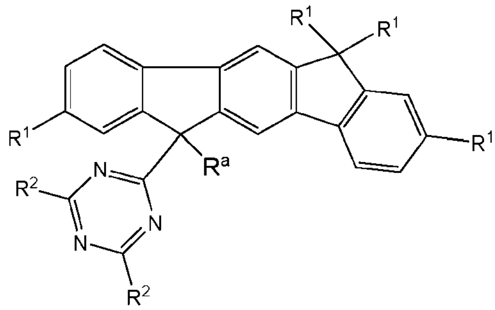

Formel (6a)

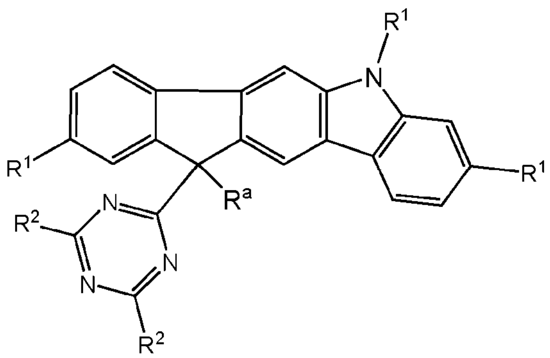

Formel (6b)

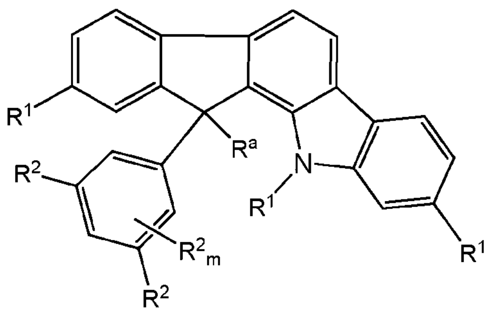

Formel (8a)

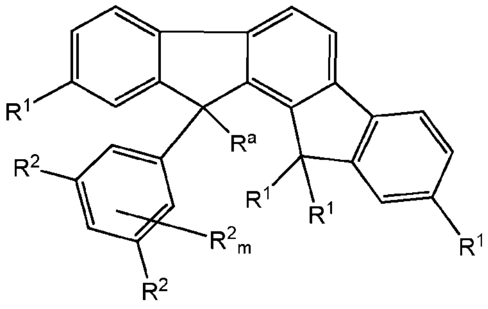

Formel (8b)

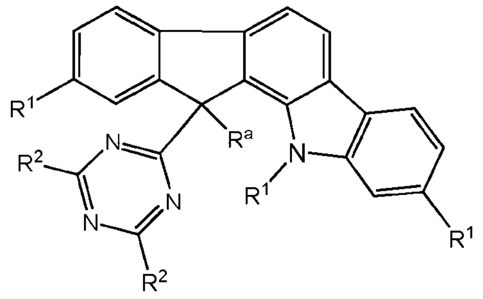

Formel (9a)

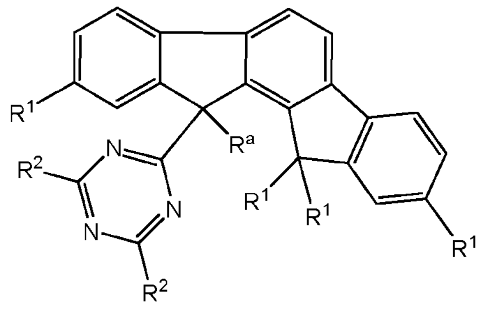

Formel (9b)

wo die verwendeten Symbole wie in Anspruch 1 definiert sind und m 0 oder 1 ist.

6. Elektronische Vorrichtung gemäß einem oder mehreren der Ansprüche 1 bis 5, **dadurch gekennzeichnet, dass** die zumindest eine Verbindung dargestellt ist durch die Formel (10), (11) oder (12)

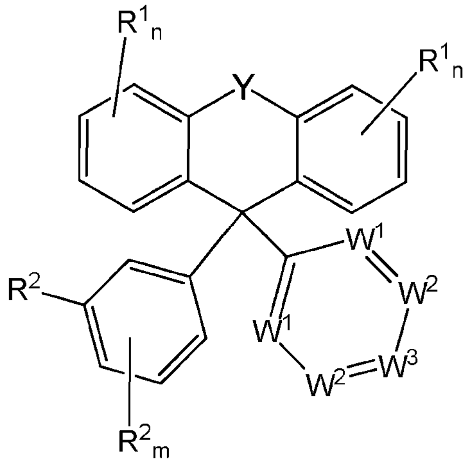

Formel (10)

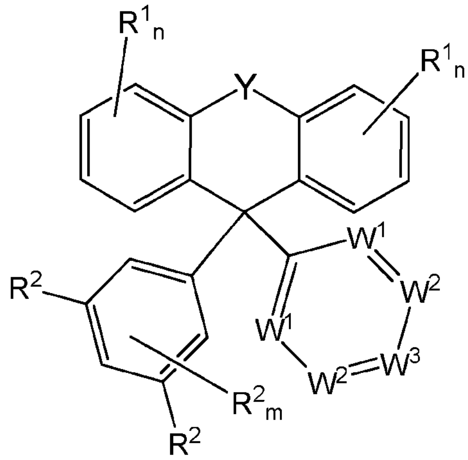

Formel (11)

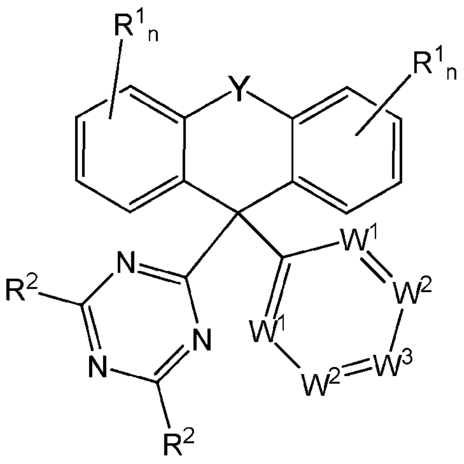

Formel (12)

wo $W^1$, $W^2$, $W^3$ bei jedem Auftreten, identisch oder unterschiedlich, N oder $CR^3$, bevorzugt $CR^3$ ist, mit der Maßgabe, dass nicht mehr als drei der Gruppen $W^1$, $W^2$, $W^3$ in einem Zyklus N sind; und wo die Symbole $R^1$, $R^2$, $R^3$ und Y wie in Anspruch 1 definiert sind, m 0 oder 1 ist und n jeweils unabhängig 0, 1, 2, 3 oder 4, bevorzugt 0, 1 oder 2 ist.

7. Elektronische Vorrichtung gemäß einem oder mehreren der Ansprüche 1 bis 6, **dadurch gekennzeichnet, dass** die zumindest eine Verbindung dargestellt ist durch die Formel (13), (14), (15), (16), (17), (18), (19), (20), (21), (22), (23) oder (24)

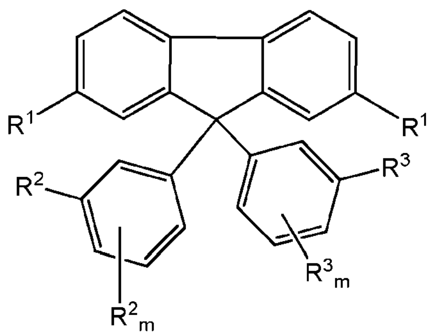

Formel (13)

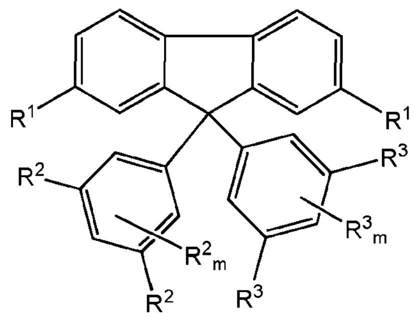

Formel (14)

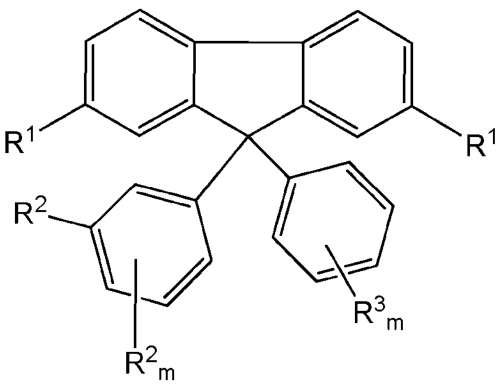

Formel (15)

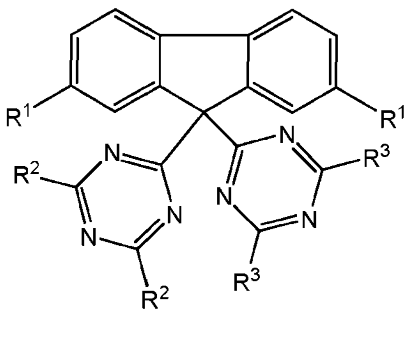

Formel (16)

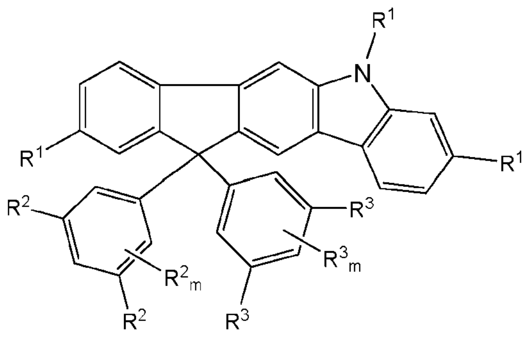

Formel (17)

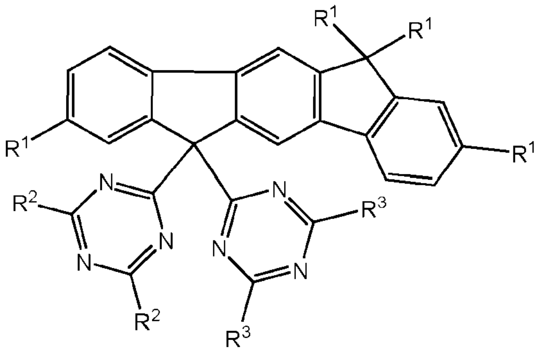

Formel (18)

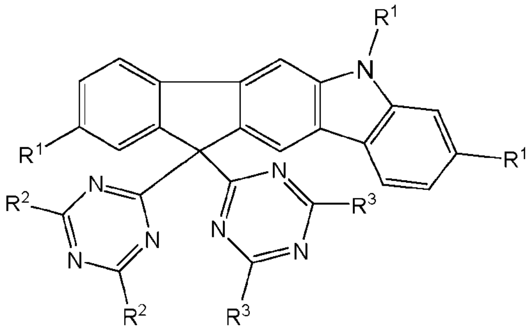

Formel (19)

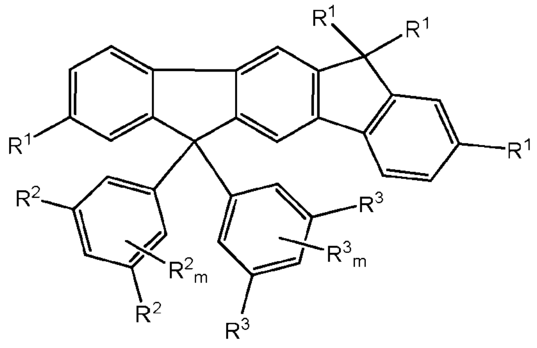

Formel (20)

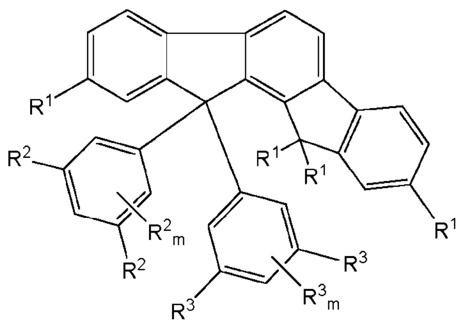

Formel (21)

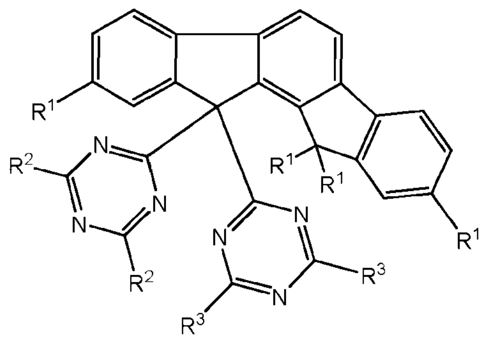

Formel (22)

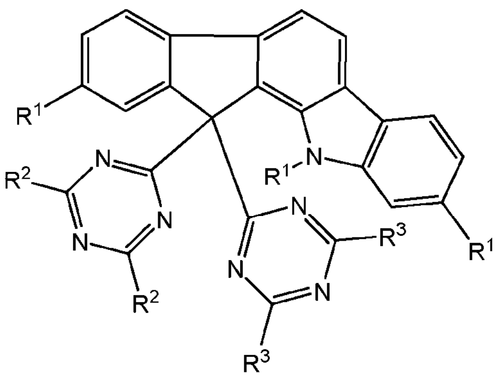

Formel (23)

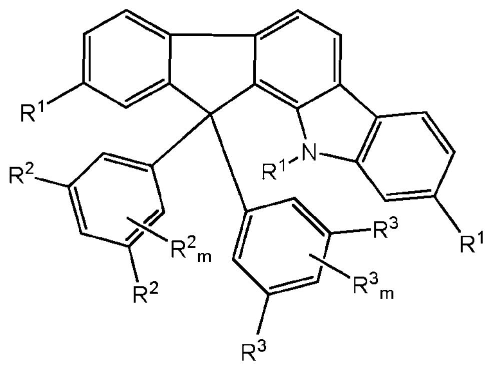

Formel (24)

wo die Symbole $R^1$, $R^2$ und $R^3$ wie in Anspruch 1 definiert sind und jedes m unabhängig 0 oder 1 ist, wo die Gesamtsumme der Indizes m nicht mehr als 1 beträgt.

**8.** Elektronische Vorrichtung gemäß einem oder mehreren der Ansprüche 1 bis 7, **dadurch gekennzeichnet, dass** die Radikale $R^2$, $R^3$, identisch oder unterschiedlich, bei jedem Auftreten $N(Ar)_2$, C(=O)Ar, $P(=O)Ar_2$ oder ein aromatisches oder heteroaromatisches Ringsystem mit 5 bis 30 aromatischen Ringatomen sind, welche substituiert sein können durch ein oder mehrere nicht-aromatische Radikale $R^4$.

**9.** Elektronische Vorrichtung gemäß einem oder mehreren der Ansprüche 1 bis 8, **dadurch gekennzeichnet, dass** die zumindest eine Verbindung dargestellt ist durch die Formel (27), (28), (29), (30) oder (31)

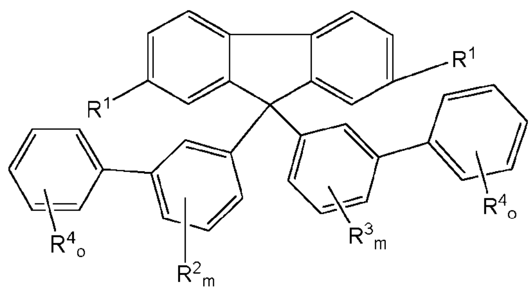

Formel (27)

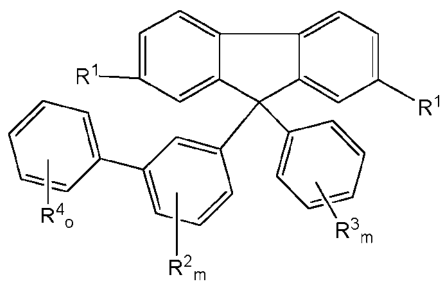

Formel (28)

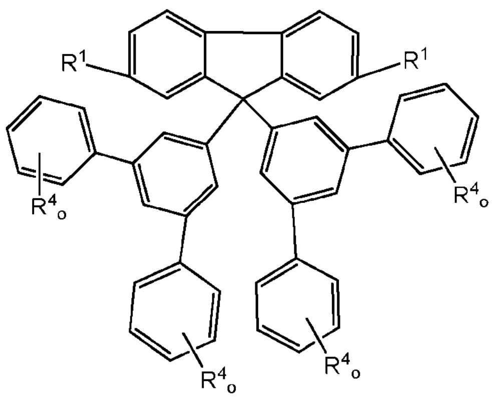

Formel (29)

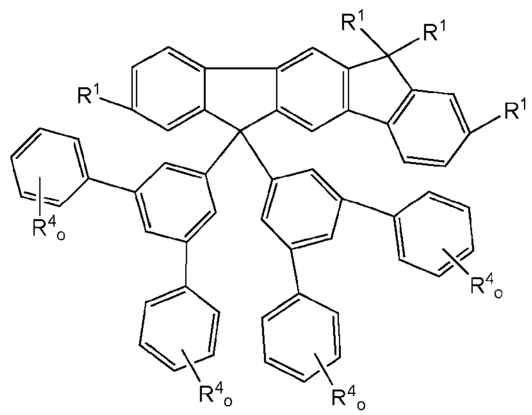

Formel (30)

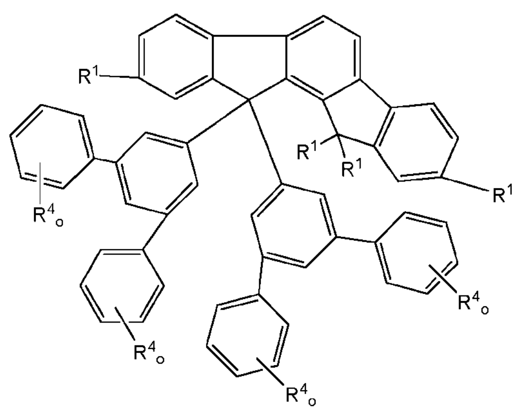

Formel (31)

wo die Symbole $R^1$, $R^2$, $R^3$ und $R^4$ wie in Anspruch 1 definiert sind und jedes m unabhängig 0 oder 1 ist, wo die

Gesamtsumme der Indizes m nicht mehr als 1 beträgt und jedes o unabhängig 0, 1, 2, 3, 4 oder 5, bevorzugt 1, 2 oder 3 ist.

**10.** Elektronische Vorrichtung gemäß einem oder mehreren der Ansprüche 1 bis 9, **dadurch gekennzeichnet, dass** die zumindest eine Verbindung insgesamt höchstens 5 Stickstoffatome, bevorzugt insgesamt höchstens 3 Stickstoffatome, bevorzugter insgesamt höchstens 5 Heteroatome, bevorzugt insgesamt höchstens 3 Heteroatome, abgesehen von Fluor, aufweist.

**11.** Elektronische Vorrichtung gemäß einem oder mehreren der Ansprüche 1 bis 10, **dadurch gekennzeichnet, dass** das zumindest eine halbleitende lichtemittierende Nanopartikel ausgewählt ist aus lichtemittierenden Materialien in Quantengröße, insbesondere aus Quantenpunkten und Quantenstäben.

**12.** Elektronische Vorrichtung gemäß einem oder mehreren der Ansprüche 1 bis 11, **dadurch gekennzeichnet, dass** das zumindest eine halbleitende lichtemittierende Nanopartikel Cd-frei ist.

**13.** Elektronische Vorrichtung gemäß einem oder mehreren der Ansprüche 1 bis 12, wobei die elektronische Vorrichtung eine organische lichtemittierende Diode (OLED) ist.

**14.** Elektronische Vorrichtung gemäß einem oder mehreren der Ansprüche 1 bis 13, **dadurch gekennzeichnet, dass** die zumindest eine Schicht eine emittierende Schicht ist.

**15.** Verfahren zum Herstellen einer elektronischen Vorrichtung gemäß einem oder mehreren der Ansprüche 1 bis 14, **dadurch gekennzeichnet, dass** zumindest eine Schicht, bevorzugt die zumindest eine Schicht, welche das zumindest eine halbleitende lichtemittierende Nanopartikel und die zumindest eine Verbindung mit einer Bandlücke von 2,5 eV oder mehr umfasst, die durch die Formel (1) dargestellt ist, durch ein Sublimationsverfahren beschichtet wird und/oder durch ein OVPD-Verfahren oder mittels einer Trägergassublimation beschichtet wird und/oder aus Lösung durch Schleuderbeschichten oder durch ein Druckverfahren aufgebracht wird.

## Revendications

**1.** Dispositif électronique comprenant une anode, une cathode et au moins une couche qui comprend les composés suivants :

a) au moins une nanoparticule électroluminescente semi-conductrice présentant une structure noyau-enveloppe où, dans la structure noyau-enveloppe, un noyau inorganique est entouré d'une ou de plusieurs couches d'enveloppe inorganiques, où éventuellement les couches d'enveloppe sont recouvertes d'un ou de plusieurs ligands modificateurs de surface ; et
b) au moins un composé présentant une bande interdite, telle que mesurée par le procédé décrit dans la description, de 2,5 eV ou plus, de préférence de 3,0 eV ou plus, idéalement de 3,5 eV ou plus, et très préférablement de 4,0 eV ou plus,

dans lequel le noyau de la nanoparticule électroluminescente semi-conductrice est un matériau choisi parmi CdS, CdSe, CdTe, ZnS, ZnSe, ZnSeS, ZnTe, ZnO, GaAs, GaP, GaSb, HgS, HgSe, HgSe, HgTe, InAs, InP, InPS, InPZnS, InPZn, InPGa, InSb, AlAs, AlP, AlSb, $Cu_2S$, $Cu_2Se$, CuInS2, $CuInSe_2$, $Cu_2(ZnSn)S_4$, $Cu_2(InGa)S_4$, $TiO_2$, et une combinaison de n'importe lesquels de ceux-ci ;
dans lequel le dispositif électronique est choisi parmi des transistors organiques électroluminescents (OLET), des dispositifs organiques à extinction de champ (OFQD), des diodes laser organiques (O-lasers) et des diodes électroluminescentes organiques (OLED) ; et dans lequel
l'au moins un composé présentant une bande interdite de 2,5 eV ou plus est représenté par la formule (1) :

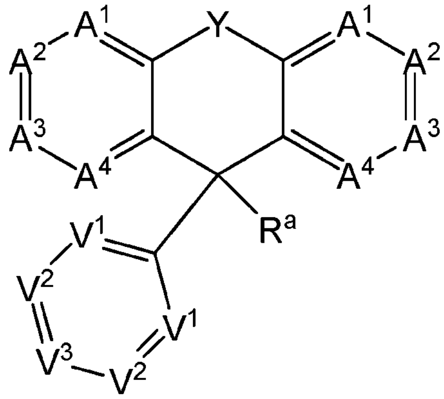

formule (1)

où les symboles utilisés sont comme suit :

$A^1$, $A^2$, $A^3$, $A^4$ sont, de manière identique ou différente à chaque occurrence, N ou $CR^1$, de préférence $CR^1$, à condition que pas plus de deux des groupes $A^1$, $A^2$, $A^3$, $A^4$ dans un cycle soient N ; ou deux groupes directement adjacents $A^1$, $A^2$, $A^3$, $A^4$ représentent une unité de la formule (7) suivante

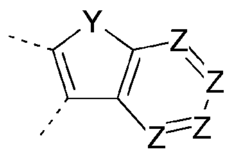

formule (7)

où les liaisons en pointillé indiquent la liaison de l'unité aux atomes C ou N adjacents ;

Y est, à chaque occurrence, de manière identique ou différente, une liaison simple ou un groupe choisi parmi $BR^1$, $C(R^1)_2$, C(=O), $C(=NR^1)$, $C(=C(R^1)_2)$, $Si(R^1)_2$, $NR^1$, $PR^1$, $P(=O)R^1$, O, S, S(=O), $S(=O)_2$, $C(R^1)_2$-$C(R^1)_2$, $C(R^1)_2$-$NR^1$ ou $CR^1$=$CR^1$ ;

Z est, à chaque occurrence, de manière identique ou différente, $CR^1$ ou N, où un maximum de deux groupes Z dans chaque cycle représentent N ;

$V^1$, $V^2$, $V^3$ sont, de manière identique ou différente à chaque occurrence, N ou $CR^2$, de préférence $CR^2$, à condition que pas plus de trois des groupes $V^1$, $V^2$, $V^3$ dans un cycle soient N ;

$R^a$ est, à chaque occurrence, de manière identique ou différente, H, D, F, Cl, Br, I, CHO, $N(R^3)_2$, $N(Ar)_2$, C(=O)Ar, $P(=O)(Ar)_2$, S(=O)Ar, $S(=O)_2Ar$, $CR^3$=$CR^3Ar$, CN, $NO_2$, $Si(R^3)_3$, $B(OR^3)_2$, $B(R^3)_2$, $B(N(R^3)_2)_2$, $OSO_2R^3$, un groupe alkyle, alcényle, alcynyle, alcoxy ou thioalcoxy à chaîne linéaire comportant 1 à 40 atomes C ou un groupe alkyle, alcényle, alcynyle, alcoxy ou thioalcoxy ramifié ou cyclique comportant 3 à 40 atomes C, chacun pouvant être substitué par un ou plusieurs radicaux $R^3$, où un ou plusieurs groupes $CH_2$ non adjacents peuvent être remplacés par $R^3C$=$CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S ou $CONR^3$ et où un ou plusieurs atomes H peuvent être remplacés par F, Cl, Br, I, CN ou $NO_2$, ou un système de cycle aromatique ou hétéroaromatique comportant 5 à 60 atomes de cycle aromatique, qui peut, dans chaque cas, être substitué par un ou plusieurs radicaux $R^3$, ou un groupe aryloxy ou hétéroaryloxy comportant 5 à 60 atomes de cycle aromatique, qui peut être substitué par un ou plusieurs radicaux $R^3$, ou une combinaison de ces systèmes ; simultanément, un substituant $R^a$ et un groupe adjacent $V^1$, $V^2$ ou $V^3$, de préférence $V^1$ peuvent ici également être liés les uns aux autres par une liaison simple ou un pont choisi parmi $B(R^3)$, $C(R^3)_2$, $Si(R^3)_2$, C=O, $C=NR^3$, $C=C(R^3)_2$, O, S, S=O, $SO_2$, $N(R^3)$, $P(R^3)$ et $P(=O)R^3$, de préférence une liaison simple ;

Ar est, à chaque occurrence, de manière identique ou différente, un système de cycle aromatique ou hétéroaromatique comportant 5 à 30 atomes de cycle aromatique, qui peut être substitué par un ou plusieurs radicaux non aromatiques $R^5$ ; deux radicaux Ar ici qui sont liés au même atome d'azote ou de phosphore peuvent également être liés l'un à l'autre par une liaison simple ou un pont choisi parmi $B(R^6)$, $C(R^6)_2$, $Si(R^6)_2$, C=O, $C=NR^6$, $C=C(R^6)_2$, O, S, S=O, $SO_2$, $N(R^6)$, $P(R^6)$ et $P(=O)R^6$ ;

$R^1$ est, de manière identique ou différente à chaque occurrence, H, D, F, Cl, Br, I, $B(OR^5)_2$, CHO, $C(=O)R^5$, $CR^5$=$C(R^5)_2$, CN, $C(=O)OR^5$, $C(=O)N(R^5)_2$, $Si(R^5)_3$, $N(R^5)_2$, $NO_2$, $P(=O)(R^5)_2$, $OSO_2R^5$, $OR^5$, $S(=O)R^5$,

$S(=O)_2R^5$, un groupe alkyle, alcoxy ou thioalcoxy à chaîne linéaire comportant 1 à 40 atomes de carbone ou un groupe alkyle, alcoxy ou thioalcoxy ramifié ou cyclique comportant 3 à 40 atomes de carbone, chacun pouvant être substitué par un ou plusieurs radicaux $R^5$, où un ou plusieurs groupes $CH_2$ non adjacents peuvent être remplacés par $-R^5C=CR^5-$, -C=C-, $Si(R^5)_2$, $Ge(R^5)_2$, $Sn(R^5)_2$, C=O, C=S, C=Se, $C=NR^5$, -C(=O)O-, $-C(=O)NR^5-$, $NR^5$, $P(=O)(R^5)$, -O-, -S-, SO ou $SO_2$ et où un ou plusieurs atomes d'hydrogène peuvent être remplacés par D, F, Cl, Br, I, CN ou $NO_2$, ou un système de cycle aromatique ou hétéroaromatique qui comporte 5 à 40 atomes de cycle aromatique et peut être substitué, dans chaque cas, par un ou plusieurs radicaux $R^5$, ou un groupe aryloxy ou hétéroaryloxy comportant 5 à 40 atomes de cycle aromatique et peut être substitué par un ou plusieurs radicaux $R^5$, ou une combinaison de ces systèmes ; simultanément, il est également possible que deux substituants $R^1$ adjacents ou plus forment ensemble un système de cycle aliphatique ou aromatique mono- ou polycyclique ;

$R^2$, $R^3$ sont, de manière identique ou différente à chaque occurrence, H, D, F, Cl, Br, I, $B(OR^4)_2$, CHO, $C(=O)R^4$, $CR^4=C(R^4)_2$, CN, $C(=O)OR^4$, $C(=O)N(R^4)_2$, $Si(R^4)_3$, $N(R^4)_2$, $NO_2$, $P(=O)(R^4)_2$, $OSO_2R^4$, $OR^4$, $S(=O)R^4$, $S(=O)_2R^4$, un groupe alkyle, alcoxy ou thioalcoxy à chaîne linéaire comportant 1 à 40 atomes de carbone ou un groupe alkyle, alcoxy ou thioalcoxy ramifié ou cyclique comportant 3 à 40 atomes de carbone, chacun pouvant être substitué par un ou plusieurs radicaux $R^4$, où un ou plusieurs groupes $CH_2$ non adjacents peuvent être remplacés par - $R^4C=CR^4-$, -C≡C-, $Si(R^4)_2$, $Ge(R^4)_2$, $Sn(R^4)_2$, C=O, C=S, C=Se, $C=NR^4$, -C(=O)O-, $-C(=O)NR^4-$, $NR^4$, $P(=O)(R^4)$, -O-, -S-, SO ou $SO_2$ et où un ou plusieurs atomes d'hydrogène peuvent être remplacés par D, F, Cl, Br, I, CN ou $NO_2$, ou un système de cycle aromatique ou hétéroaromatique comportant 5 à 40 atomes de cycle aromatique et peut être substitué dans chaque cas par un ou plusieurs radicaux $R^4$, ou un groupe aryloxy ou hétéroaryloxy comportant 5 à 40 atomes de cycle aromatique et peut être substitué par un ou plusieurs radicaux $R^4$, ou une combinaison de ces systèmes ; simultanément, il est également possible que deux substituants $R^2$ adjacents ou plus forment ensemble un système de cycle aliphatique ou aromatique mono- ou polycyclique ; simultanément, il est également possible que deux substituants $R^3$ adjacents ou plus forment ensemble un système de cycle aliphatique ou aromatique mono- ou polycyclique ;

$R^4$, $R^5$ sont, de manière identique ou différente à chaque occurrence, H, D, F, Cl, Br, I, $B(OR^6)_2$, CHO, $C(=O)R^6$, $CR^6=C(R^6)_2$, CN, $C(=O)OR^6$, $C(=O)N(R^6)_2$, $Si(R^6)_3$, $N(R^6)_2$, $NO_2$, $P(=O)(R^6)_2$, $OSO_2R^6$, $OR^6$, $S(=O)R^6$, $S(=O)_2R^6$, un groupe alkyle, alcoxy ou thioalcoxy à chaîne linéaire comportant 1 à 40 atomes de carbone ou un groupe alkyle, alcoxy ou thioalcoxy ramifié ou cyclique comportant 3 à 40 atomes de carbone, chacun pouvant être substitué par un ou plusieurs radicaux $R^6$, où un ou plusieurs groupes $CH_2$ non adjacents peuvent être remplacés par - $R^6C=CR^6-$, -C≡C-, $Si(R^6)_2$, $Ge(R^6)_2$, $Sn(R^6)_2$, C=O, C=S, C=Se, $C=NR^6$, -C(=O)O-, $-C(=O)NR^6-$, $NR^6$, $P(=O)(R^6)$, -O-, -S-, SO ou $SO_2$ et où un ou plusieurs atomes d'hydrogène peuvent être remplacés par D, F, Cl, Br, I, CN ou $NO_2$, ou un système de cycle aromatique ou hétéroaromatique comportant 5 à 40 atomes de cycle aromatique et peut être substitué dans chaque cas par un ou plusieurs radicaux $R^6$, ou un groupe aryloxy ou hétéroaryloxy comportant 5 à 40 atomes de cycle aromatique et peut être substitué par un ou plusieurs radicaux $R^6$, ou une combinaison de ces systèmes ; simultanément, il est également possible que deux substituants $R^4$ adjacents ou plus forment ensemble un système de cycle aliphatique ou aromatique mono- ou polycyclique ; simultanément, il est également possible que deux substituants $R^5$ adjacents ou plus forment ensemble un système de cycle aliphatique ou aromatique mono- ou polycyclique, et

$R^6$ est, de manière identique ou différente à chaque occurrence, H, D, F ou un radical hydrocarbyle aliphatique, aromatique et/ou hétéroaromatique comportant 1 à 20 atomes de carbone, dans lequel les atomes d'hydrogène peuvent également être remplacés par F ; simultanément, il est également possible que deux substituants $R^6$ adjacents ou plus forment ensemble un système de cycle aliphatique ou aromatique mono- ou polycyclique.

**2.** Dispositif électronique selon la revendication 1, **caractérisé en ce que** l'au moins un composé présente un poids moléculaire ne dépassant pas 5000 g/mol, de préférence ne dépassant pas 4000 g/mol, de manière particulièrement préférée ne dépassant pas 3000 g/mol, de manière tout particulièrement préférée ne dépassant pas 2000 g/mol et très préférablement ne dépassant pas 1000 g/mol.

**3.** Dispositif électronique selon la revendication 1 ou 2, **caractérisé en ce que** l'au moins un composé est représenté par la formule (2), (3), (4), (5), (6), (8) ou (9)

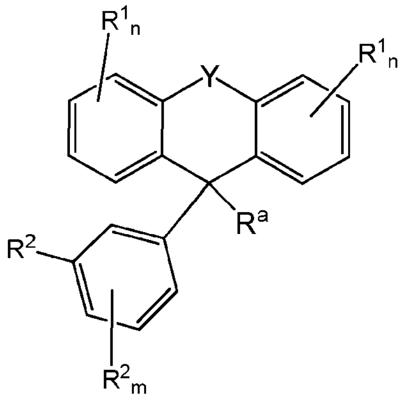

formule (2)

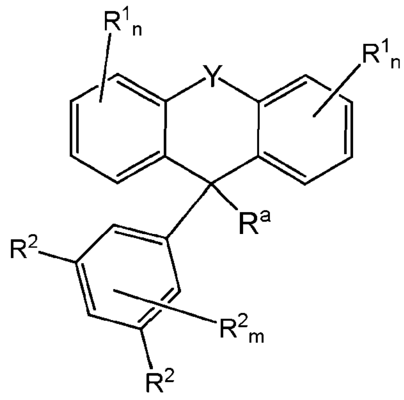

formule (3)

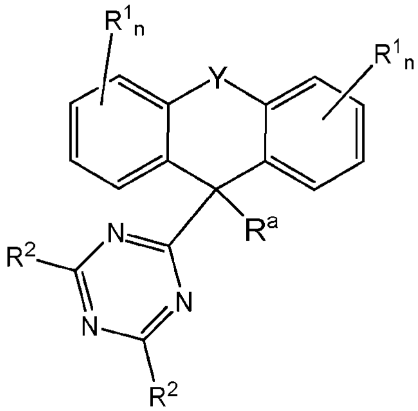

formule (4)

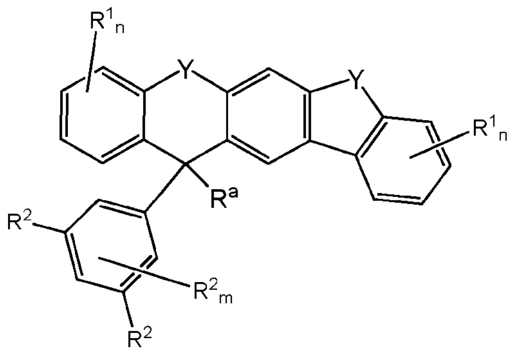

formule (5)

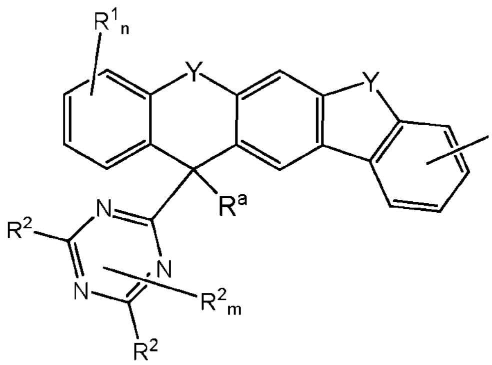

formule (6)

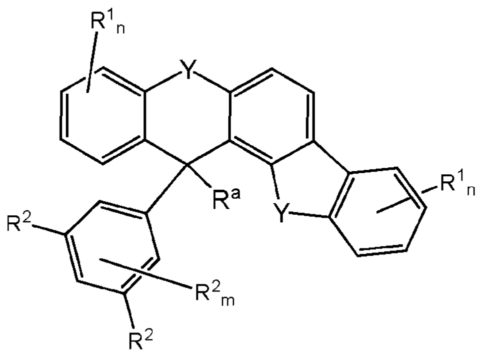

formule (8)

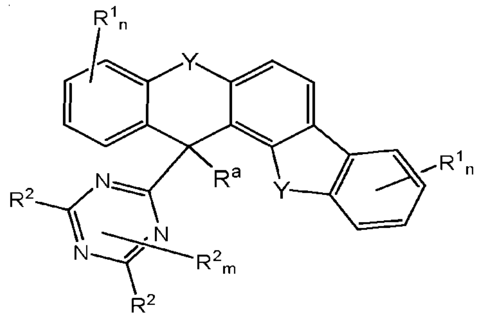

formule (9)

où les symboles utilisés sont tels que définis dans la revendication 1, m vaut 0 ou 1, et chaque n vaut indépendamment 0, 1, 2, 3 ou 4, de préférence 0, 1 ou 2.

**4.** Dispositif électronique selon une ou plusieurs des revendications 1 à 3, **caractérisé en ce que** le symbole Y est, de manière identique ou différente à chaque occurrence, une liaison simple ou un groupe choisi parmi $C(R^1)_2$, O ou $NR^1$.

**5.** Dispositif électronique selon une ou plusieurs des revendications 1 à 4, **caractérisé en ce que** l'au moins un composé est représenté par la formule (2a), (3a), (4a), (5a), (5b), (6a), (6b), (8a), (8b), (9a) ou (9b)

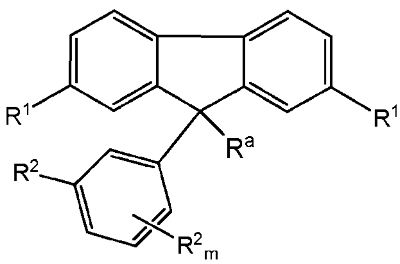

formule (2a)

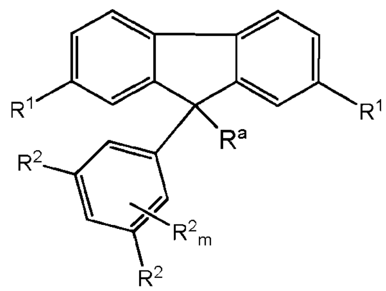

formule (3a)

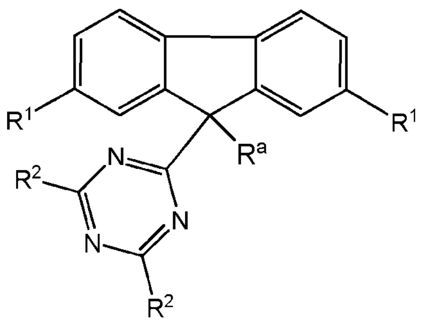

formule (4a)

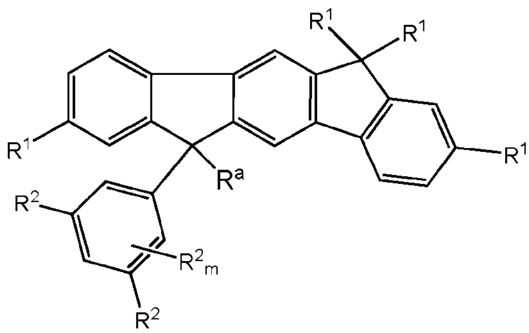

formule (5a)

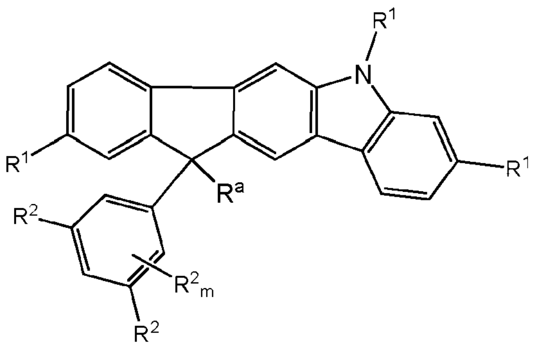

formule (5b)

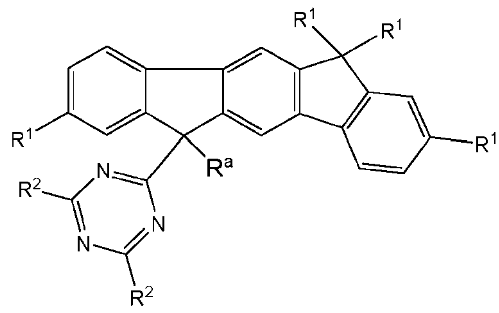

formule (6a)

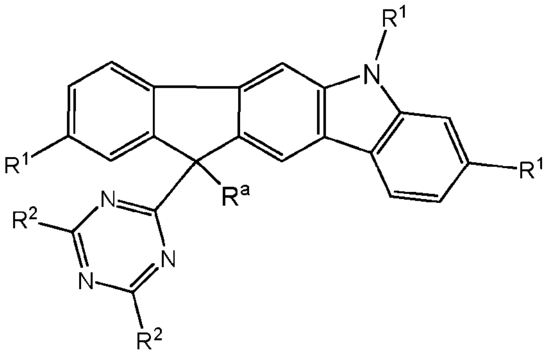

Formule (6b)

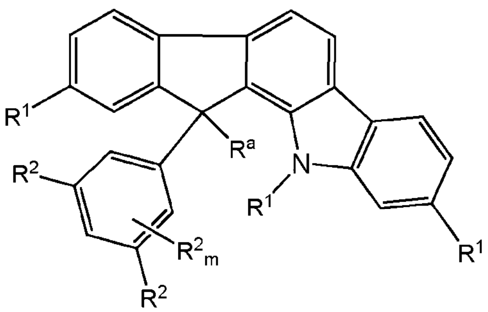

formule (8a)

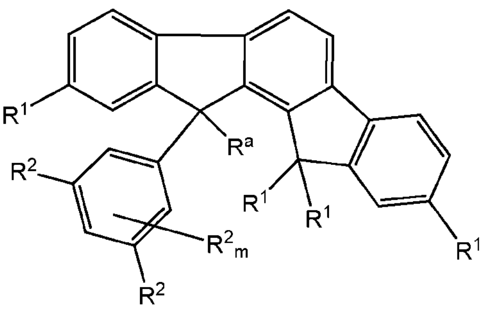

formule (8b)

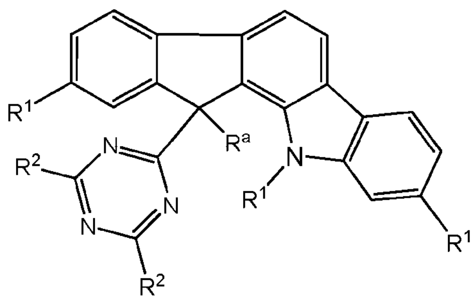

formule (9a)

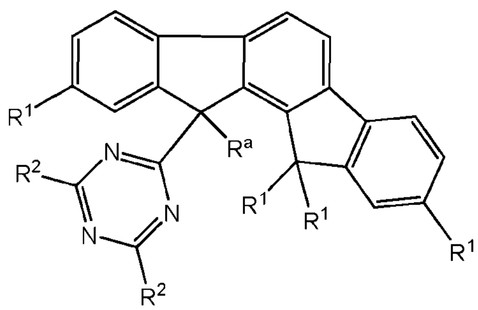

formule (9b)

où les symboles utilisés sont tels que définis dans la revendication 1 et m vaut 0 ou 1.

6. Dispositif électronique selon une ou plusieurs des revendications 1 à 5, **caractérisé en ce que** l'au moins un composé est représenté par la formule (10), (11) ou (12)

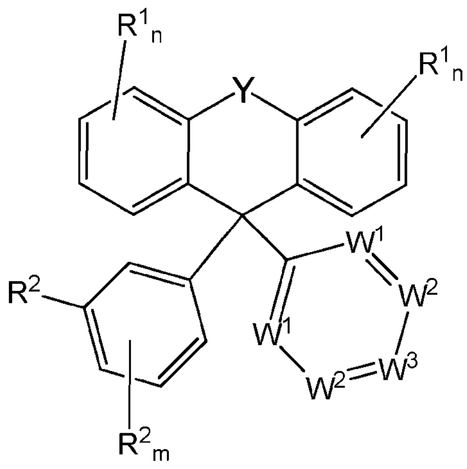

formule (10)

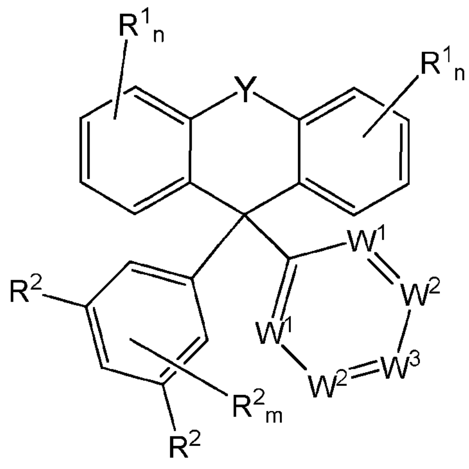

formule (11)

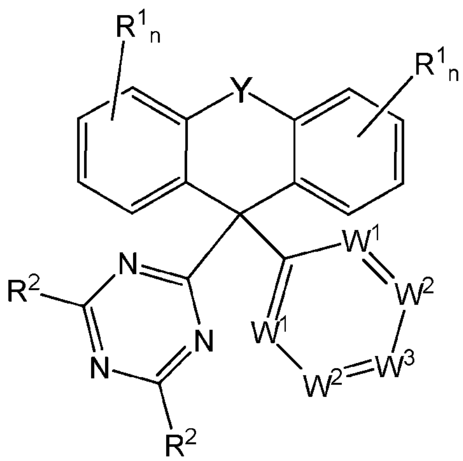

formule (12)

où $W^1$, $W^2$, $W^3$ sont, de manière identique ou différente à chaque occurrence, N ou $CR^3$, de préférence $CR^3$, à condition que pas plus de trois des groupes $W^1$, $W^2$, $W^3$ dans un cycle soient N ; et
où les symboles $R^1$, $R^2$, $R^3$ et Y sont tels que définis dans la revendication 1, m vaut 0 ou 1, et chaque n vaut indépendamment 0, 1, 2, 3 ou 4, de préférence 0, 1 ou 2.

7. Dispositif électronique selon une ou plusieurs des revendications 1 à 6, **caractérisé en ce que** l'au moins un composé est représenté par la formule (13), (14), (15), (16), (17), (18), (19), (20), (21), (22), (23) ou (24)

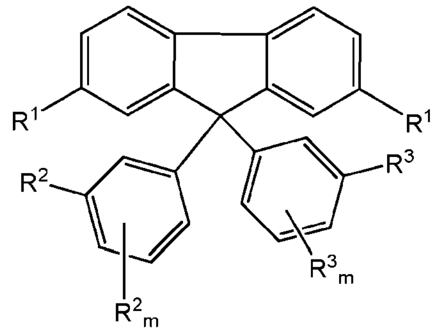

formule (13)

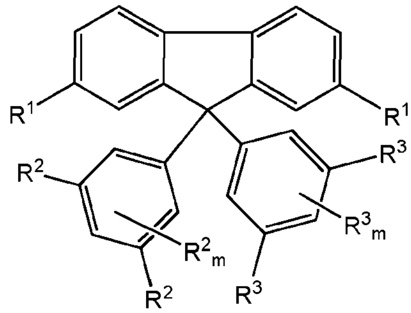

formule (14)

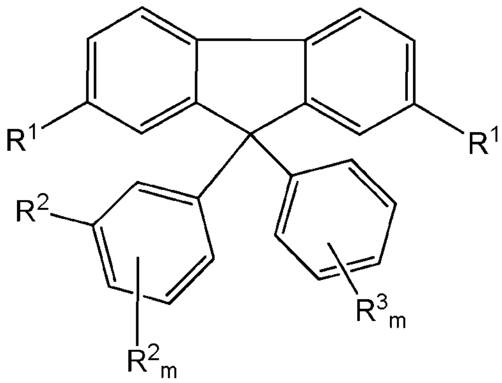

formule (15)

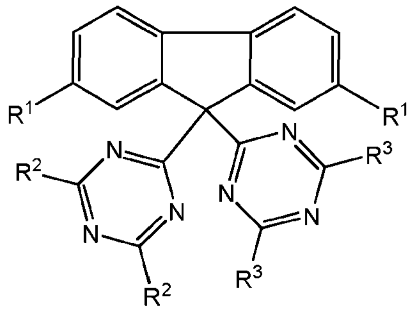

formule (16)

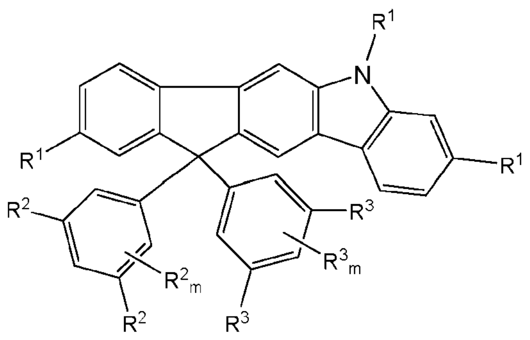

formule (17)

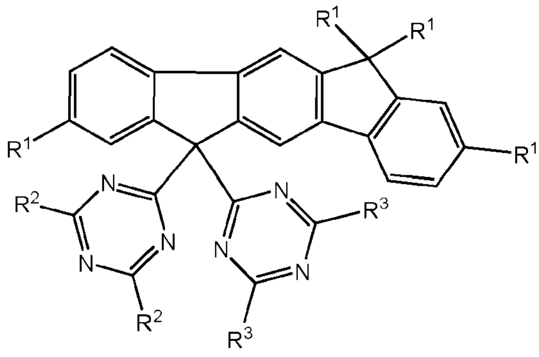

formule (18)

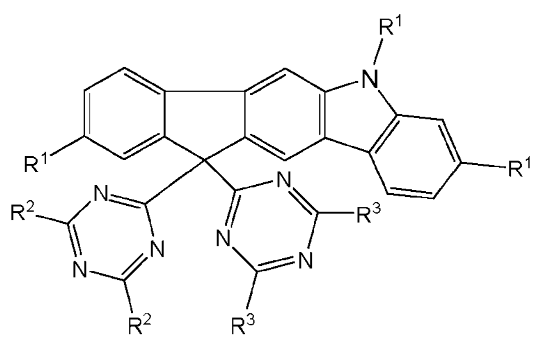

formule (19)

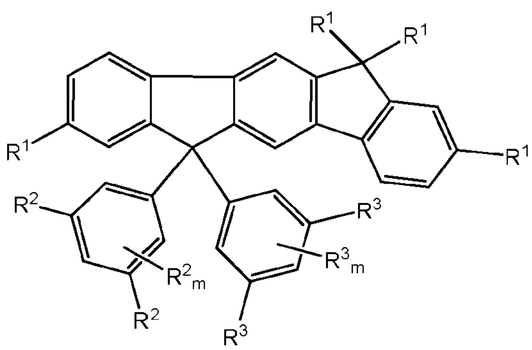

formule (20)

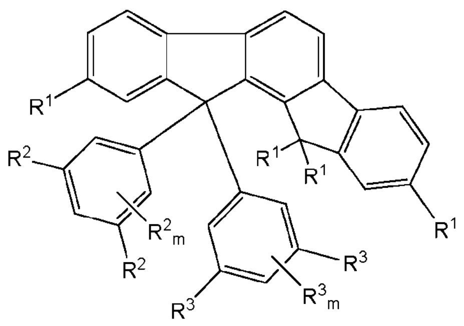

formule (21)

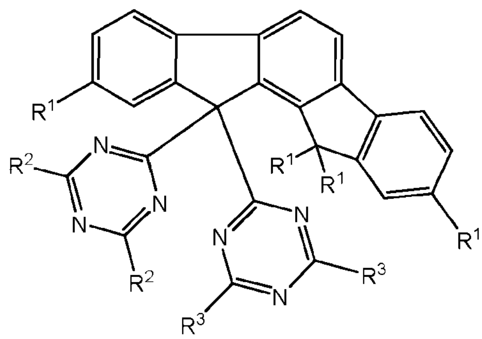

formule (22)

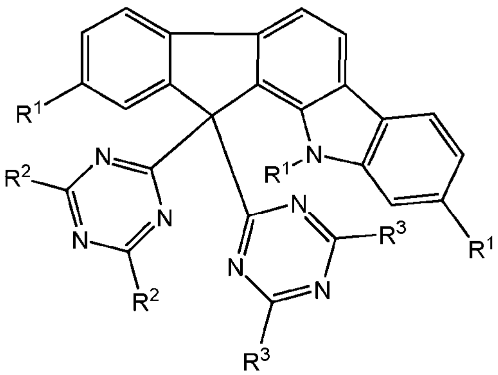

formule (23)

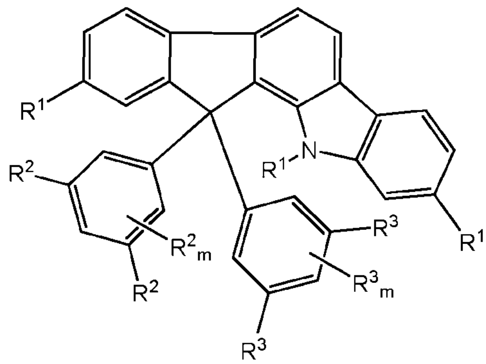

formule (24)

où les symboles $R^1$, $R^2$ et $R^3$ sont tels que définis dans la revendication 1 et chaque m vaut indépendamment 0 ou 1, où la somme totale des indices m n'est pas supérieure à 1.

**8.** Dispositif électronique selon une ou plusieurs des revendications 1 à 7, **caractérisé en ce que** les radicaux $R^2$, $R^3$ sont, de manière identique ou différente à chaque occurrence, $N(Ar)_2$, $C(=O)Ar$, $P(=O)Ar_2$ ou un système de cycle aromatique ou hétéroaromatique comportant 5 à 30 atomes de cycle aromatique, qui peut être substitué par un ou plusieurs radicaux non aromatiques $R^4$.

**9.** Dispositif électronique selon une ou plusieurs des revendications 1 à 8, **caractérisé en ce que** l'au moins un composé est représenté par la formule (27), (28), (29), (30) ou (31)

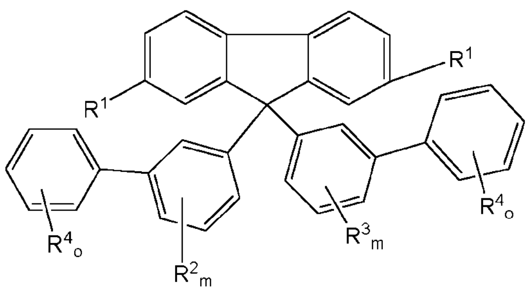

formule (27)

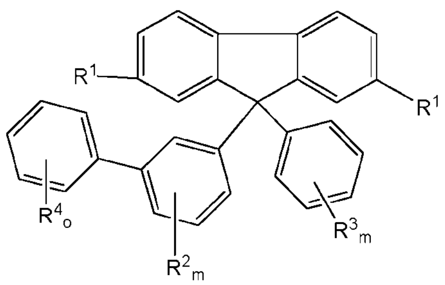

formule (28)

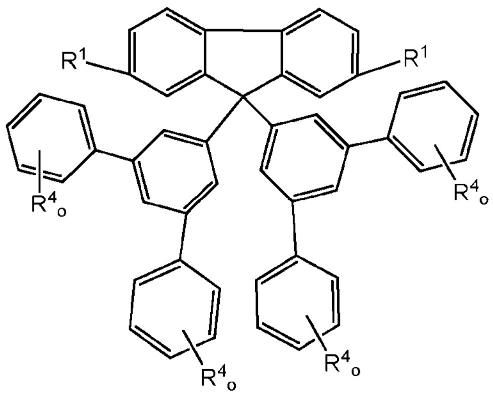

formule (29)

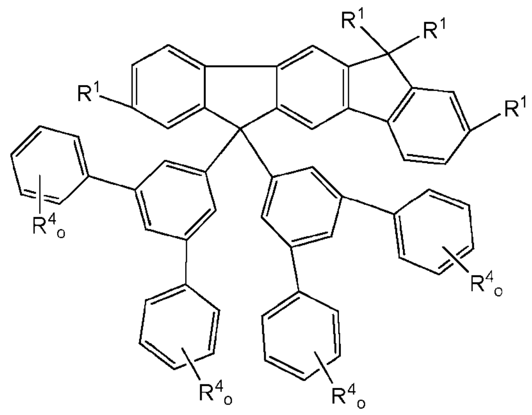

formule (30)

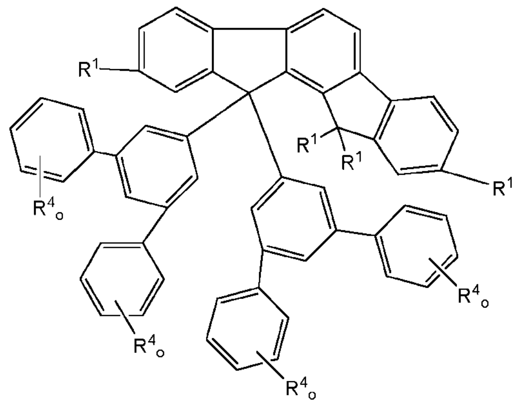

formule (31)

où les symboles $R^1$, $R^2$, $R^3$ et $R^4$ sont tels que définis dans la revendication 1, et chaque m vaut indépendamment 0 ou 1, où la somme totale des indices m n'est pas supérieure à 1, et chaque o vaut indépendamment 0, 1, 2, 3, 4 ou 5, de préférence 1, 2 ou 3.

**10.** Dispositif électronique selon une ou plusieurs des revendications 1 à 9, **caractérisé en ce que** l'au moins un composé comporte un total de pas plus de 5 atomes d'azote, de préférence un total de pas plus de 3 atomes d'azote, idéalement un total de pas plus de 5 hétéroatomes, de préférence un total de pas plus de 3 hétéroatomes, à l'exception du fluor.

**11.** Dispositif électronique selon une ou plusieurs des revendications 1 à 10, **caractérisé en ce que** l'au moins une nanoparticule électroluminescente semi-conductrice est choisie parmi des matériaux électroluminescents de taille quantique, en particulier parmi des points quantiques et des bâtonnets quantiques.

**12.** Dispositif électronique selon une ou plusieurs des revendications 1 à **11, caractérisé en ce que** l'au moins une nanoparticule électroluminescente semi-conductrice est exempte de Cd.

**13.** Dispositif électronique selon une ou plusieurs des revendications 1 à 12, dans lequel le dispositif électronique est une diode électroluminescente organique (OLED).

**14.** Dispositif électronique selon une ou plusieurs des revendications 1 à 13, **caractérisé en ce que** l'au moins une couche est une couche émettrice.

**15.** Procédé permettant la préparation d'un dispositif électronique selon une ou plusieurs des revendications 1 à **14, caractérisé en ce qu'**au moins une couche, de préférence l'au moins une couche qui comprend l'au moins une nanoparticule électroluminescente semi-conductrice et l'au moins un composé présentant une bande interdite de 2,5 eV ou plus représentée par la formule (1), est déposée par un procédé de sublimation et/ou est déposée par un

procédé OVPD ou au moyen d'une sublimation par gaz vecteur et/ou est appliquée à partir d'une solution par dépôt par centrifugation ou par un procédé d'impression.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2015022885 A1
- CN 105900529 B
- JP 2019033005 A
- US 2013226268 A
- US 2017324057 A
- US 7294849 B
- WO 2016184540 A1
- WO 2009124627 A1
- US 8221651 B2
- WO 2010095140 A2
- WO 2012059931 A
- WO 2004013080 A
- WO 2004093207 A
- WO 2006005627 A
- WO 2010006680 A
- WO 2005039246 A
- US 20050069729 A
- JP 2004288381 A
- EP 1205527 A
- WO 2008086851 A
- WO 2007063754 A
- WO 2008056746 A
- WO 2010136109 A
- WO 2011000455 A
- EP 1617710 A
- EP 1617711 A
- EP 1731584 A
- JP 2005347160 A
- WO 2007137725 A
- WO 2005111172 A
- WO 2006117052 A
- WO 2010015306 A
- WO 08056746 A
- EP 652273 A
- WO 2009062578 A
- WO 2009124627 A
- WO 2010054729 A
- WO 2010054730 A
- US 20090136779 A
- WO 2010050778 A
- WO 2011042107 A
- WO 2011088877 A
- WO 2014094964 A
- WO 200070655 A
- WO 200141512 A
- WO 200202714 A
- WO 200215645 A
- EP 1191613 A
- EP 1191612 A
- EP 1191614 A
- WO 2005033244 A
- WO 2005019373 A
- US 20050258742 A
- WO 2009146770 A
- WO 2010015307 A
- WO 2010031485 A
- WO 2010054731 A
- WO 2010054728 A
- WO 2010086089 A
- WO 2010099852 A
- WO 2010102709 A
- WO 2011157339 A
- WO 2012007086 A
- WO 2005053051 A
- WO 2011073149 A
- EP 1968131 A
- EP 2276085 A
- EP 2213662 A
- EP 1722602 A
- EP 2045848 A
- DE 102007031220
- US 8044390 B
- US 8057712 B
- WO 2009003455 A
- WO 2010094378 A
- WO 2011120709 A
- US 20100096600 A
- WO 2002072714 A
- WO 2003019694 A
- WO 2004037887 A
- WO 2010097155 A
- US 20170009134 A1
- US 170009134 A1


### Non-patent literature cited in the description


- *Adv. Mater.*, 2017, vol. 29, 1607022
- *J. Mater. Chem. C*, 2014, 2028-2036
- *ACS Nano,*, 2016, vol. 10 (6), 5769-5781
- *Chem. Mater.*, 2015, vol. 27, 4893-4898

- **T. MATSUMOTO** ; **T. NAKADA** ; **J. ENDO** ; **K. MORI** ; **N. KAWAMURA** ; **A. YOKOI** ; **J. KIDO**. *Multiphoton Organic EL Device Having Charge Generation Layer*
- *Chem. Rev.*, 2007, vol. 107, 1233
- **M. S. ARNOLD et al.** *Appl. Phys. Lett.*, 2008, vol. 92, 053301